# EUROPEAN PATENT APPLICATION

(11) **EP 4 474 911 A1**
(43) Date of publication of application: **11.12.2024**
(21) Application number: 24177474.4
(22) Date of filing: 22.05.2024
(51) Int. Cl.: G03F 7/09

(54) **COMPOSITION FOR FORMING RESIST UNDERLAYER FILM AND PATTERNING PROCESS**

(30) Priority: 05.06.2023 JP 2023092739
(71) Applicant: SHIN-ETSU CHEMICAL CO., LTD., Tokyo 1000005 (JP)
(72) Inventor: Kobayashi, Naoki, Niigata (JP); Iwamori, Shohei, Niigata (JP); Kori, Daisuke, Niigata (JP); Satoh, Hironori, Niigata (JP)
(74) Representative: Sonnenhauser, Thomas Martin

(57) **Abstract**

The present invention is a composition for forming a resist underlayer film used for a multilayer resist method contains (A) a resin, (B) a base generator, and (C) an organic solvent, wherein a weight-average molecular weight of (A) the resin is 3,000 to 10,000, (A) the resin is (A-1) a resin containing a phenolic hydroxyl group and a group obtained by modifying a phenolic hydroxyl group, or (A-2) a mixture of a resin containing a phenolic hydroxyl group and a resin containing a group obtained by modifying a phenolic hydroxyl group, and (A) the resin satisfies relations of a+b=1, 0.1≤a≤0.5, and 0.5≤b≤0.9, wherein "a" is a proportion of a phenolic hydroxyl group and "b" is a proportion of a group obtained by modifying a phenolic hydroxyl group contained in (A) the resin. This provides: a composition for forming a resist underlayer film having an excellent filling property and adhesiveness to a substrate, and a patterning process using thereof are to be provided.

## Description

### TECHNICAL FIELD

The present invention relates to a composition for forming a resist underlayer film and a patterning process.

### BACKGROUND ART

As higher integration and speed is achieved in LSI, miniaturization of pattern size progresses rapidly. Along with this miniaturization, lithography techniques have achieved formation of a fine pattern by shortening a wavelength of a light source and appropriately selecting a resist composition corresponding thereto. A positive photoresist composition used for a single layer has been the key to this achievement. This single-layer positive photoresist composition contains a resist resin, which has a skeleton having etching resistance against dry etching with chlorine-based or fluorine-based gas plasma and a switching mechanism to cause dissolution of an exposed portion such that the exposed portion is dissolved to form a pattern, and a substrate to be processed is processed by dry etching while the remained resist pattern is used as an etching mask.

However, miniaturing a pattern, that is, reducing pattern width while maintaining film thickness of a photoresist film for use has caused a problem of degraded resolution performance of the photoresist film, and pattern development of the photoresist film with a developer has caused a problem of a so-called high aspect ratio, resulting in pattern collapse. Therefore, thickness of a photoresist film has been decreased as a pattern has been miniaturized.

Meanwhile, commonly used for processing a substrate to be processed is a method of processing a substrate by dry etching while using a photoresist film having a formed pattern as an etching mask. However, in reality, there is no dry etching method capable of securing complete etch selectivity between the photoresist film and the substrate to be processed. Hence, there has been a problem that a resist film is also damaged and collapses during processing of a substrate, making it impossible to accurately transfer a resist pattern to the substrate to be processed. Accordingly, as miniaturization of a pattern has progressed, higher dry etching resistance has been required for a photoresist composition. On the other hand, a resin used for the photoresist composition has been required to absorb less light at an exposure wavelength to enhance resolution. Therefore, as exposure light has been changed to the one having a shorter wavelength, such as i-line, KrF, and ArF, the resin also has been changed to a novolac resin, polyhydroxystyrene, and a resin having an aliphatic polycyclic skeleton. However, in reality, an etch rate has been increased under dry etching conditions during processing of a substrate, and recent photoresist compositions having high resolution tend to have rather weak etching resistance.

Accordingly, a substrate to be processed should be processed by dry etching with a thinner photoresist film having weaker etching resistance, and it has become an urgent matter to secure a material and a process for this processing steps.

One of methods to solve such problems is a multilayer resist method. This method includes: interposing a resist underlayer film having different etch selectivity from that of a photoresist film (i.e. a resist upper layer film) between the resist upper layer film and a substrate to be processed; giving a pattern in the resist upper layer film, followed by transferring the pattern to the resist underlayer film by dry etching while using the resist upper layer film pattern as a dry etching mask; and further transferring the pattern to the substrate to be processed by dry etching while using the resist underlayer film as a dry etching mask.

One of the multilayer resist methods is a three-layer resist method that can be performed by using a common resist composition used in a single-layer resist method. In this three-layer resist method, for example, an organic film of a novolac resin or the like is deposited on a substrate to be processed as a resist underlayer film; a silicon-containing film is deposited thereon as a silicon-containing resist middle layer film; and a common organic photoresist film is formed thereon as a resist upper layer film. When the dry etching is performed with fluorine-based gas plasma, the organic resist upper layer film can have good etch selectivity to the silicon-containing resist middle layer film and thus, the resist upper layer film pattern can be transferred to the silicon-containing resist middle layer film by dry etching with the fluorine-based gas plasma. According to this method, the pattern can be transferred to a silicon-containing film (silicon-containing resist middle layer film) even by using a resist composition which makes it difficult to form a pattern having film thickness sufficient for directly processing the substrate to be processed or a resist composition having dry etching resistance insufficient for processing the substrate. Subsequently transferring the pattern by dry etching with oxygen-based or hydrogen-based gas plasma can yield an organic film (resist underlayer film) pattern of the novolac resin or the like having dry etching resistance sufficient for processing the substrate. As the aforementioned resist underlayer film, many materials such as those described in Patent Document 1, for example, have already been known.

Meanwhile, in recent years, a 3D-NAND memory with a three-dimensional memory structure is becoming mainstream. To manufacture this 3D-NAND memory, it is required to form a thick resist underlayer film by a single process in the multilayer resist method. Therefore, a value of a resin concentration in a resist underlayer film material should be as high as 10% by mass or more. Additionally, there is recently an increasing trend of highly stacked 3D-NAND memories and in response to this trend, a growing need for a resist underlayer film having higher performance than the conventional ones regarding a gap-filling property to fill gaps in a pattern with a film without leaving voids.

As a resist underlayer film material capable of forming a thick resist underlayer film, for example, Patent Document 2 proposes a material containing a crosslinking agent in addition to an olefin-based polymer or a novolac polymer. However, there is concern about occurrence of voids since in the above material, the large amount of a hydroxyl group contained in the above polymer structure decreases flowability during filling of a substrate to be processed having a deep pattern as employed in the state-of-the-art process.

Meanwhile, as a resist underlayer film material containing a compound with a structure in which a hydroxyl group contained in a polymer is protected, a material is known in which a hydroxyl group contained in a novolac polymer is protected with a group containing a triple bond (Patent Document 3). However, the above material has insufficient adhesiveness to a substrate to be processed, and thus there is concern about occurrence of defects such as peeling during the process.

As described above, to manufacture a 3D-NAND memory with an increasingly highly stacked structure, a resist underlayer film material for manufacturing a semiconductor device, which has a favorable filling property without causing defects such as voids and peeling, and a patterning process using thereof have been demanded.

### CITATION LIST

### PATENT LITERATURE

Patent Document 1: JP 2004-205685 A
Patent Document 2: JP 6550760 B2
Patent Document 3: JP 5821694 B2

### SUMMARY OF INVENTION

### TECHNICAL PROBLEM

The present invention has been made in view of the above circumstances and aims to provide: a composition for forming a resist underlayer film having an excellent filling property and adhesiveness to a substrate, and a patterning process using thereof.

### SOLUTION TO PROBLEM

To solve the above-mentioned problems, the present invention provides a composition for forming a resist underlayer film used for a multilayer resist method, containing (A) a resin, (B) a base generator, and (C) an organic solvent, wherein
a weight-average molecular weight of (A) the resin is 3,000 to 10,000,
(A) the resin is (A-1) a resin containing a phenolic hydroxyl group and a group obtained by modifying a phenolic hydroxyl group, or (A-2) a mixture of a resin containing a phenolic hydroxyl group and a resin containing a group obtained by modifying a phenolic hydroxyl group, and
(A) the resin satisfies relations of a+b=1, 0.1≤a≤0.5, and 0.5≤b≤0.9, wherein "a" is a proportion of a phenolic hydroxyl group and "b" is a proportion of a group obtained by modifying a phenolic hydroxyl group contained in (A) the resin.

The composition for forming a resist underlayer film including such structure can have an excellent filling property and adhesiveness to a substrate, and adjusting the proportions in the structure within the above ranges enables both elimination of voids and prevention of peeling from the substrate upon filling the substrate to be processed.

Further in the present invention, (A) the resin preferably contains any of a styrene unit, a novolac-type phenol unit, and a novolac-type naphthol unit.

The composition for forming a resist underlayer film containing such resin can have the excellent filling property and etching resistance.

Further in the present invention, (A) the resin is preferably a resin having a constitutional unit represented by the following general formula (1-1) or (1-2),

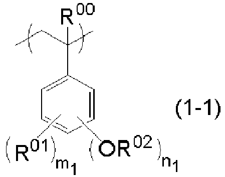

in the general formula (1-1), R⁰⁰ represents a hydrogen atom or a methyl group; R⁰¹ represents a saturated or unsaturated monovalent organic group having 1 to 30 carbon atoms; R⁰² represents a hydrogen atom, or a saturated or unsaturated optionally substituted monovalent organic group having 1 to 30 carbon atoms, satisfying relations of a'+b'=1, 0.1≤a'≤0.5, and 0.5≤b'≤0.9, wherein "a'" is a proportion of the hydrogen atom and "b'" is a proportion of the monovalent organic group to a structure constituting the R⁰²; *"*m₁*"* represents an integer of 0 to 4; *"*n₁*"* represents an integer of 1 to 5; and m₁+n₁ represents an integer of 1 or greater and 5 or smaller;

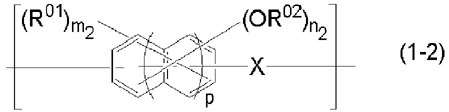

in the general formula (1-2), R⁰¹ represents a saturated or unsaturated monovalent organic group having 1 to 30 carbon atoms; R⁰² represents a hydrogen atom or a saturated or unsaturated optionally substituted monovalent organic group having 1 to 30 carbon atoms, satisfying relations of a'+b'=1, 0.1≤a'≤0.5, and 0.5≤b'≤0.9, wherein "a'" is a proportion of the hydrogen atom and "b'" is a proportion of the monovalent organic group to a structure constituting the R⁰²; X represents a divalent organic group having 1 to 30 carbon atoms; "p" represents 0 or 1, and when "p" is 0, "m₂" represents an integer of 0 to 3, "n₂" represents an integer of 1 to 4, and m₂+n₂ represents an integer of 1 or greater and 4 or smaller, whereas when "p" is 1, "m₂" represents an integer of 0 to 5, "n₂" represents an integer of 1 to 6, and m₂+n₂ represents an integer of 1 or greater and 6 or smaller.

The composition for forming a resist underlayer film containing such resin can achieve both the filling property and the adhesiveness to the substrate at a high level, and further enables the thick resist underlayer film to be formed without causing deposition defects such as cracks.

Further in the present invention, in the general formulae (1-1) and (1-2), the R⁰² is preferably any of a hydrogen atom, an alkyl group having 1 to 10 carbon atoms, and a structure represented by the following general formulae (8), 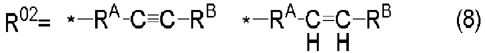 wherein * represents a bonding position to an oxygen atom; R^{A} represents an optionally substituted divalent organic group having 1 to 10 carbon atoms; and R^{B} represents a hydrogen atom or an optionally substituted monovalent organic group having 1 to 10 carbon atoms.

The composition for forming a resist underlayer film containing such resin can further enhance the filling property.

Further in the present invention, in the general formula (1-2), "p" is preferably 0.

Further in the present invention, in the general formula (1-1), *"*n₁*"* is preferably 1.

Further in the present invention, in the general formula (1-2), "n₂" is preferably 1.

The composition for forming a resist underlayer film containing such resin can further more enhance the filling property.

Further in the present invention, the "a" and the "b" preferably satisfy relations of a+b=1, 0.15≤a≤0.4, and 0.6≤b≤0.85.

The composition for forming a resist underlayer film containing such resin can achieve both the filling property and the adhesiveness to the substrate at a higher level.

Further in the present invention, (B) the base generator is preferably a compound which exhibits basicity due to pyrolysis.

In such composition for forming a resist underlayer film, it is expected that the phenolic hydroxyl group contained in (A) the resin has ionicity to increase interaction with a substrate during baking of the film, thereby achieving excellent film formability. By adjusting a content of the phenolic hydroxyl group in (A) the resin and an addition amount of (B) the base generator, it is possible to achieve both the filling property and the adhesiveness to the substrate.

Further, (B) the base generator is preferably represented by any of the following general formulae (2), (3), and (4), 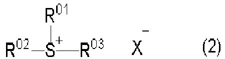 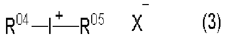 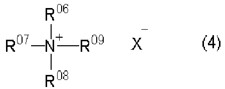 wherein each of R⁰¹ to R⁰³ independently represents a linear, branched, or cyclic alkyl group or alkenyl group having 1 to 10 carbon atoms, or an aralkyl group having 7 to 18 carbon atoms, which is optionally substituted with or separated by a heteroatom, or represents an aryl group having 6 to 18 carbon atoms, which is optionally substituted with or separated by a heteroatom; additionally, any two of R⁰¹, R⁰², and R⁰³ optionally bond together to form a ring with a sulfur atom in the formula; X⁻ represents an organic or inorganic anion as a counterion, but X⁻ does not contain OH-; each of R⁰⁴ and R⁰⁵ independently represents an aryl group having 6 to 20 carbon atoms, which is optionally substituted with or separated by a heteroatom, wherein part or all of hydrogen atoms thereof are optionally substituted with a linear, branched, or cyclic alkyl group or alkoxy group having 1 to 10 carbon atoms; additionally, R⁰⁴ and R⁰⁵ optionally bond together to form a ring with an iodine atom in the formula; each of R⁰⁶, R⁰⁷, R⁰⁸, and R⁰⁹ independently represents a hydrogen atom, a linear, branched, or cyclic alkyl group or alkenyl group having 1 to 20 carbon atoms, or an aralkyl group having 7 to 18 carbon atoms, which is optionally substituted with or separated by a heteroatom, or represents an aryl group having 6 to 18 carbon atoms, which is optionally substituted with or separated by a heteroatom; and any two or more of R⁰⁶, R⁰⁷, R⁰⁸, and R⁰⁹ optionally bond together to form a ring with a nitrogen atom in the formula.

Further, X⁻ in the general formulae (2), (3), and (4) is more preferably a structure represented by any of the following general formulae (5), (6), and (7), or any of anions selected from a group consisting of a chloride ion, a bromide ion, an iodide ion, a fluoride ion, a cyanide ion, a nitrate ion, and a nitrite ion,

R¹⁰-COO⁻ (5)

R¹¹-SO₃⁻ (6)

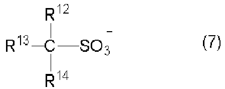

wherein R¹⁰ represents a linear, branched, or cyclic alkyl group or alkenyl group having 1 to 20 carbon atoms, an aralkyl group having 7 to 20 carbon atoms, or an aryl group having 6 to 20 carbon atoms, and optionally containing an ether group, an ester group, and a carbonyl group, wherein one or more hydrogen atoms of these groups are optionally substituted with a halogen atom, a hydroxyl group, a carboxyl group, an amino group, or a cyano group; R¹¹ represents an aryl group having 6 to 20 carbon atoms, wherein one or more hydrogen atoms of the aryl group are optionally substituted with a halogen atom, a hydroxyl group, a carboxyl group, an amino group, or a cyano group; each of R¹², R¹³, and R¹⁴ independently represents a hydrogen atom, a halogen atom other than a fluorine atom, a linear, branched, or cyclic alkyl group or alkenyl group having 1 to 20 carbon atoms, an aralkyl group having 7 to 20 carbon atoms, or an aryl group having 6 to 20 carbon atoms, and optionally containing an ether group, an ester group, and a carbonyl group, wherein one or more hydrogen atoms of these groups are optionally substituted with a halogen atom, a hydroxyl group, a carboxyl group, an amino group, or a cyano group, and two or more of R¹², R¹³, and R¹⁴ optionally bond together to form a ring.

Appropriate selection of such base generator (thermal base generator) exhibiting basicity due to pyrolysis allows the basicity to be exhibited according to a baking temperature of the composition for forming a resist underlayer film, thereby achieving both the filling property and the adhesiveness to the substrate. Additionally, since the entire amount thereof is decomposed or evaporated during the baking and none remains in the baked film, performances other than the film formability are not adversely affected.

In the present invention, (A) the resin preferably satisfies 2.00≤Mw/Mn≤5.00, where Mw is a weight-average molecular weight and Mn is a number-average molecular weight measured by gel permeation chromatography in terms of polystyrene.

The composition for forming a resist underlayer film containing such resin can prevent generation of a sublimate during baking of the film, thereby allowing to form the resist underlayer film having excellent film thickness uniformity and defect reduction performance. Additionally, it can further enhance the filling property due to its excellent thermal flowability.

Further in the present invention, a content of (A) the resin in the composition for forming a resist underlayer film is preferably 20% by mass or greater.

It is preferable from the viewpoint of productivity of a device that a concentration of (A) the resin contained in the composition for forming a resist underlayer film falls within the above range so that the thick resist underlayer film can be formed by applying the composition once.

Further in the present invention, the composition for forming a resist underlayer film can include (D) a crosslinking agent.

The composition for forming a resist underlayer film containing (D) the crosslinking agent can enhance a curing property, and be advantageous to thermally curing the thick resist underlayer film.

Further in the present invention, the composition for forming a resist underlayer film can include (E) a flowability accelerator, wherein a weight loss rate between 30°C to 190°C is less than 30% and the weight loss rate between 30°C to 350°C is 98% or greater.

(E) the flowability accelerator preferably contains one or more compounds selected from the following general formulae (i) to (iii), 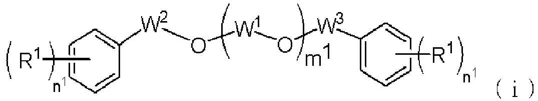
wherein each R¹ independently represents a hydrogen atom, a hydroxyl group, or an optionally substituted organic group having 1 to 10 carbon atoms; W¹ represents a phenylene group or a divalent group represented by the following general formula (i-1); W² and W³ represent a single bond or a divalent group represented by any of the following general formulae (i-2); "m¹" represents an integer of 1 to 10; and "n¹" represents an integer of 0 to 5; 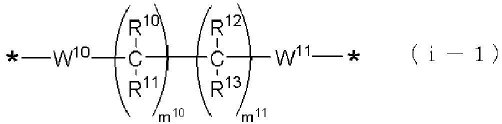
wherein * represents a bonding position; R¹⁰, R¹¹, R¹², and R¹³ represent a hydrogen atom, a hydroxyl group, or an organic group having 1 to 10 carbon atoms; each of W¹⁰ and W¹¹ independently represents a single bond or a carbonyl group; and *"*m¹⁰*"* and *"*m¹¹*"* represent an integer of 0 to 10 satisfying a relation of m¹⁰+m¹¹≥1; 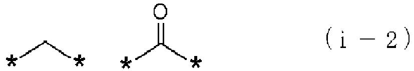
wherein * represents a bonding position; 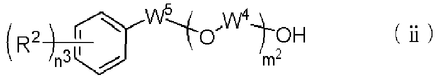
wherein each R² independently represents a hydrogen atom or an optionally substituted organic group having 1 to 10 carbon atoms; W⁴ represents a divalent group represented by the following general formula (ii-1); W⁵ represents a single bond or a divalent group represented by any of the following general formulae (ii-2); *"*m₂*"* represents an integer of 2 to 10; and *"*n³*"* represents an integer of 0 to 5; 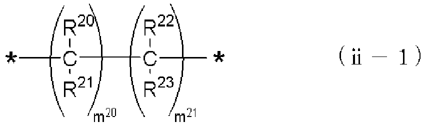
wherein * represents a boning position; R²⁰, R²¹, R²², and R²³ represent a hydrogen atom, a hydroxyl group, or an organic group having 1 to 10 carbon atoms; and *"*m²⁰*"* and *"*m²¹*"* represent an integer of 0 to 10 satisfying a relation of m²⁰+m²¹≥1; 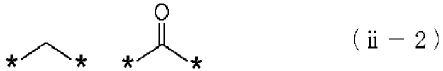
wherein * represents a bonding position; 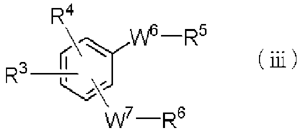
wherein R³ and R⁴ represent a hydrogen atom, a hydroxyl group, or an optionally substituted organic group having 1 to 10 carbon atoms, and optionally bond together to form a cyclic structure; R⁵ and R⁶ represent an organic group having 1 to 10 carbon atoms, wherein R⁵ represents a group containing either an aromatic ring or a divalent group represented by the following general formula (iii-1); and W⁶ and W⁷ represent a single bond or a divalent group represented by any of the following general formulae (iii-2), wherein at least one of W⁶ and W⁷ represents the divalent group represented by (iii-2); 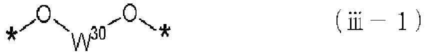
wherein * represents a bonding position; and W³⁰ represents an organic group having 1 to 4 carbon atoms; 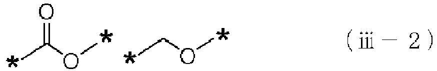
wherein * represents a bonding position.

The thermal flowability of (A) the resin is accelerated by containing such (E) flowability accelerator, thereby enabling the more enhanced filling property.

Further in the present invention, the composition for forming a resist underlayer film can further contain one or more of (F) a surfactant and (G) a plasticizer.

The composition for forming a resist underlayer film according to the present invention is practically preferable since presence/absence or selection of the additives as described above allows fine adjustment of performances according to requirements, such as application and deposition performance of spin coating, a curing temperature, filling/planarization properties, and optical properties (light absorption property), as necessary.

The present invention further provides a patterning process for forming a pattern in a substrate to be processed, including the steps of:
(I-1) applying the composition for forming a resist underlayer film according to the present invention on a substrate to be processed and thereafter performing heat treatment to form a resist underlayer film;
(I-2) forming a resist upper layer film on the resist underlayer film using a photoresist material;
(I-3) forming a pattern in the resist upper layer film by developing the resist upper layer film using a developer after pattern exposure;
(I-4) transferring the pattern to the resist underlayer film by dry etching while using the resist upper layer film having the formed pattern as a mask; and
(I-5) processing the substrate to be processed while using the resist underlayer film having the formed pattern as a mask to form the pattern in the substrate to be processed.

The present invention further provides a patterning process for forming a pattern in a substrate to be processed, including the steps of:
(II-1) applying the composition for forming a resist underlayer film according to the present invention on a substrate to be processed and thereafter performing heat treatment to form a resist underlayer film;
(II-2) forming a resist middle layer film on the resist underlayer film;
(II-3) forming a resist upper layer film on the resist middle layer film using a photoresist material;
(II-4) forming a pattern in the resist upper layer film by developing the resist upper layer film using a developer after pattern exposure;
(II-5) transferring the pattern to the resist middle layer film by dry etching while using the resist upper layer film having the formed pattern as a mask;
(II-6) transferring the pattern to the resist underlayer film by dry etching while using the resist middle layer film having the formed pattern as a mask; and
(II-7) processing the substrate to be processed while using the resist underlayer film having the formed pattern as a mask to form the pattern in the substrate to be processed.

The present invention further provides a patterning process for forming a pattern in a substrate to be processed, including the steps of:
(III-1) applying the composition for forming a resist underlayer film according to the present invention on a substrate to be processed and thereafter performing heat treatment to form a resist underlayer film;
(III-2) forming an inorganic hard mask middle layer film selected from a group consisting of a silicon oxide film,
a silicon nitride film, and a silicon oxynitride film on the resist underlayer film;
(III-3) forming an organic thin film on the inorganic hard mask middle layer film;
(III-4) forming a resist upper layer film on the organic thin film using a photoresist material;
(III-5) forming a pattern in the resist upper layer film by developing the resist upper layer film using a developer after pattern exposure;
(III-6) transferring the pattern to the organic thin film and the inorganic hard mask middle layer film by dry etching while using the resist upper layer film having the formed pattern as a mask;
(III-7) transferring the pattern to the resist underlayer film by dry etching while using the inorganic hard mask middle layer film having the formed pattern as a mask; and
(III-8) processing the substrate to be processed while using the resist underlayer film having the formed pattern as a mask to form the pattern in the substrate to be processed.

Accordingly, the composition for forming a resist underlayer film according to the present invention can be suitably used for various patterning processes including a two-layer resist process and a three-layer resist process using the silicon-containing resist middle layer film, as well as a four-layer resist process using the organic thin film. These patterning processes can effectively reduce unevenness and steps of the substrate to be processed by forming the resist underlayer film, and are suitable for photolithography of the resist upper layer film.

In the patterning process, the resist underlayer film preferably has thickness of at least 2 µm.

In the patterning process, the resist underlayer film is preferably coated to have thickness of at least 2 µm by applying, one time, the composition for forming a resist underlayer film according to the present invention.

Such patterning process is preferable from the viewpoint of productivity of a device since it can form the thick resist underlayer film by applying the composition once.

### ADVANTAGEOUS EFFECTS OF INVENTION

As described above, the composition for forming a resist underlayer film and the patterning process according to the present invention are particularly suitable for use in a multilayer resist process including filling/planarization of a substrate to be processed having steps and unevenness, and are significantly useful in fine patterning for manufacturing a semiconductor device. Particularly, the present invention can provide: a composition for forming a resist underlayer film capable of forming a resist underlayer film having an excellent filling property without causing defects such as voids and peeling even on a substrate to be processed having a portion especially difficult to fill due to its high aspect ratio, typified by a 3D-NAND memory with an increasingly highly stacked structure, in a fine patterning process by a multilayer resist method in a manufacturing process of a semiconductor device, the composition further having a proper planarization property, etching characteristics, and optical properties; and a patterning process using the composition.

### BRIEF DESCRIPTION OF DRAWINGS

FIG. 1 is an illustrative diagram of one example of a patterning process (three-layer resist process) according to the present invention;
FIG. 2 is an illustrative diagram of an evaluation method of a filling property; and
FIG. 3 shows SEM images showing a cross-sectional shape of a resist underlayer film formed by using the composition of the present invention and a substrate, and a cross-sectional shape of a resist underlayer film formed by using a composition of Comparative Example and a substrate.

### DESCRIPTION OF EMBODIMENTS

Hereinafter, the present invention will be described in more detail. As described above, a composition for forming a resist underlayer film and a patterning process have been demanded, that enable formation of a resist underlayer film having an excellent filling property without causing defects such as voids and peeling even on a substrate to be processed having a portion especially difficult to fill due to its high aspect ratio, typified by a 3D-NAND memory with an increasingly highly stacked structure, in a fine patterning process by a multilayer resist method in a manufacturing process of a semiconductor device.

The present inventors have made an investigation on various resist underlayer film materials and a patterning process to enable both realization of a high filling property on a substrate to be processed having a portion especially difficult to fill due to its high aspect ratio, typified by a 3D-NAND memory, and adhesiveness to the substrate to be processed upon forming a thick resist underlayer film in multilayer lithography using the resist underlayer film. As a result, the inventors have found that a composition for forming a resist underlayer film containing a resin and a base generator that have a specific structure, and a patterning process are very effective, and completed the present invention.

That is, the present invention provides a composition for forming a resist underlayer film used for a multilayer resist method, containing (A) a resin, (B) a base generator, and (C) an organic solvent, wherein
a weight-average molecular weight of (A) the resin is 3,000 to 10,000,
(A) the resin is (A-1) a resin containing a phenolic hydroxyl group and a group obtained by modifying a phenolic hydroxyl group, or (A-2) a mixture of a resin containing a phenolic hydroxyl group and a resin containing a group obtained by modifying a phenolic hydroxyl group, and
(A) the resin satisfies relations of a+b=1, 0.1≤a≤0.5, and 0.5≤b≤0.9, wherein "a" is a proportion of a phenolic hydroxyl group and "b" is a proportion of a group obtained by modifying a phenolic hydroxyl group contained in (A) the resin.

Hereinafter, the present invention will be described in detail. However, the present invention is not limited thereto.

### Composition for Forming Resist Underlayer Film

The composition for forming a resist underlayer film according to the present invention is used for a multilayer resist method as described above and contains (A) a resin, (B) a base generator, and (C) an organic solvent, wherein
a weight-average molecular weight of (A) the resin is 3,000 to 10,000,
(A) the resin is (A-1) a resin containing a phenolic hydroxyl group and a group obtained by modifying a phenolic hydroxyl group, or (A-2) a mixture of a resin containing a phenolic hydroxyl group and a resin containing a group obtained by modifying a phenolic hydroxyl group, and
(A) the resin satisfies relations of a+b=1, 0.1≤a≤0.5, and 0.5≤b≤0.9, wherein "a" is a proportion of a phenolic hydroxyl group and "b" is a proportion of a group obtained by modifying a phenolic hydroxyl group contained in (A) the resin.

(A) the resin containing the group obtained by modifying a phenolic hydroxyl group in the proportion within the above range can provide the composition for forming a resist underlayer film with excellent thermal flowability, thereby enabling formation of the resist underlayer film having an excellent filling property. Additionally, (A) the resin containing the phenolic hydroxyl group in the proportion within the above range acts with (B) the base generator to enable formation of the resist underlayer film having excellent adhesiveness to a substrate.

Furthermore, the composition for forming a resist underlayer film according to the present invention contains (A) the resin, (B) the base generator, and (C) the organic solvent, wherein a content of (A) the resin is preferably 20% by mass or greater, more preferably 25% by mass or greater, and further preferably 30% by mass or greater.

When the composition for forming a resist underlayer film contains (A) the resin in the proportion as described above, the thick resist underlayer film can be formed by applying the composition once.

### (A) Resin

(A) the resin contained in the composition for forming a resist underlayer film according to the present invention is (A-1) a resin containing a phenolic hydroxyl group and a group obtained by modifying a phenolic hydroxyl group, or (A-2) a mixture of a resin containing a phenolic hydroxyl group and a resin containing a group obtained by modifying a phenolic hydroxyl group, satisfying relations of a+b=1, 0.1≤a≤0.5, and 0.5≤b≤0.9, wherein "a" is a proportion of a phenolic hydroxyl group contained in (A) the resin and "b" is a proportion of a group obtained by modifying a phenolic hydroxyl group contained in (A) the resin. The relation between "a" and "b" preferably satisfies a+b=1, 0.1≤a≤0.5, and 0.5≤b<0.9, and more preferably a+b=1, 0.15≤a≤0.4, and 0.6≤b≤0.85. When the proportion of the "b" is less than 0.5, there is concern that increased contribution of hydrogen bonding with the phenolic hydroxyl group increases complex viscosity of the resin, resulting in lower flowability and deterioration in the filling property. When the proportion of the "b" is greater than 0.9, there is concern that the low proportion of the phenolic hydroxyl group in the resin slows down the action with (B) the base generator, resulting in deterioration in the adhesiveness to the substrate to be processed.

Furthermore, (A) the resin preferably contains any of a styrene unit, a novolac-type phenol unit, and a novolac-type naphthol unit.

Furthermore, the resin preferably has a constitutional unit particularly represented by the following general formula (1-1) or (1-2),

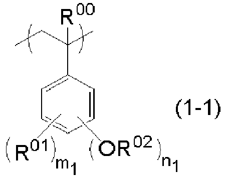

in the general formula (1-1), R⁰⁰ represents a hydrogen atom or a methyl group; R⁰¹ represents a saturated or unsaturated monovalent organic group having 1 to 30 carbon atoms; R⁰² represents a hydrogen atom, or a saturated or unsaturated optionally substituted monovalent organic group having 1 to 30 carbon atoms, satisfying relations of a'+b'=1, 0.1≤a'≤0.5, and 0.5≤b'≤0.9, wherein "a'" is a proportion of the hydrogen atom to a structure constituting the R⁰² and "b'" is a proportion of the monovalent organic group to a structure constituting the R⁰²; *"*m₁*"* represents an integer of 0 to 4; *"*n₁*"* represents an integer of 1 to 5; and m₁+n₁ represents an integer of 1 or greater and 5 or smaller;

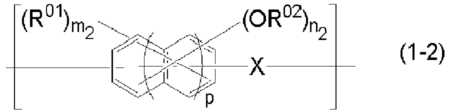

in the general formula (1-2), R⁰¹ represents a saturated or unsaturated monovalent organic group having 1 to 30 carbon atoms; R⁰² represents a hydrogen atom or a saturated or unsaturated optionally substituted monovalent organic group having 1 to 30 carbon atoms, satisfying relations of a'+b'=1, 0.1≤a'≤0.5, and 0.5≤b'≤0.9, wherein "a'" is a proportion of the hydrogen atom to a structure constituting the R⁰² and "b'" is a proportion of the monovalent organic group to a structure constituting the R⁰²; X represents a divalent organic group having 1 to 30 carbon atoms; "p" represents 0 or 1, and when "p" is 0, *"*m₂*"* represents an integer of 0 to 3, "n₂" represents an integer of 1 to 4, and m₂+n₂ represents an integer of 1 or greater and 4 or smaller, whereas when "p" is 1, "m₂" represents an integer of 0 to 5, "n₂" represents an integer of 1 to 6, and m₂+n₂ represents an integer of 1 or greater and 6 or smaller.

By employing (A) the resin having the constitutional unit represented by the general formula (1-1) or (1-2), it is possible to provide the composition for forming a resist underlayer film having the better thermal flowability and substrate affinity. Additionally, it is possible to form the thick resist underlayer film having excellent etching resistance without causing deposition defects such as cracks.

Examples of the saturated or unsaturated optionally substituted monovalent organic group having 1 to 30 carbon atoms represented by R⁰¹ in the above general formulae (1-1) and (1-2) include: monovalent saturated hydrocarbon groups such as methyl group, ethyl group, n-propyl group, i-propyl group, n-butyl group, i-butyl group, sec-butyl group, tert-butyl group, n-pentyl group, iso-pentyl group, sec-pentyl group, and tert-pentyl group; monovalent unsaturated chain hydrocarbon groups such as ethenyl group, propenyl group, butenyl group, pentenyl group, ethynyl group, and propynyl group; monocyclic saturated cyclic hydrocarbon groups such as cyclobutyl group, cyclopentyl group, cyclohexyl group, cycloheptyl group, and cyclooctyl group; monovalent monocyclic unsaturated cyclic hydrocarbon groups such as cyclobutenyl group, cyclopentenyl group, and cyclohexenyl group; monovalent polycyclic cyclic hydrocarbon groups such as norbornyl group and adamantyl group; monovalent aromatic hydrocarbon groups such as phenyl group, methylphenyl group, naphthyl group, methylnaphthyl group, anthryl group, and methylanthryl group; and the like.

The organic group represented by the above R⁰¹ includes: an alkoxy group such as methoxy group, ethoxy group, n-propoxy group, i-propoxy group, n-butoxy group, i-butoxy group, sec-butoxy group, t-butoxy group, n-pentyloxy group, and n-hexyloxy group; an alkoxycarbonyl group such as methoxycarbonyl group, ethoxycarbonyl group, n-propoxycarbonyl group, i-propoxycarbonyl group, n-butoxycarbonyl group, i-butoxycarbonyl group, sec-butoxycarbonyl group, t-butoxycarbonyl group, n-pentyloxycarbonyl group, and n-hexyloxycarbonyl group; and the like.

Part or all of hydrogen atoms included in the aforementioned saturated hydrocarbon groups, unsaturated chain hydrocarbon groups, monocyclic saturated cyclic hydrocarbon groups, monocyclic unsaturated cyclic hydrocarbon groups, polycyclic cyclic hydrocarbon groups, aromatic hydrocarbon groups, alkoxy groups, alkoxycarbonyl groups, and the like are optionally substituted, and examples of the substituent include: halogen atoms such as fluorine atom, chlorine atom, bromine atom, and iodine atom; hydroxyl group, cyano group, carboxy group, nitro group, amino group, alkoxy group, alkoxycarbonyl group, acyl group, alkoxycarbonyloxy group, aryl group, aliphatic heterocyclic groups such as lactone group; aromatic heterocyclic groups such as furyl group and pyridyl group; and the like.

From the viewpoints of the filling property and availability of raw materials, the organic group represented by the above R⁰¹ is preferably a methyl group.

Examples of the divalent organic group having 1 to 30 carbon atoms represented by X in the above general formula (1-2) include: alkanediyl groups such as methylene group, ethanediyl group, propanediyl group, butanediyl group, pentanediyl group, hexanediyl group, octanediyl group, and decanediyl group; monocyclic cycloalkanediyl groups such as cyclopropanediyl group, cyclobutanediyl group, cyclopentanediyl group, cyclohexanediyl group, cycloheptanediyl group, cyclooctanediyl group, cyclodecanediyl group, methylcyclohexanediyl group, and ethylcyclohexanediyl group; polycyclic cycloalkanediyl groups such as bicyclo[2.2.1]heptanediyl group, bicyclo[2.2.2]octanediyl group, tricyclo[5.2.1.0^{2,6}]decanediyl group (dicyclopentylene group), tricyclo[3.3.1.1^{3,7}]decanediyl group, tetracyclo[6.2.1.1^{3,6}.0^{2,7}]dodecanediyl group, and adamantanediyl group; arenediyl groups such as phenylene group and naphthylene group; and the like.

Examples of an alkanediyloxy group represented by the above X include a group combining the aforementioned alkanediyl group and an oxygen atom, and the like. Additionally, examples of a cycloalkanediyloxy group represented by the above X include a group combining the aforementioned cycloalkanediyl group and an oxygen atom, and the like.

Part or all of hydrogen atoms included in the aforementioned alkanediyl groups, cycloalkanediyl groups, alkanediyloxy groups, cycloalkanediyloxy groups, arenediyl groups, and the like are optionally substituted, and examples of the substituent include the same groups as the exemplary substituents that the organic group represented by the R⁰¹ may have, and the like.

The organic group represented by the above X includes groups represented by the following formulae and the like, 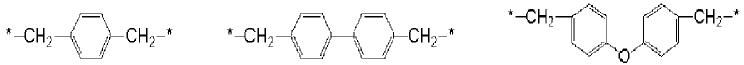 wherein * represents a bonding arm.

From the viewpoints of the filling property and the availability of raw materials, the organic group represented by the above X is preferably a methylene group.

In the above general formulae (1-1) and (1-2), R⁰² represents a hydrogen atom or a saturated or unsaturated optionally substituted monovalent organic group having 1 to 30 carbon atoms, and a preferable structure of the R⁰² includes any of a hydrogen atom, an alkyl group having 1 to 10 carbon atoms, and a structure represented by the following general formulae (8), 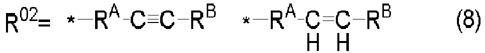 wherein * represents a bonding position to an oxygen atom; R^{A} represents an optionally substituted divalent organic group having 1 to 10 carbon atoms; and R^{B} represents a hydrogen atom or an optionally substituted monovalent organic group having 1 to 10 carbon atoms.

Examples of the divalent organic group having 1 to 10 carbon atoms represented by R^{A} in the above general formulae (8) include; alkanediyl groups such as methylene group, ethanediyl group, propanediyl group, butanediyl group, pentanediyl group, hexanediyl group, octanediyl group, and decanediyl group; arenediyl groups such as benzenediyl group, methylbenzenediyl group, and naphthalenediyl group; and the like.

Examples of the monovalent organic group having 1 to 10 carbon atoms represented by R^{B} in the above general formulae (8) include: alkyl groups such as methyl group, ethyl group, n-propyl group, i-propyl group, n-butyl group, i-butyl group, sec-butyl group, t-butyl group, n-pentyl group, n-hexyl group, n-octyl group, and n-decyl group; aryl groups such as phenyl group, tolyl group, xylyl group, mesityl group, and naphthyl group; and the like.

Part or all of hydrogen atoms included in the aforementioned alkanediyl groups, arenediyl groups, alkyl groups, aryl groups, and the like are optionally substituted, and examples of the substituent include the same groups as the exemplary substituents that the organic group represented by the R⁰¹ may have, and the like.

The particularly preferable examples thereof include structures described below. Having such structure imparts the favorable flowability and enhances the filling property and planarization property. Additionally, it can impart favorable heat resistance and film formability, and prevent generation of a sublimate during heat curing, contamination of an apparatus due to the sublimate, and occurrence of application defects.

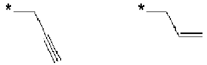

In the formulae, * represents a bonding position to an oxygen atom.

In the resin having the constitutional unit represented by the above general formula (1-1), specific examples of the structure wherein the R⁰² represents a monovalent organic group include, but are not limited to, the following ones, 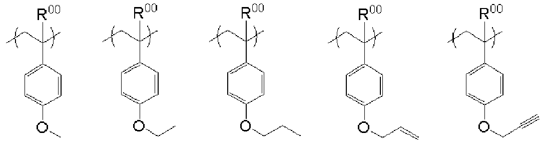 wherein R°° is the same as the above.

In the resin having the constitutional unit represented by the above general formula (1-2), specific examples of the structure wherein the R⁰² represents a monovalent organic group include, but are not limited to, the following ones.

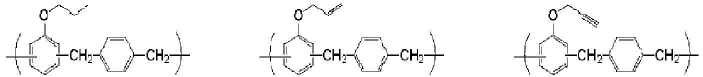

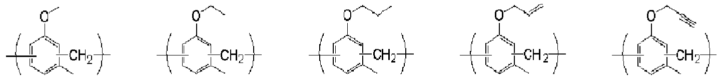

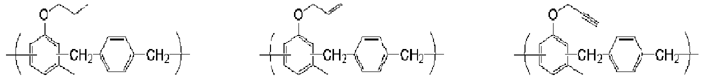

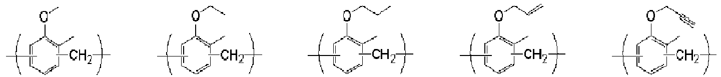

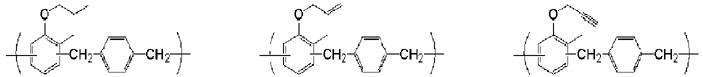

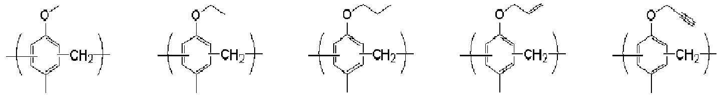

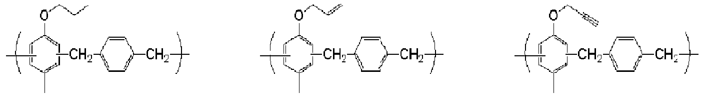

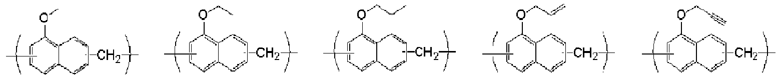

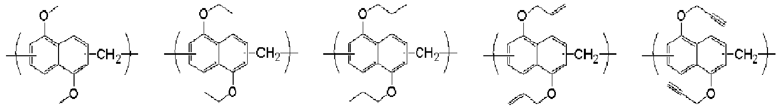

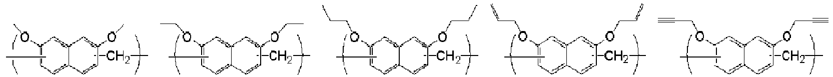

Further, in the above general formulae (1-1) and (1-2), "a'" and "b'" satisfy relations of a'+b'=1, 0.1≤a'≤0.5, and 0.5≤b'≤0.9, wherein "a'" is a proportion of the hydrogen atom to a structure constituting the R⁰² and "b'" is a proportion of the monovalent organic group to a structure constituting the R⁰². The "a'" and "b'" preferably satisfy relations of a'+b'=1, 0.1≤a'≤0.5, and 0.5≤b'<0.9, and more preferably satisfy relations of a'+b'=1, 0.15≤a'≤0.4, and 0.6≤b'≤0.85. When the proportion of the "b'" is less than 0.5, there is concern that increased contribution of hydrogen bonding with the phenolic hydroxyl group increases the complex viscosity of the resin, resulting in the lower flowability and deterioration in the filling property. When the proportion of the "b'" is greater than 0.9, there is concern that the low proportion of the phenolic hydroxyl group in the resin slows down the action with (B) the base generator, resulting in deterioration in the adhesiveness to the substrate to be processed.

For example, in a case of forming the thick resist underlayer film on the substrate to be processed, the lower complex viscosity of the resin is preferable because of its excellent film forming property so as to reduce a consumption amount of a chemical liquid. On the other hand, in a case where hydrophobization of the resin is intended to decrease the complex viscosity of the resin, a problem of the decreased adhesiveness to the substrate to be processed will be caused. The composition for forming a resist underlayer film according to the present invention combines (A) the resin having the excellent flowability and the adhesiveness to the substrate and (B) the base generator with a function of further enhancing the adhesiveness of the resin to the substrate, thereby enabling formation of the resist underlayer film having the extremely good adhesiveness to the substrate.

Furthermore, in the above general formula (1-1), "n₁" represents an integer of 1 to 5, preferably 1 or 2, and more preferably 1. Further, in the above general formula (1-2), "p" represents 0 or 1, and when "p" is 0, "n₂" represents an integer of 1 to 4, whereas when "p" is 1, "n₂" represents an integer of 1 to 6. It is preferable that "p" is 0 and "n₂" is 1. The composition for forming a resist underlayer film including such structure can demonstrate the extremely good filling property even for the substrate to be processed having a portion especially difficult to fill due to its high aspect ratio, and form the resist underlayer film without causing voids or peeling from the substrate to be processed.

Furthermore, in the above general formula (1-1), "m₁" represents an integer of 0 to 4, and m₁+n₁ represents an integer of 1 or greater and 5 or smaller. Further, in the above general formula (1-2), when "p" is 0, *"*m₂*"* represents an integer of 0 to 3 and m₂+n₂ represents an integer of 1 or greater and 4 or smaller, whereas when "p" is 1, "m₂" represents an integer of 0 to 5 and m₂+n₂ represents an integer of 1 or greater and 6 or smaller.

A weight-average molecular weight of (A) the resin is 3,000 to 10,000. The weight-average molecular weight is based on a value measured by gel permeation chromatography (tetrahydrofuran solvent, polystyrene standard). The weight-average molecular weight of (A) the resin having the constitutional unit represented by the general formulae (1-1) and (1-2) is 3,000 to 10,000, and preferably 4,000 to 9,500. If the weight-average molecular weight is less than 3,000, an apparatus is contaminated due to increase in generation of a sublimate during baking of the film. On the other hand, if the weight-average molecular weight is greater than 10,000, the thermal flowability becomes insufficient, resulting in the poor filling property. Accordingly, adjusting the molecular weight of the resin within an appropriate range can balance conflicting effects of increase in the molecular weight of the resin, that causes deterioration in the thermal flowability and thus the deterioration in the filling property, and decrease in the molecular weight of the resin, that causes increase in generation of a sublimate due to a low molecular weight component in the resin.

Furthermore, a ratio of the weight-average molecular weight Mw, as measured by gel permeation chromatography versus a polystyrene standard, to a number-average molecular weight Mn, or Mw/Mn of (A) the resin, preferably satisfies 2.00≤Mw/Mn≤5.00, and more preferably satisfies 2.50≤Mw/Mn≤4.00. If Mw/Mn is 5.00 or smaller, there is no contamination of the apparatus caused by increase in generation of a sublimate during baking of the film. On the other hand, the ratio of the weight-average molecular weight Mw to the number-average molecular weight Mn, or Mw/Mn, is 2.00 or greater, the sufficient thermal flowability can be demonstrated due to a contained low molecular weight component, thereby imparting the excellent filling property. Accordingly, adjusting the ratio of the weight-average molecular weight Mw to the number-average molecular weight Mn, or Mw/Mn of the resin, within an appropriate range can balance conflicting effects of monodisperse of the resin, that causes deterioration in the thermal flowability and thus the filling property, and polydispersity that causes increase in generation of a sublimate due to the low molecular weight component in the resin.

In the present invention, (A) the resin can be used alone or in combination of two or more kinds thereof. Alternatively, a resin not containing the constitutional unit represented by the above general formula (1-1) or (1-2) may be mixed with. In this case, a resin that may be mixed is not particularly limited and known resins are usable. Specifically, an acrylic resin, a styreneic resin, a phenol resin, a polyether resin, and an epoxy resin are preferable.

Yet another compound or polymer can also be blended with the composition for forming a resist underlayer film according to the present invention for any purpose. When mixed with the resin having the constitutional unit represented by the above general formula (1-1) or (1-2), the compound or polymer to be blended serves as enhancing the film formability in spin coating and the filling property for a substrate having steps. Additionally, a compound having a phenolic hydroxyl group is preferable as the compound or the polymer to be blended.

Examples of such material include: novolac resins of phenol, o-cresol, m-cresol, p-cresol, 2,3-dimethylphenol, 2,5-dimethylphenol, 3,4-dimethylphenol, 3,5-dimethylphenol, 2,4-dimethylphenol, 2,6-dimethylphenol, 2,3,5-trimethylphenol, 3,4,5-trimethylphenol, 2-tert-buthylphenol, 3-tert-buthylphenol, 4-tert-buthylphenol, 2-phenylphenol, 3-phenylphenol, 4-phenylphenol, 3,5-diphenylphenol, 2-naphthylphenol, 3-naphthylphenol, 4-naphthylphenol, 4-tritylphenol, resorcinol, 2-methylresorcinol, 4-methylresorcinol, 5-methylresorcinol, catechol, 4-tert-butylcatechol, 2-methoxyphenol, 3-methoxyphenol, 2-propylphenol, 3-propylphenol, 4-propylphenol, 2-isopropylphenol, 3-isopropylphenol, 4-isopropylphenol, 2-methoxy-5-methylphenol, 2-tert-buthyl-5-methylphenol, pyrogallol, thymol, isothymol, 4,4'-(9H-fluorene-9-ylidene)bisphenol, 2,2'-dimethyl-4,4'-(9H-fluorene-9-ylidene)bisphenol, 2,2'-diallyl-4,4'-(9H-fluorene-9-ylidene)bisphenol, 2,2'-difluoro-4,4'-(9H-fluorene-9-ylidene)bisphenol, 2,2'-diphenyl-4,4'-(9H-fluorene-9-ylidene)bisphenol, 2,2'-dimethoxy-4,4'-(9H-fluorene-9-ylidene)bisphenol, 2,3,2',3'-tetrahydro-(1,1')-spirobiindene-6,6'-diol, 3,3,3',3'-tetrametyl-2,3,2',3'-tetrahydro-(1,1')-spirobiindene-6,6'-diol, 3,3,3',3',4,4'-hexamethyl-2,3,2',3'-tetrahydro-(1,1')-spirobiindene-6,6'-diol, 2,3,2',3'-tetrahydro-(1,1')-spirobiindene-5,5'-diol, 5,5'-dimethy-3,3,3',3'-tetramethyl-2,3,2',3'-tetrahydro-(1,1')-spirobiindene-6,6'-diol, 1-naphthol, 2-naphthol, 2-methyl-1-naphthol, 4-methoxy-1-naphthol, 7-methoxy-2-naphthol, dihydroxynaphthalene such as 1,5-dihydroxynaphthalene, 1,7-dihydroxynaphthalene, and 2,6-dihydroxynaphthalene, methyl 3-hydroxynaphthalene-2-carboxylate, indene, hydroxyindene, benzofuran, hydroxyanthracene, acenaphthylene, biphenyl, bisphenol, trisphenol, dicyclopentadiene, tetrahydroindene, 4-vinylcyclohexene, norbornadiene, 5-vinylnorborna-2-ene, α-pinene, β-pinene, limonene, and the like; polyhydroxystyrene, polystyrene, polyvinylnaphthalene, polyvinylanthracene, polyvinylcarbazole, polyindene, polyacenaphthylene, polynorbornene, polycyclodecene, polytetracyclododecene, polynortricyclene, poly(meth)acrylate, and copolymers thereof. It is also possible to blend a naphthol dicyclopentadiene copolymer described in JP 2004-205685 A, a fluorenebisphenol novolac resin described in JP 2005-128509 A, an acenaphthylene copolymer described in JP 2005-250434 A, a fullerene having a phenol group described in JP 2006-227391 A, a bisphenol compound and a novolac resin thereof described in JP 2006-293298 A, an adamantanephenol compound and a novolac resin thereof described in JP 2006-285095 A, a bisnaphthol compound and a novolac resin thereof described in JP 2010-122656 A, a fullerene resin compound described in JP 2008-158002 A, and the like.

### (B) Base Generator

The composition for forming a resist underlayer film according to the present invention contains (B) the base generator, thereby enabling formation of the resist underlayer film having the favorable adhesiveness to the substrate to be processed without causing defects such as peeling from the substrate during dry etching even in a case of forming the thick resist underlayer film, for example. To maximize the effect of the base generator, it is preferable to use no acid generator.

In the present invention, the base generator is also referred to as "latent base" or "base precursor", referring to a compound that changes the chemical structure thereof by external stimulation such as light and heat to generate a base. The base to be generated may be not only a general base such as ammonia and amine but also a chemical species having a function to increase ionicity of the phenolic hydroxyl group in (A) the resin.

The base generator as the component (B) is not particularly limited, and known base generators can be used as necessary. Heating is performed during deposition using the composition for forming a resist underlayer film according to the present invention, and the film formability is expected to be enhanced as the phenolic hydroxyl group in (A) the resin has ionicity to increase the interaction with the substrate during the heating. Therefore, (B) the base generator is preferably a compound which exhibits basicity due to pyrolysis. This is because the composition for forming a resist underlayer film containing such component (B) can achieve both the thermal flowability of the film and the interaction with the substrate by adjusting an addition amount of the component (B).

When the base generator (also referred to as a thermal base generator) which exhibits basicity due to pyrolysis is used as the component (B) in this manner, the base to be generated is an excess cation in a system resulting from evaporation or decomposition of an anion, the cation specifically including a triphenylsulfonium cation, a tetrabutylammonium cation, and the like. These increase ionicity (polarity) of the phenolic hydroxyl group in (A) the resin to interact with a polar group such as a silanol group present on the substrate even if the substrate is subjected to hydrophobic treatment such as HMDS treatment, thereby improving adhesiveness between the composition for forming a resist underlayer film and the substrate. Meanwhile, the action as described above does not occur before the heating, that is, before the base is generated, so that the flowability itself of the composition for forming a resist underlayer film is maintained. In this manner, the resist underlayer film having the excellent film formability can be formed.

Furthermore, (B) the base generator is more preferably represented by any of the following general formulae (2), (3), and (4),

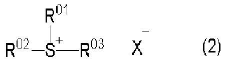

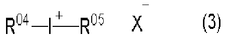

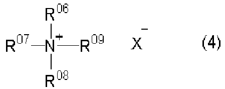

wherein each of R⁰¹ to R⁰³ independently represents a linear, branched, or cyclic alkyl group or alkenyl group having 1 to 10 carbon atoms, or an aralkyl group having 7 to 18 carbon atoms, which is optionally substituted with or separated by a heteroatom, or represents an aryl group having 6 to 18 carbon atoms, which is optionally substituted with or separated by a heteroatom; additionally, any two of R⁰¹, R⁰², and R⁰³ optionally bond together to form a ring with a sulfur atom in the formula; X- represents an organic or inorganic anion as a counterion, but X⁻ does not contain OH-; each of R⁰⁴ and R⁰⁵ independently represents an aryl group having 6 to 20 carbon atoms, which is optionally substituted with or separated by a heteroatom, wherein part or all of hydrogen atoms thereof are optionally substituted with a linear, branched, or cyclic alkyl group or alkoxy group having 1 to 10 carbon atoms; additionally, R⁰⁴ and R⁰⁵ optionally bond together to form a ring with an iodine atom in the formula; each of R⁰⁶, R⁰⁷, R⁰⁸, and R⁰⁹ independently represents a hydrogen atom, a linear, branched, or cyclic alkyl group or alkenyl group having 1 to 20 carbon atoms, or an aralkyl group having 7 to 18 carbon atoms, which is optionally substituted with or separated by a heteroatom, or represents an aryl group having 6 to 18 carbon atoms, which is optionally substituted with or separated by a heteroatom; and any two or more of R⁰⁶, R⁰⁷, R⁰⁸, and R⁰⁹ optionally bond together to form a ring with a nitrogen atom in the formula.

Specifically, R⁰¹, R⁰², and R⁰³ in the general formula (2) include: alkyl groups such as methyl group, ethyl group, n-propyl group, isopropyl group, n-butyl group, tert-butyl group, cyclopropyl group, cyclopentyl group, cyclohexyl group, cyclopropylmethyl group, 4-methylcyclohexyl group, cyclohexylmethyl group, norbornyl group, and adamantyl group; alkenyl groups such as vinyl group, allyl group, propenyl group, butenyl group, hexenyl group, and cyclohexenyl group; aryl groups such as phenyl group, naphthyl group, and thienyl group; aralkyl groups such as benzyl group, 1-phenylethyl group, and 2-phenylethyl group; and the like. Among these, an aryl group is preferable. Additionally, part of hydrogen atoms thereof is optionally substituted with or separated by a heteroatom such as an oxygen atom, a sulfur atom, a nitrogen atom, and a halogen atom, and as a result, a hydroxy group, a cyano group, a carbonyl group, an ether bond, an ester bond, a sulfonate ester bond, a carbonate bond, a lactone ring, a sultone ring, a carboxylic anhydride, a haloalkyl group, and the like may be formed or interposed.

When any two of R⁰¹, R⁰², and R⁰³ are bonded to each other directly or via an oxygen atom, a methylene group, a sulfone group, or a carbonyl group, examples thereof include, but are not limited to, a dibenzothiophene skeleton, a phenoxathiin skeleton, and partial structures illustrated below. Note that in the following formulae, there may be a substituent at a given position on an aromatic ring.

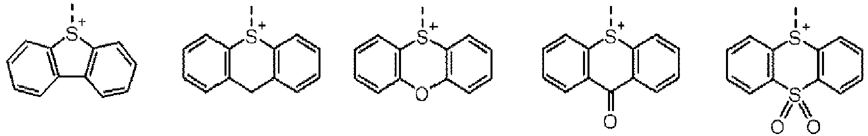

More specifically, the sulfonium cation includes triphenylsulfonium, 4-hydroxyphenyldiphenylsulfonium, bis(4-hydroxyphenyl)phenylsulfonium, tris(4-hydroxyphenyl)sulfonium, 4-tert-butoxyphenyldiphenylsulfonium, bis(4-tert-butoxyphenyl)phenylsulfonium, tris(4-tert-butoxyphenyl)sulfonium, 3-tert-butoxyphenyldiphenylsulfonium, bis(3-tert-butoxyphenyl)phenylsulfonium, tris(3-tert-butoxyphenyl)sulfonium, 4-tert-butylphenyldiphenylsulfonium, tris(4-tert-butylphenyl)sulfonium, 3,4-di-tert-butoxyphenyldiphenylsulfonium, bis(3,4-di-tert-butoxyphenyl)phenylsulfonium, tris(3,4-di-tert-butoxyphenyl)sulfonium, diphenyl(4-thiophenoxyphenyl)sulfonium, 10-phenylphenoxathiinium, S-phenyldibenzothiophenium, 4-tert-butoxycarbonylmethyloxyphenyldiphenylsulfonium, tris(4-tert-butoxycarbonylmethyloxyphenyl)sulfonium, (4-tert-butoxyphenyl)bis(4-dimethylaminophenyl)sulfonium, tris(4-dimethylaminophenyl)sulfonium, 2-naphthyldiphenylsulfonium, (4-hydroxy-3,5-dimethylphenyl)diphenylsulfonium, (4-n-hexyloxy-3,5-dimethylphenyl)diphenylsulfonium, and the like. The sulfonium cation further includes 4-methacryloyloxyphenyldiphenylsulfonium, 4-acryloyloxyphenyldiphenylsulfonium, 4-methacryloyloxyphenyldimethylsulfonium, 4-acryloyloxyphenyldimethylsulfonium, (4-methacryloyloxy-3,5-dimethylphenyl)diphenylsulfonium, (4-acryloyloxy-3,5-dimethylphenyl)diphenylsulfonium, and the like. More preferably, the sulfonium cation includes triphenylsulfonium, 4-tert-butylphenyldiphenylsulfonium, 4-tert-butoxyphenyldiphenylsulfonium, 10-phenylphenoxathiinium, S-phenyldibenzothiophenium, and the like. Among them, triphenylsulfonium, 4-tert-butylphenyldiphenylsulfonium, and 4-tert-butoxyphenyldiphenylsulfonium are more preferable.

Specifically, R⁰⁴ and R⁰⁵ in the general formula (3) include, but are not limited to: phenyl group; naphthyl group; tolyl group, xylyl group, trimethylphenyl group, ethylphenyl group, isopropylphenyl group, tert-butylphenyl group, 1-adamanthylphenyl group, triisopropylphenyl group, tricyclohexylphenyl group, methoxyphenyl group, ethoxyphenyl group, butoxyphenyl group, hydroxyphenyl group, dihydroxyphenyl group, trimethoxyphenyl group, methylthiophenyl group, biphenyl group, fluorophenyl group, difluorophenyl group, bromophenyl group, iodophenyl group, N,N-diphenylaminophenyl group, acetoxyphenyl group, acetylaminophenyl group, 2,2,2-trifluoroethoxyphenyl group, (2-methoxyethoxy)phenyl group, hydroxynaphthyl group, dihydroxynaphthyl group, 2,2,2-trifluoroethoxynaphthyl group, and (2-methoxyethoxy)naphthyl group, wherein these groups optionally have a substituent at a given position; and the like.

R⁰⁴ and R⁰⁵ preferably represent an unsubstituted phenyl group, or a phenyl group having a substituent selected from a group consisting of a halogen atom, an alkyl group, and an alkoxy group at a para position of an iodine atom. Particularly, a phenyl group, a 4-tert-butylphenyl group, a 4-fluorophenyl group and the like are preferable.

When R⁰⁴ and R⁰⁵ are bonded to each other directly or via an oxygen atom, a methylene group, a sulfone group, or a carbonyl group, examples of a partial structure include, but are not limited to, those illustrated below. Note that in the following formulae, there may be a substituent at a given position on an aromatic ring.

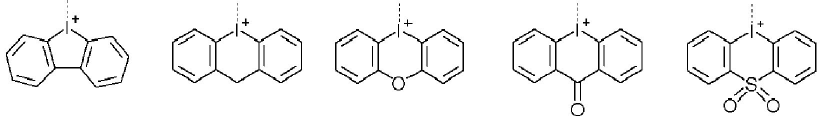

More specifically, the iodonium cation includes, but is not limited to, those described below. Note that in the following formulae, tBu represents a tert-butyl group and Ph represents a phenyl group.

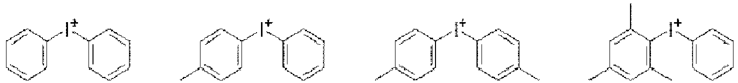

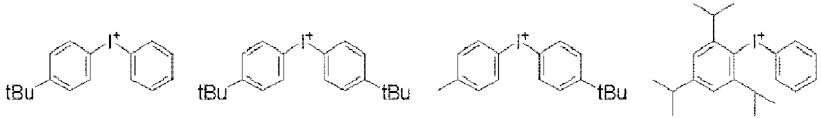

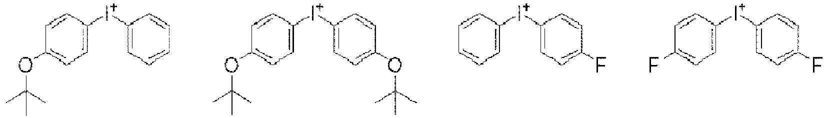

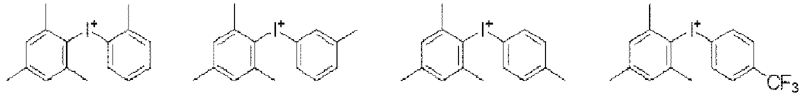

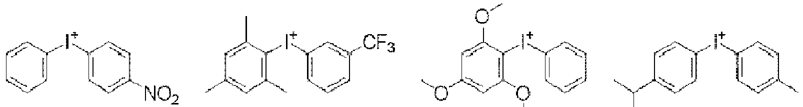

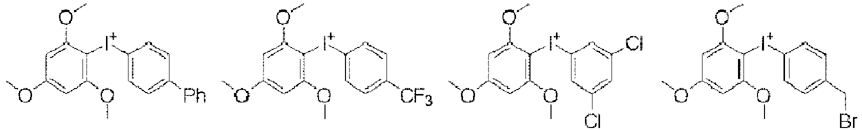

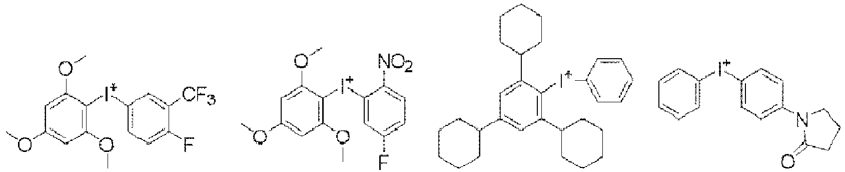

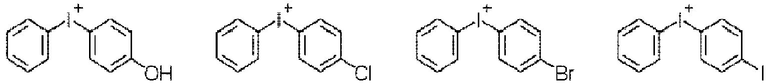

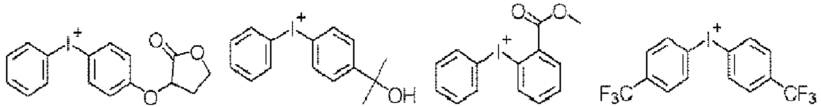

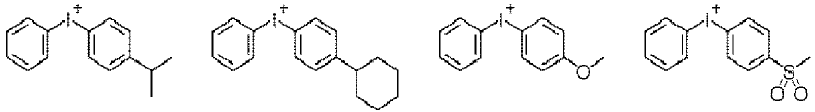

An ammonium cation represented by the general formula (4) includes: an ammonium cation having a protonated nitrogen atom of ammonia, primary, secondary, or tertiary aliphatic amines, mixed amines, aromatic amines, heterocyclic amines, a nitrogen-containing compound having a carboxy group, a nitrogen-containing compound having a sulfonyl group, a nitrogen-containing compound having a hydroxy group, a nitrogen-containing compound having a hydroxyphenyl group, an alcoholic nitrogen-containing compound, and the like; and a quaternary ammonium cation.

Specifically, examples of the primary aliphatic amines include methylammonium, ethylammonium, n-propylammonium, isopropylammonium, n-butylammonium, isobutylammonium, sec-butylammonium, tert-butylammonium, pentylammonium, tert-amylammonium, cyclopentylammonium, hexylammonium, cyclohexylammonium, heptylammonium, octylammonium, nonylammonium, decylammonium, dodecylammonium, cetylammonium, aminomethylammonium, 2-aminoethylammonium, and the like; examples of the secondary aliphatic amines include dimethylammonium, diethylammonium, di-n-propylammonium, diisopropylammonium, di-n-butylammonium, diisobutylammonium, di-sec-butylammonium, dipentylammonium, dicyclopentylammonium, dihexylammonium, dicyclohexylammonium, diheptylammonium, dioctylammonium, dinonylammonium, didecylammonium, didodecylammonium, dicetylammonium, methyl(methylamino)methylammonium, methyl-2-(methylamino)ethylammonium, and the like; and examples of the tertiary aliphatic amines include trimethylammonium, triethylammonium, tri-n-propylammonium, triisopropylammonium, tri-n-butylammonium, triisobutylammonium, tri-sec-butylammonium, tripentylammonium, tricyclopentylammonium, trihexylammonium, tricyclohexylammonium, triheptylammonium, trioctylammonium, trinonylammonium, tridecylammonium, tridodecylammonium, tricetylammonium, dimethyl(dimethylamino)methylammonium, dimethyl(2-dimethylaminoethyl)ammonium, and the like.

Furthermore, examples of the mixed amines include dimethylethylammonium, methylpropylammonium, benzylammonium, phenethylammonium, benzyldimethylammonium, and the like. Specific examples of the aromatic amines and the heterocyclic amines include anilinium derivatives (for example, anilinium, N-methylanilinium, N-ethylanilinium, N-propylanilinium, N,N-dimethylanilinium, 2-methylanilinium, 3-methylanilinium, 4-methylanilinium, ethylanilinium with any substitution position, propylanilinium with any substitution position, trimethylanilinium with any substitution position, 2-nitroanilinium, 3-nitroanilinium, 4-nitroanilinium, 2,4-dinitroanilinium, 2,6-dinitroanilinium, 3,5-dinitroanilinium, and N,N-dimethyltoluidinium with any substitution position), diphenyl(p-tolyl)ammonium, methyldiphenylammonium, triphenylammonium, aminophenylammonium with any substitution position, naphthylammonium, aminonaphthylammonium with any substitution position, pyrrolinium derivatives (for example, pyrrolinium, 2H-pyrrolinium, 1-methylpyrrolinium, 2,4-dimethylpyrrolinium, 2,5-dimethylpyrrolinium, N-methylpyrrolinium, and the like), oxazolium derivatives (for example, oxazolium, isoxazolium, and the like), thiazolium derivatives (for example, thiazolium, isothiazolium, and the like), imidazolium derivatives (for example, imidazolium, 4-methylimidazolium, 4-methyl-2-phenylimidazolium, and the like), pyrazolium derivatives, furazanium derivatives, 2-methyl-1-pyrrolinium, pyrrolidinium derivatives (for example, pyrrolidinium, N-methylpyrrolidinium, pyrrolidinonium, N-methylpyrrolidonium, and the like), imidazolinium derivatives, imidazolidinium derivatives, pyridinium derivatives (for example, pyridinium, methylpyridinium, ethylpyridinium, propylpyridinium, butylpyridinium, 4-(1-butylpentyl)pyridinium, dimethylpyridinium, trimethylpyridinium, triethylpyridinium, phenylpyridinium, 3-methyl-2-phenylpyridinium, 4-tert-butylpyridinium, diphenylpyridinium, benzylpyridinium, methoxypyridinium, butoxypyridinium, dimethoxypyridinium, 4-pyrrolidinopyridinium, 2-(1-ethylpropyl)pyridinium, aminopyridinium, dimethylaminopyridinium, and the like), pyridazinium derivatives, pyrimidinium derivatives, pyrazinium derivatives, pyrazolinium derivatives, pyrazolidinium derivatives, piperidinium derivatives, piperazinium derivatives, morpholinium derivatives, indolinium derivatives, isoindolinium derivatives, 1H-indazolinium derivatives, quinolinium derivatives (for example, quinolinium), isoquinolinium derivatives, cinnolinium derivatives, quinazolinium derivatives, quinoxalinium derivatives, phthalazinium derivatives, purinium derivatives, pteridinium derivatives, carbazolium derivatives, phenanthridinium derivatives, acridinium derivatives, fenadinium derivatives, 1,10-phenanthrolinium derivatives, and the like.

Further, examples of the nitrogen-containing compound having a carboxy group include carboxyphenylammonium, carboxyindolinium, and amino acid derivatives (for example, protonated products of nicotinic acid, alanine, arginine, aspartic acid, glutamic acid, glycine, histidine, isoleucine, glycylleucine, leucine, methionine, phenylalanine, threonine, lysine, 3-aminopyradine-2-carboxylic acid, methoxyalanine, and the like). Examples of the nitrogen-containing compound having a sulfonyl group include 3-pyridiniumsulfonic acid and the like. Examples of the nitrogen-containing compound having a hydroxyl group, the nitrogen-containing compound having a hydroxyphenyl group, and the alcoholic nitrogen-containing compound include 2-hydroxypyridinium, hydroxyanilinium with any substitution position, hydroxy-methyl-anilinium with any substitution position, hydroxyquinolinium, dihydroxyquinolinium, 2-hydroxyethylammonium, bis(2-hydroxyethyl)ammonium, tris(2-hydroxyethyl)ammonium, ethylbis(2-hydroxyethyl)ammonium, diethyl(2-hydroxyethyl)ammonium, hydroxypropylammonium, bis(hydroxypropyl)ammonium, tris(hydroxypropyl)ammonium, 4-(2-hydroxyethyl)morpholinium, 2-(2-hydroxyethyl)pyridinium, 1-(2-hydroxyethyl)piperazinium, 1-[2-(2-hydroxyethoxy)ethyl]piperazinium, (2-hydroxyethyl)piperazinium, 1-(2-hydroxyethyl) pyrrolidinium, 1-(2-hydroxyethyl)-2-pyrrolidinonium, 2,3-dihydroxypropylpiperidinium, 2,3-dihydroxypropylpiperolidinium, 8-hydroxyjulolidinium, 3-hydroxyquinuclidinium, and the like.

Further, specific examples of a quaternary ammonium salt include tetramethylammonium, triethylmethylammonium, tetraethylammonium, tetrabutylammonium, tetraoctylammonium, didecyldimethylammonium, tridecylmethylammonium, hexadecyltrimethylammonium, stearyltrimethylammonium, benzyltrimethylammonium, benzyltriethylammonium, benzyltributylammonium, 2-hydroxyethyltrimethylammonium, and the like.

As the ammonium cation, a quaternary ammonium cation is preferable, and a tetramethylammonium cation, a tetraethylammonium cation, and a tetrabutylammonium cation are particularly preferable.

In this case, X- in the general formulae (2), (3), and (4) is more preferably a structure represented by any of the following general formulae (5), (6), and (7), or any of a chloride ion, a bromide ion, an iodide ion, a fluoride ion, a cyanide ion, a nitrate ion, and a nitrite ion,

R¹⁰-COO⁻ (5)

R¹¹-SO₃⁻ (6)

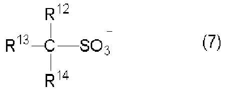

wherein R¹⁰ represents a linear, branched, or cyclic alkyl group or alkenyl group having 1 to 20 carbon atoms, an aralkyl group having 7 to 20 carbon atoms, or an aryl group having 6 to 20 carbon atoms, and optionally containing an ether group, an ester group, and a carbonyl group, wherein one or more hydrogen atoms of these groups are optionally substituted with a halogen atom, a hydroxyl group, a carboxyl group, an amino group, or a cyano group; R¹¹ represents an aryl group having 6 to 20 carbon atoms, wherein one or more hydrogen atoms of the aryl group are optionally substituted with a halogen atom, a hydroxyl group, a carboxyl group, an amino group, or a cyano group; each of R¹², R¹³, and R¹⁴ independently represents a hydrogen atom, a halogen atom other than a fluorine atom, a linear, branched, or cyclic alkyl group or alkenyl group having 1 to 20 carbon atoms, an aralkyl group having 7 to 20 carbon atoms, or an aryl group having 6 to 20 carbon atoms, and optionally containing an ether group, an ester group, and a carbonyl group, wherein one or more hydrogen atoms of these groups are optionally substituted with a halogen atom, a hydroxyl group, a carboxyl group, an amino group, or a cyano group, and two or more of R¹², R¹³, and R¹⁴ optionally bond together to form a ring.

Specific examples of a carboxylate anion represented by the general formula (5) include formate anion, acetate anion, propionate anion, butyrate anion, isobutyrate anion, valerate anion, isovalerate anion, pivalate anion, hexanoate anion, octanoate anion, cyclohexanecarboxylate anion, cyclohexylacetate anion, laurate anion, myristate anion, palmitate anion, stearate anion, phenylacetate anion, diphenylacetate anion, phenoxyacetate anion, mandelate anion, benzoylformate anion, cinnamate anion, dihydroxycinnamate anion, benzoate anion, methylbenzoate anion, salicylate anion, naphthalenecarboxylate anion, anthracenecarboxylate anion, anthraquinonecarboxylate anion, hydroxyacetate anion, pivalate anion, lactate anion, methoxyacetate anion, 2-(2-methoxyethoxy)acetate anion, 2-(2-(2-methoxyethoxy)ethoxy)acetate anion, diphenolate anion, monochloroacetate anion, dichloroacetate anion, trichloroacetate anion, trifluoroacetate anion, pentafluoropropionate anion, heptafluorobutyrate anion, 2-hydroxy-2,2-bis(trifluoromethyl)acetate anion, and the like. The examples thereof further include monoanions of dicarboxylic acids, such as succinic acid, tartaric acid, glutaric acid, pimelic acid, sebacic acid, phthalic acid, isophthalic acid, terephthalic acid, naphthalenedicarboxylic acid, cyclohexanedicarboxylic acid, and cyclohexenedicarboxylic acid.

Specific examples of an arenesulfonate anion represented by the general formula (6) include benzenesulfonate, 4-toluenesulfonate, 2-toluenesulfonate, xylenesulfonate with any substitution position, trimethylbenzenesulfonate, mesitylenesulfonate, 4-methoxybenzenesulfonate, 4-ethylbenzenesulfonate, 2,4,6-triisopropylbenzenesulfonate, 1-naphthalenesulfonate, 2-naphthalenesulfonate, anthraquinone-1-sulfonate, anthraquinone-2-sulfonate, 4-(4-methylbenzenesulfonyloxy)benzenesulfonate, 3,4-bis(4-methylbenzenesulfonyloxy)benzenesulfonate, 6-(4-methylbenzenesulfonyloxy)naphthalene-2-sulfonate, 4-phenyloxybenzenesulfonate, 4-diphenylmethylbenzenesulfonate, 2,4-dinitrobenzenesulfonate, dodecylbenzenesulfonate, and the like.

Specific examples of an alkanesulfonate anion represented by the general formula (7) include methanesulfonate, ethanesulfonate, propanesulfonate, butanesulfonate, pentanesulfonate, hexanesulfonate, cyclohexanesulfonate, octanesulfonate, 10-camphorsulfonate, and the like.

Further, a conjugate acid X-H of X- in the general formulae (2), (3), and (4) more preferably has a boiling point of 200°C or lower. Note that in the present description, the boiling point refers to a value at a pressure of 1 atmosphere (1013 hPa).

X⁻ in the general formulae (2), (3), and (4) is particularly preferably a trifluoroacetate anion, a pentafluoropropionate anion, a 2-hydroxy-2,2-bis(trifluoromethyl)acetate anion, a chloride ion, or a nitride ion.

(B) the base generator includes, but is not limited to, any combination of the specific examples of the cation and the specific examples of the anion as described above. Additionally, a preferable structure thereof includes the following ones. Note that in the following formulae, tBu represents a tert-butyl group.

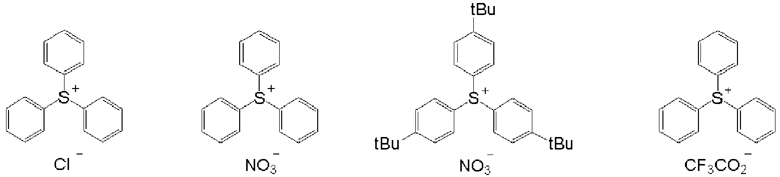

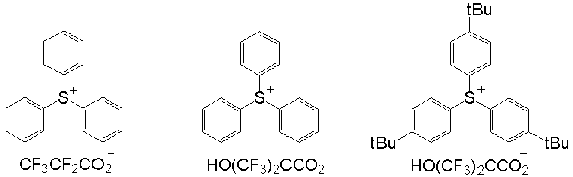

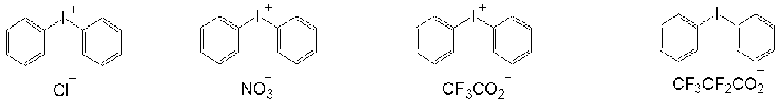

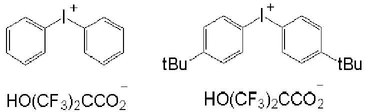

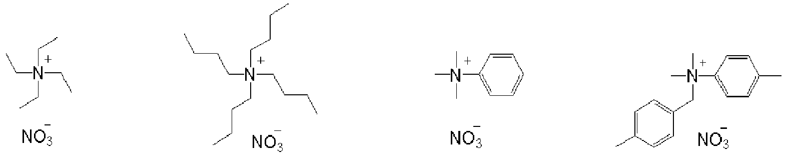

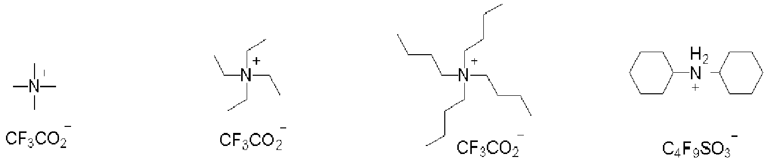

(B) the base generator can be used alone or in combination of two or more kinds thereof, such that it can exhibit basicity according to the baking temperature of the composition for forming a resist underlayer film, allowing to adjust the balance between the film formability and the planarization property for a hydrophobic substrate as appropriate. The addition amount of (B) the base generator is preferably 0.1 to 10 parts by mass and more preferably 0.3 to 5 parts by mass relative to 100 parts by mass of (A) the resin. The addition amount of (B) the base generator within these ranges can impart a sufficient effect of improving the film formability, causing no problem of deterioration in in-plane uniformity of the film due to decomposition and sublimation or decrease in a curing property of the compound or the resin due to the basicity.

As (B) the base generator used for the composition for forming a resist underlayer film according to the present invention, those represented by the above general formulae (2) and (4) are more preferable, and the one represented by the above general formula (2) is particularly preferable.

### (C) Organic Solvent

(C) the organic solvent usable for the composition for forming a resist underlayer film according to the present invention is not particularly limited as long as it can dissolve or disperse (A) the resin and (B) the base generator, and is preferably the one that can also dissolve or disperse (D) a crosslinking agent, (E) a flowability accelerator, (F) a surfactant, and (G) a plasticizer as described later.

Specifically, the organic solvents described in paragraphs [0091] to [0092] of JP 2007-199653 A can be added. More specifically, propylene glycol monomethyl ether acetate, propylene glycol monomethyl ether, propylene glycol monoethyl ether, propylene glycol monopropyl ether, 2-heptanone, cyclopentanone, cyclohexanone, γ-butyrolactone, or a mixture containing one or more kinds thereof are preferably used.

While a blending amount of the organic solvent is preferably adjusted according to set film thickness of the resist underlayer film, it is generally preferable that the amount falls within the range of 100 to 50,000 parts by mass relative to 100 parts by mass of (A) the resin. To form the thick resist underlayer film, it is in the range of more preferably 100 to 400 parts by mass, further preferably 100 to 300 parts by mass, particularly preferably 100 to 250 parts by mass, and the most preferably 100 to 200 parts by mass. By blending such amount of the organic solvent, it is possible to form the thicker resist underlayer film, thereby allowing more suitable use of the composition for forming a resist underlayer film according to the present invention having the excellent filling property and adhesiveness to the substrate.

### (D) Crosslinking Agent

(D) a crosslinking agent can also be added to the composition for forming a resist underlayer film according to the present invention. The crosslinking agent for use is not particularly limited, and various known types of crosslinking agents can widely be used. One example thereof includes: polynuclear phenolic methylol-based or alkoxymethyl-based crosslinking agent (polynuclear phenol-based crosslinking agent), melamine-based crosslinking agent, glycoluril-based crosslinking agent, benzoguanamine-based crosslinking agent, urea-based crosslinking agent, β-hydroxyalkylamide-based crosslinking agent, isocyanurate-based crosslinking agent, aziridine-based crosslinking agent, oxazoline-based crosslinking agent, and epoxy-based crosslinking agent. Among them, the polynuclear phenol-based crosslinking agent is particularly preferable. An addition amount of the crosslinking agent (if added) is preferably 1 to 50 parts by mass and more preferably 5 to 30 parts by mass relative to 100 parts by mass of (A) the resin.

It is preferable that the composition for forming a resist underlayer film according to the present invention contains (D) the crosslinking agent as described above, because this can enhance a thermosetting property of (A) the resin and can be effective in eliminating occurrence of voids caused by a residual solvent in the resin, which becomes a problem when filling a high aspect pattern, thereby enhancing the filling property. Particularly, the polynuclear phenol-based crosslinking agent is preferable because it acts with (B) the base generator contained in the composition for forming a resist underlayer film according to the present invention, thereby further contributing to improving the adhesiveness.

Specific examples of the melamine-based crosslinking agent include hexamethoxymethylated melamine, hexabutoxymethylated melamine, alkoxy- and/or hydroxy-substituted derivatives thereof, and partial self-condensates thereof.

Specific examples of the glycoluril-based crosslinking agent include tetramethoxymethylated glycoluril, tetrabutoxymethylated glycoluril, alkoxy- and/or hydroxy-substituted derivatives thereof, and partial self-condensates thereof.

Specific examples of the benzoguanamine-based crosslinking agent include tetramethoxymethylated benzoguanamine, tetrabutoxymethylated benzoguanamine, alkoxy- and/or hydroxy-substituted derivatives thereof, and partial self-condensates thereof.

Specific examples of the urea-based crosslinking agent include dimethoxymethylated dimethoxyethyleneurea, alkoxy- and/or hydroxy-substituted derivatives thereof, and partial self-condensates thereof.

Specific examples of the β-hydroxyalkylamide-based crosslinking agent include N,N,N',N'-tetra(2-hydroxyethyl)adipic acid amide.

Specific examples of the isocyanurate-based crosslinking agent include triglycidyl isocyanurate and triallyl isocyanurate.

Specific examples of the aziridine-based crosslinking agent include 4,4'-bis(ethyleneiminocarbonylamino)diphenylmethane and 2,2-bishydroxymethylbutanol-tris[3-(1-aziridinyl)propionate].

Specific examples of the oxazoline-based crosslinking agent include 2,2'-isopropylidene bis(4-benzyl-2-oxazoline), 2,2'-isopropylidene bis(4-phenyl-2-oxazoline), 2,2'-methylenebis-4,5-diphenyl-2-oxazoline, 2,2'-methylenebis-4-phenyl-2-oxazoline, 2,2'-methylenebis-4-tertbutyl-2-oxazoline, 2,2'-bis(2-oxazoline), 1,3-phenylenebis(2-oxazoline), 1,4-phenylenebis(2-oxazoline), and 2-isopropenyloxazoline copolymer.

Specific examples of the epoxy-based crosslinking agent include diglycidyl ether, ethylene glycol diglycidyl ether, 1,4-butanediol diglycidyl ether, 1,4-cyclohexanedimethanol diglycidyl ether, poly(glycidyl methacrylate), trimethylolethane triglycidyl ether, trimethylolpropane triglycidyl ether, and pentaerythritol tetraglycidyl ether.

Specific examples of the polynuclear phenol-based crosslinking agent include a compound represented by the following general formula (XL-1), 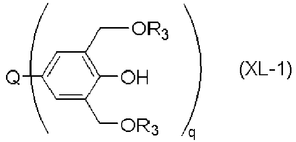 wherein Q represents a single bond or a q-valent hydrocarbon group having 1 to 20 carbon atoms; R₃ represents a hydrogen atom or an alkyl group having 1 to 20 carbon atoms; and "q" represents an integer of 1 to 5.

Q represents a single bond or a q-valent hydrocarbon group having 1 to 20 carbon atoms. "q" represents an integer of 1 to 5, and more preferably 2 or 3. Specific examples of Q include groups obtained by removing "q" hydrogen atoms from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane. R₃ represents a hydrogen atom or an alkyl group having 1 to 20 carbon atoms. Specific examples of the alkyl group having 1 to 20 carbon atoms include methyl group, ethyl group, propyl group, isopropyl group, butyl group, isobutyl group, pentyl group, isopentyl group, hexyl group, octyl group, ethylhexyl group, decyl group, and eicosanyl group. Among them, a hydrogen atom or a methyl group is preferable.

Specific examples of the compound represented by the above general formula (XL-1) include the following compounds. Among them, hexamethoxymethylated forms of triphenolmethane, triphenolethane, 1,1,1-tris(4-hydroxyphenyl)ethane, and tris(4-hydroxyphenyl)-1-ethyl-4-isopropylbenzene are preferable from the viewpoint of enhancing a curing property and film thickness uniformity of an organic film. R₃ is the same as the above.

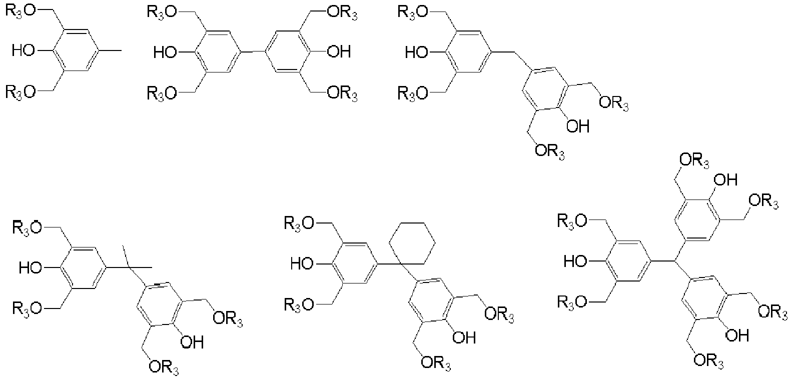

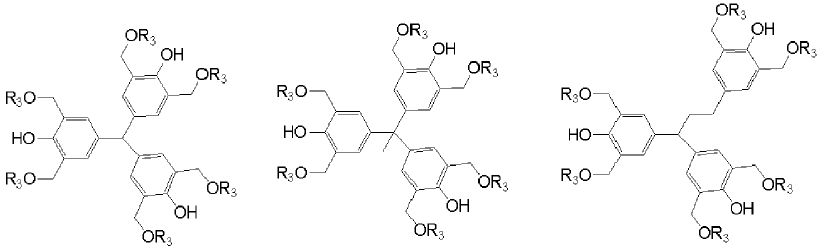

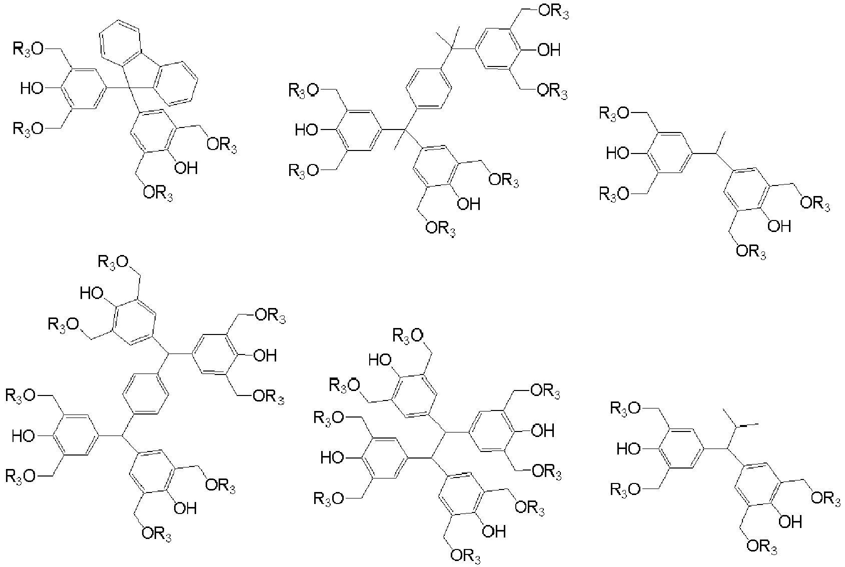

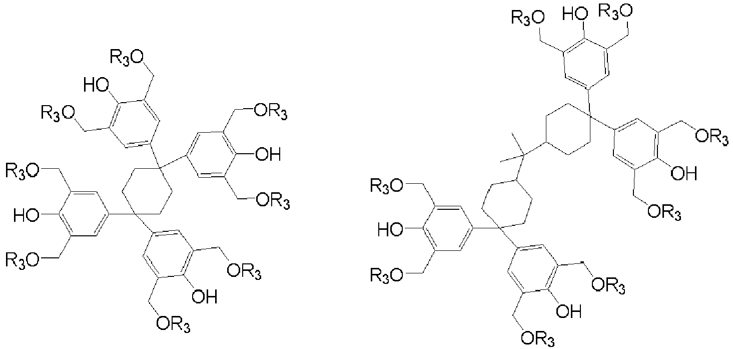

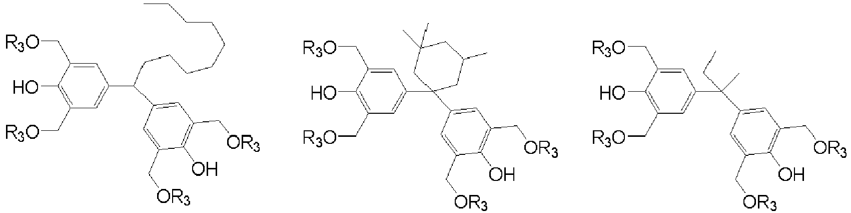

### (E) Flowability Accelerator

The composition for forming a resist underlayer film according to the present invention can further contain (E) a flowability accelerator, wherein a weight loss rate between 30°C to 190°C is less than 30% and the weight loss rate between 30°C to 350°C is 98% or greater.

(E) the flowability accelerator with the weight loss rate between 30°C to 190°C of less than 30% and the weight loss rate between 30°C to 350°C of 98% or greater is preferable because it sufficiently maintains low viscosity resulting from suppressed evaporation during heat treatment, has excellent thermal flowability, and remains in a small amount in the resist underlayer film after baking. In the present description, the weight loss rate is based on a value obtained by TG (thermogravimetric) measurement using differential thermo-gravimetry.

An upper limit of a temperature range where the weight loss rate of (E) the flowability accelerator is less than 30% is more preferably 210°C and further preferably 230°C. By setting the above temperature range as the temperature range where the weight loss rate of the flowability accelerator is less than 30%, it is possible to further enhance the filling/planarization properties.

An upper limit of a temperature range where the weight loss rate of (E) the flowability accelerator is 98% or greater is more preferably 330°C and particularly preferably 310°C. By setting the above temperature range as the temperature range where the weight loss rate of the flowability accelerator is 98% or greater, it is possible to further reduce the residual flowability accelerator in the resist underlayer film after baking.

By adding (E) the flowability accelerator as described above, the thermal flowability of the composition for forming a resist underlayer film from the start of the heat treatment till the curing by a crosslinking reaction is enhanced, thereby demonstrating the excellent filling/planarization properties. On the other hand, an amount of (E) the flowability accelerator decreases as a result of evaporation or the like by heat treatment, so that the etching resistance and the optical properties are not impaired.

Further preferable aspect of (E) the flowability accelerator includes one or more compounds selected from the following general formulae (i) to (iii), 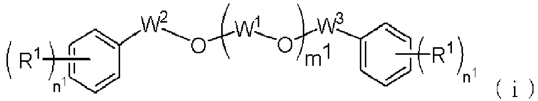
wherein each R¹ independently represents a hydrogen atom, a hydroxyl group, or an optionally substituted organic group having 1 to 10 carbon atoms; W¹ represents a phenylene group or a divalent group represented by the following general formula (i-1); W² and W³ represent a single bond or a divalent group represented by any of the following general formulae (i-2); "m¹" represents an integer of 1 to 10; and "n¹" represents an integer of 0 to 5; 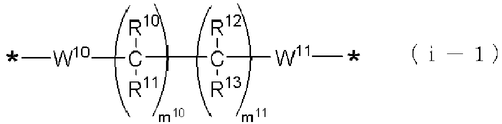
wherein * represents a bonding position; R¹⁰, R¹¹, R¹², and R¹³ represent a hydrogen atom, a hydroxyl group, or an organic group having 1 to 10 carbon atoms; each of W¹⁰ and W¹¹ independently represents a single bond or a carbonyl group; and "m¹⁰" and "m¹¹" represent an integer of 0 to 10 satisfying a relation of m¹⁰+m¹¹≥1; 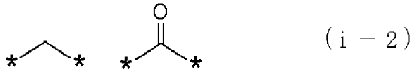
wherein * represents a bonding position; 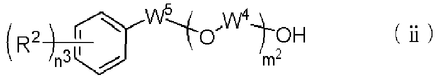
wherein each R² independently represents a hydrogen atom or an optionally substituted organic group having 1 to 10 carbon atoms; W⁴ represents a divalent group represented by the following general formula (ii-1); W⁵ represents a single bond or a divalent group represented by any of the following general formulae (ii-2); "m²" represents an integer of 2 to 10; and "n³" represents an integer of 0 to 5; 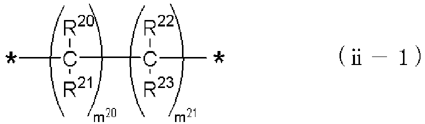
wherein * represents a bonding position; R²⁰, R²¹, R²², and R²³ represent a hydrogen atom, a hydroxyl group, or an organic group having 1 to 10 carbon atoms; and "m²⁰" and "m²¹" represent an integer of 0 to 10 satisfying a relation of m²⁰+m²¹≥1; 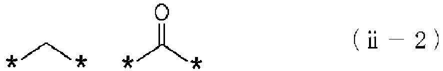
wherein * represents a bonding position; 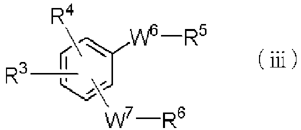
wherein R³ and R⁴ represent a hydrogen atom, a hydroxyl group, or an optionally substituted organic group having 1 to 10 carbon atoms, and optionally bond together to form a cyclic structure; R⁵ and R⁶ represent an organic group having 1 to 10 carbon atoms, wherein R⁵ represents a group containing either an aromatic ring or a divalent group represented by the following general formula (iii-1); and W⁶ and W⁷ represent a single bond or a divalent group represented by any of the following general formulae (iii-2), wherein at least one of W⁶ and W⁷ represents the divalent group represented by (iii-2); 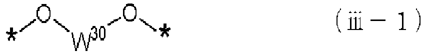
wherein * represents a bonding position; and W³⁰ represents an organic group having 1 to 4 carbon atoms; 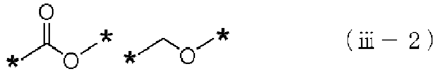
wherein * represents a bonding position.

In the above general formula (i), each R¹ independently represents a hydrogen atom, a hydroxyl group, or an optionally substituted organic group having 1 to 10 carbon atoms.

Here, the "organic group" of the present invention means a group containing at least one carbon atom, which further contains a hydrogen atom and optionally contains a nitrogen atom, an oxygen atom, a sulfur atom, a silicon atom, a halogen atom, and the like.

R¹ may be of a single kind or a mixture of a plurality of kinds. More specifically, examples of R¹ include hydrogen atom, hydroxyl group, methyl group, ethyl group, vinyl group, 2,2,2-trifluoroethyl group, propyl group, isopropyl group, allyl group, butyl group, s-butyl group, t-butyl group, isobutyl group, pentyl group, cyclopentyl group, hexyl group, cyclohexyl group, cyclohexenyl group, decyl group, methoxy group, ethoxy group, propoxy group, isopropoxy group, butoxy group, s-butoxy group, t-butoxy group, norbornyl group, adamantyl group, phenyl group, tolyl group, xylyl group, naphthyl group, benzyl group, 2-furanyl group, and 2-tetrahydrofuranyl group. Among them, a hydrogen atom is more preferable.

W¹ represents a phenylene group or the divalent group represented by the above general formula (i-1). W² and W³ represent a single bond or a divalent group represented by any of the above general formulae (i-2). "m¹" represents an integer of 1 to 10 and each "n¹" independently represents an integer of 0 to 5.

More specifically, R¹⁰, R¹¹, R¹², and R¹³ represent a hydrogen atom, a hydroxyl group, or an organic group having 1 to 10 carbon atoms. More specifically, examples thereof include hydrogen atom, hydroxyl group, methyl group, ethyl group, vinyl group, 2,2,2-trifluoroethyl group, propyl group, isopropyl group, allyl group, butyl group, s-butyl group, t-butyl group, isobutyl group, pentyl group, cyclopentyl group, hexyl group, cyclohexyl group, cyclohexenyl group, decyl group, methoxy group, ethoxy group, propoxy group, isopropoxy group, butoxy group, s-butoxy group, t-butoxy group, norbornyl group, adamantyl group, phenyl group, tolyl group, xylyl group, naphthyl group, benzyl group, 2-furanyl group, and 2-tetrahydrofuranyl group. Among them, a hydrogen atom and a methyl group are more preferable, and a hydrogen atom is even more preferable.

Each of W¹⁰ and W¹¹ independently represents a single bond or a carbonyl group. "m¹⁰" and "m¹¹" represent an integer of 0 to 10 satisfying a relation of m¹⁰+m¹¹≥1.

In the above general formula (ii), each R² independently represents a hydrogen atom or an optionally substituted organic group having 1 to 10 carbon atoms.

R² may be of a single kind or a mixture of a plurality of kinds. More specifically, examples of R² include hydrogen atom, methyl group, ethyl group, vinyl group, 2,2,2-trifluoroethyl group, propyl group, isopropyl group, allyl group, butyl group, s-butyl group, t-butyl group, isobutyl group, pentyl group, cyclopentyl group, hexyl group, cyclohexyl group, cyclohexenyl group, decyl group, methoxy group, ethoxy group, propoxy group, isopropoxy group, butoxy group, s-butoxy group, t-butoxy group, norbornyl group, adamantyl group, phenyl group, tolyl group, xylyl group, naphthyl group, benzyl group, 2-furanyl group, and 2-tetrahydrofuranyl group. Among them, a hydrogen atom is more preferable.

W⁴ represents the divalent group represented by the above general formula (ii-1). W⁵ represents a single bond or a divalent group represented by any of the above general formulae (ii-2). "m²" represents an integer of 2 to 10 and "n³" represents an integer of 0 to 5.

More specifically, examples of R²⁰, R²¹, R²², and R²³ include hydrogen atom, hydroxyl group, methyl group, ethyl group, vinyl group, 2,2,2-trifluoroethyl group, propyl group, isopropyl group, allyl group, butyl group, s-butyl group, t-butyl group, isobutyl group, pentyl group, cyclopentyl group, hexyl group, cyclohexyl group, cyclohexenyl group, decyl group, methoxy group, ethoxy group, propoxy group, isopropoxy group, butoxy group, s-butoxy group, t-butoxy group, norbornyl group, adamantyl group, phenyl group, tolyl group, xylyl group, naphthyl group, benzyl group, 2-furanyl group, and 2-tetrahydrofuranyl group. Among them, a hydrogen atom and a methyl group are more preferable, and a hydrogen atom is even more preferable.

"m²⁰" and "m²¹" represent an integer of 0 to 10 satisfying a relation of m²⁰+m²¹≥1.

In the above general formula (iii), R³ and R⁴ represent a hydrogen atom, a hydroxyl group, or an optionally substituted organic group having 1 to 10 carbon atoms, and optionally bond together to form a cyclic structure. More specifically, examples thereof include hydrogen atom, hydroxyl group, methyl group, ethyl group, vinyl group, 2,2,2-trifluoroethyl group, propyl group, isopropyl group, allyl group, butyl group, s-butyl group, t-butyl group, isobutyl group, pentyl group, cyclopentyl group, hexyl group, cyclohexyl group, cyclohexenyl group, decyl group, methoxy group, ethoxy group, propoxy group, isopropoxy group, butoxy group, s-butoxy group, t-butoxy group, norbornyl group, adamantyl group, phenyl group, tolyl group, xylyl group, naphthyl group, benzyl group, 2-furanyl group, and 2-tetrahydrofuranyl group. Among them, a hydrogen atom is more preferable.

R⁵ represents an organic group having 1 to 10 carbon atoms, which is a group containing either an aromatic ring or the divalent group represented by the above general formula (iii-1). R⁶ represents an organic group having 1 to 10 carbon atoms. Examples of the organic group having 1 to 10 carbon atoms include the groups listed above for R³ and R⁴.

W⁶ and W⁷ represent a single bond or the divalent group represented by any of the above general formulae (iii-2), wherein at least one of W⁶ and W⁷ represents the divalent group represented by the above general formulae (iii-2).

W³⁰ represents an organic group having 1 to 4 carbon atoms. More specifically, examples thereof include methylene group, ethylene group, propylene group, butylene group, trimethylene group, and tetramethylene group. Among them, an ethylene group is more preferable.

Specific examples of the compound represented by the above general formula (i) further include, but are not limited to, the following compounds.

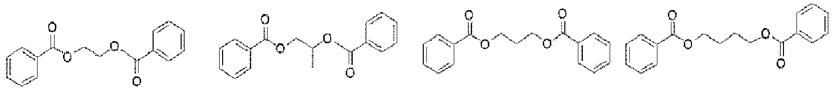

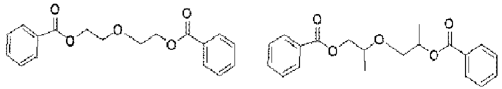

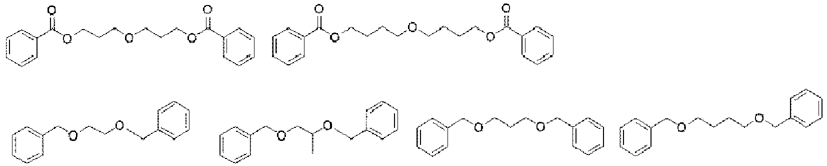

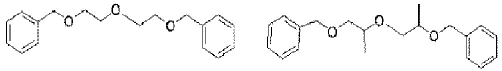

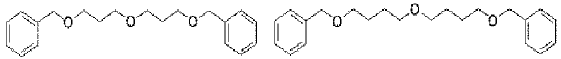

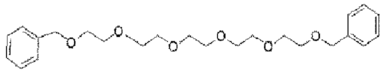

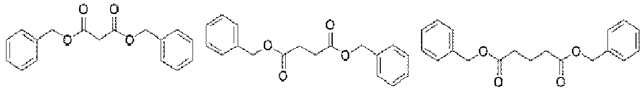

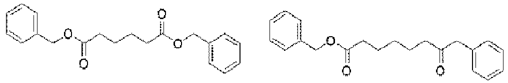

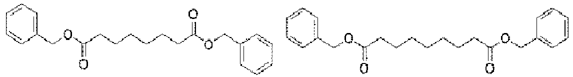

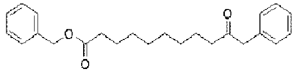

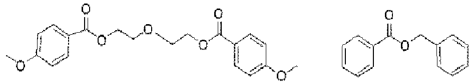

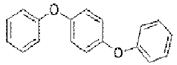

Specific examples of the compound represented by the above general formula (ii) further include, but are not limited to, the following compounds.

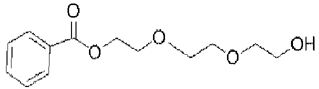

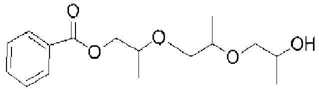

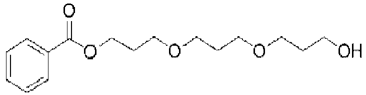

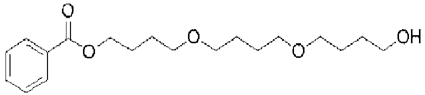

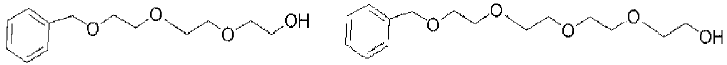

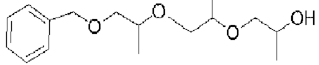

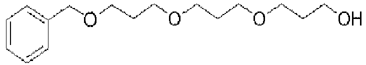

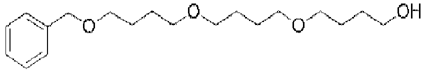

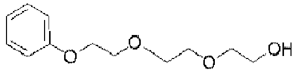

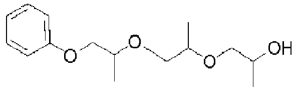

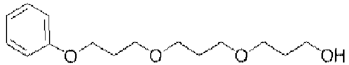

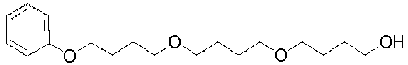

Specific examples of the compound represented by the above general formula (iii) further include, but are not limited to, the following compounds.

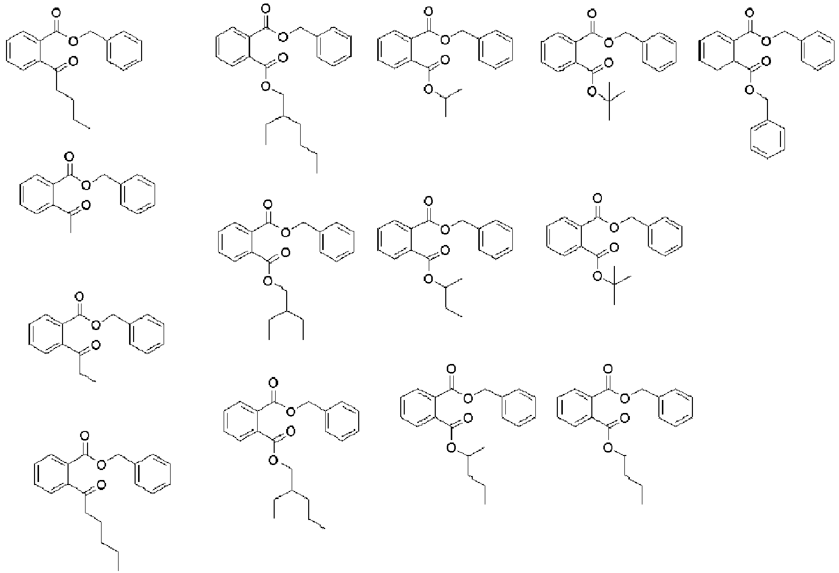

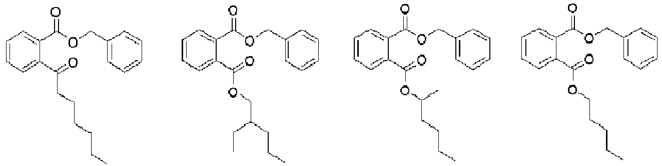

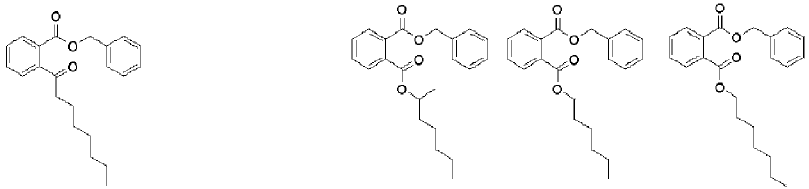

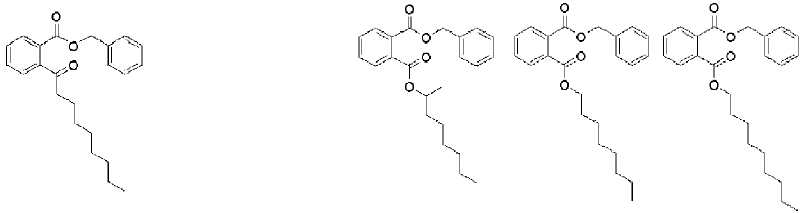

By comprehensively considering the film formability, capability of filling and planarizing the substrate, and the like of the composition for forming a resist underlayer film, (E) the flowability accelerator used for the composition for forming a resist underlayer film according to the present invention is preferably an aromatic-containing compound having a benzyl or a benzoyl group, and particularly preferably the following aromatic-containing compounds.
(i) (poly)ethylene glycol dibenzoate
(ii) (poly)ethylene glycol dibenzyl ether
(iii) (poly)propylene glycol dibenzyl ether
(iv) (poly)butylene glycol dibenzyl ether
(v) linear aliphatic dibenzyl dicarboxylate
(vi) (poly)ethylene glycol monobenzyl ether
(vii) (poly)phenyl ether

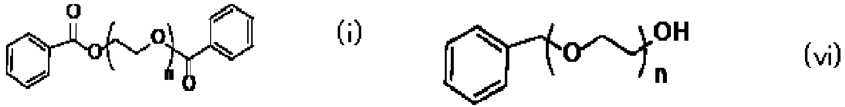

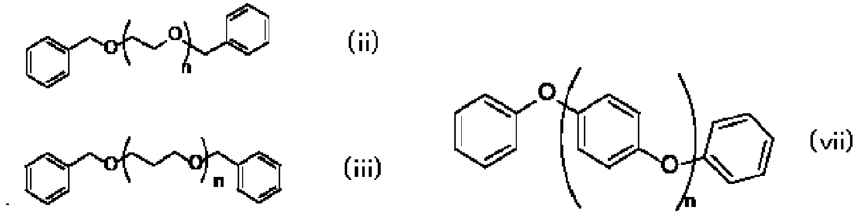

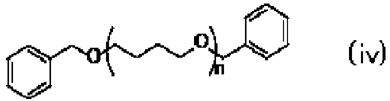

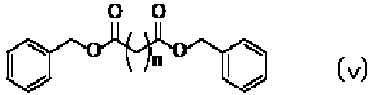

Note that "n" in the above formulae represents an integer with which the molecular weight falls within a range of 500 or less, and shall be applied only to this formula.

(E) the flowability accelerator used for the composition for forming a resist underlayer film according to the present invention preferably has a structure having both a hydrophobic part consisting of an aromatic ring and a hydrophilic part consisting of the below structure (E-1). Such (E) flowability accelerator has excellent compatibility with (A) the resin, (B) the base generator, (C) the organic solvent, and other additives, and can enhance the flowability of the composition without impairing the film formability and storage stability.

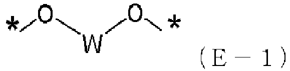

In the formula, * represents a bonding position; and W represents an organic group having 1 to 4 carbon atoms.

A blending amount of (E) the flowability accelerator is preferably 5 to 100 parts by mass and more preferably 10 to 50 parts by mass relative to 100 parts by mass of (A) the resin. If the blending amount of (E) the flowability accelerator relative to (A) the resin is 5 parts by mass or more, a sufficient effect of enhancing the thermal flowability of the resist underlayer film can be obtained. On the other hand, if the blending amount of (E) the flowability accelerator is 100 parts by mass or less, the obtained coating film has the excellent film formability and dry etching resistance.

(E) the flowability accelerator can be used alone or in combination of two or more kinds of the above aromatic-containing compounds.

Moreover, the composition for forming a resist underlayer film preferably further contains one or more of (F) a surfactant and (G) a plasticizer.

### (F) Surfactant

(F) the surfactant can be added to the composition for forming a resist underlayer film according to the present invention to enhance application performance by spin coating. For example, those described in paragraphs [0142] to [0147] of JP 2009-269953 A can be used as (F) the surfactant. An addition amount of (F) the surfactant (if added) is preferably 0.01 to 10 parts by mass and more preferably 0.05 to 5 parts by mass relative to 100 parts by mass of (A) the resin.

### (G) Plasticizer

(G) the plasticizer can also be added to the composition for forming a resist underlayer film according to the present invention to further enhance the planarization/filling properties. (G) the plasticizer is not particularly limited, and various known types of plasticizers can widely be used. One example thereof includes: a low molecular weight compound such as phthalate ester, adipate ester, phosphate ester, trimellitate ester, and citrate ester; and a polymer such as polyether-based polymer, polyester-based polymer, and polyacetal-based polymer described in JP 2013-253227 A. An addition amount of (G) the plasticizer (if added) is preferably 1 to 100 parts by mass and more preferably 5 to 30 parts by mass relative to 100 parts by mass of (A) the resin.

Moreover, as an additive for imparting the filling/planarization properties, such as a plasticizer, for example, a liquid additive having a polyethylene glycol or polypropylene glycol structure, or a thermally decomposable polymer having a weight loss rate between 30°C to 250°C of 40% by mass or greater and a weight average molecular weight of 300 to 200,000 is preferably used for the composition for forming a resist underlayer film according to the present invention. This thermally decomposable polymer preferably contains a repeating unit having an acetal structure represented by the following general formulae (DP1) and (DP1a). 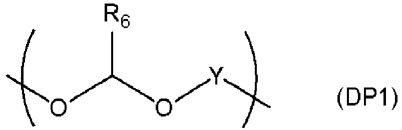 In the formula, R₆ represents a hydrogen atom or a saturated or unsaturated optionally substituted monovalent organic group having 1 to 30 carbon atoms; and Y represents a saturated or unsaturated divalent organic group having 2 to 30 carbon atoms. 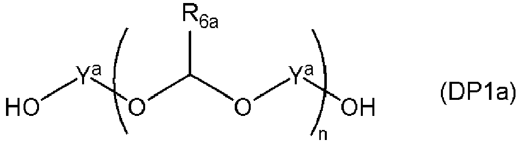 In the formula, R₆ₐ represents an alkyl group having 1 to 4 carbon atoms; Y^{a} represents a saturated or unsaturated divalent hydrocarbon group having 4 to 10 carbon atoms and optionally having an ether bond; and "n" represents an average repeating unit number of 3 to 500.

### Patterning Process Using Composition for Forming Resist Underlayer Film

The present invention further provides a patterning process with a two-resist process using the composition for forming a resist underlayer film, including the steps of:
(I-1) applying the composition for forming a resist underlayer film on a substrate to be processed and thereafter performing heat treatment to form a resist underlayer film;
(I-2) forming a resist upper layer film on the resist underlayer film using a photoresist material;
(I-3) forming a pattern in the resist upper layer film by developing the resist upper layer film using a developer after pattern exposure;
(I-4) transferring the pattern to the resist underlayer film by dry etching while using the resist upper layer film having the formed pattern as a mask; and
(I-5) processing the substrate to be processed while using the resist underlayer film having the formed pattern as a mask to form the pattern in the substrate to be processed.

The resist upper layer film in the two-layer resist process is preferably a photosensitive organic metal oxide film. Since the photosensitive organic metal oxide film has etching resistance to an oxygen-based gas, the dry etching of the resist underlayer film while using the resist upper layer film as a mask in the two-layer resist process is preferably performed by using an etching gas mainly composed of the oxygen-based gas.

The present invention further provides a patterning process with a three-layer resist process using such composition for forming a resist underlayer film, including the steps of:
(II-1) applying the composition for forming a resist underlayer film on a substrate to be processed and
thereafter performing heat treatment to form a resist underlayer film;
(II-2) forming a resist middle layer film on the resist underlayer film;
(II-3) forming a resist upper layer film on the resist middle layer film using a photoresist material;
(II-4) forming a pattern in the resist upper layer film by developing the resist upper layer film using a developer after pattern exposure;
(II-5) transferring the pattern to the resist middle layer film by dry etching while using the resist upper layer film having the formed pattern as a mask;
(II-6) transferring the pattern to the resist underlayer film by dry etching while using the resist middle layer film having the formed pattern as a mask; and
(II-7) processing the substrate to be processed while using the resist underlayer film having the formed pattern as a mask to form the pattern in the substrate to be processed.

The resist middle layer film in the three-layer resist process can be a silicon-containing resist middle layer film, which has etching resistance to an oxygen-based gas. Accordingly, in the three-layer resist process, the dry etching of the resist underlayer film while using the silicon-containing resist middle layer film as a mask is preferably performed by using an etching gas mainly composed of the oxygen-based gas.

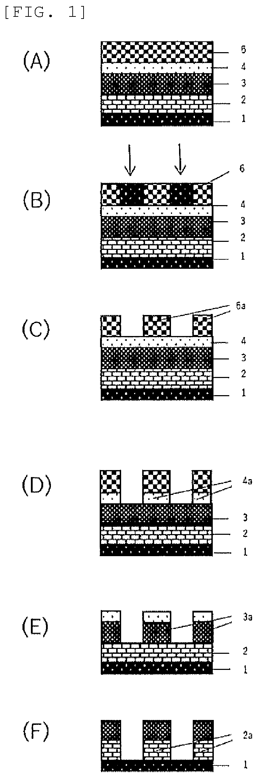

The patterning process with the three-layer resist process will be described with reference to FIG. 1. As a patterning process with the three-layer resist process using a method of forming such resist underlayer film, the present invention provides a patterning process including: forming a resist underlayer film 3 on a layer to be processed 2 which is on a substrate to be processed 1 using the composition for forming a resist underlayer film; forming a silicon-containing resist middle layer film 4 on the resist underlayer film using a silicon-containing resist middle layer film material; and forming a resist upper layer film 5 on the silicon-containing resist middle layer film using a photoresist material, as illustrated in FIG. 1(A). Then, the patterning process includes: subjecting an exposed portion 6 of the resist upper layer film to pattern exposure as illustrated in FIG. 1(B), followed by developing using a developer as illustrated in FIG. 1(C) to form a resist upper layer film pattern 5a in the resist upper layer film; transferring a silicon-containing resist middle layer film pattern 4a to the silicon-containing resist middle layer film by dry etching while using the resist upper layer film having the formed pattern as a mask as illustrated in FIG. 1(D); transferring a resist underlayer film pattern 3a to the resist underlayer film by dry etching while using the silicon-containing resist middle layer film having the formed pattern as a mask as illustrated in FIG. 1(E); and processing the layer to be processed on the substrate to be processed while using the resist underlayer film having the formed pattern as a mask to form a pattern 2a in the substrate to be processed 1 as illustrated in FIG. 1(F).

As the silicon-containing resist middle layer film in the three-layer resist process, a polysiloxane-based middle layer film is also preferably used. By providing the silicon-containing resist middle layer film with an antireflection effect, it is possible to suppress reflection. When a material containing many aromatic groups and having high etch selectivity to the substrate is used as the resist underlayer film especially for exposure at 193 nm, the k-value and thus the substrate reflection increase; whereas when the silicon-containing resist middle layer film absorbs to achieve an appropriate k-value, the reflection can be suppressed, thereby reducing the substrate reflection to 0.5% or less. Preferably used as the silicon-containing resist middle layer film having the antireflection effect is polysiloxane having a pendant anthracene for exposure at 248 nm or 157 nm, or a pendant phenyl group or a pendant light-absorbing group having a silicon-silicon bond for exposure at 193 nm, which is cross-linked by an acid or a heat.

Additionally, the present invention provides a patterning process with a four-layer resist process using such composition for forming a resist underlayer film, including the steps of:
forming a resist underlayer film on a substrate to be processed using the composition for forming a resist underlayer film;
forming a silicon-containing resist middle layer film on the resist underlayer film using a silicon-containing resist middle layer film material;
forming an organic antireflective film (BARC) or an adhesive film on the silicon-containing resist middle layer film;
forming a resist upper layer film on the BARC or the adhesive film using a photoresist material;
forming a pattern in the resist upper layer film by developing the resist upper layer film using a developer after pattern exposure;
transferring the pattern to the BARC or the adhesive film and the silicon-containing resist middle layer film by dry etching while using the resist upper layer film having the formed pattern as a mask;
transferring the pattern to the resist underlayer film by dry etching while using the silicon-containing resist middle layer film having the formed pattern as a mask; and
processing the substrate to be processed while using the resist underlayer film having the formed pattern as a mask to form the pattern in the substrate to be processed.

Furthermore, an inorganic hard mask middle layer film may be formed instead of the silicon-containing resist middle layer film. In this case, provided is a patterning process including the steps of:
(III-1) applying the composition for forming a resist underlayer film on a substrate to be processed and thereafter performing heat treatment to form a resist underlayer film;
(III-2) forming an inorganic hard mask middle layer film selected from a group consisting of a silicon oxide film,
a silicon nitride film, and a silicon oxynitride film on the resist underlayer film;
(III-3) forming an organic thin film on the inorganic hard mask middle layer film;
(III-4) forming a resist upper layer film on the organic thin film using a photoresist material;
(III-5) forming a pattern in the resist upper layer film by developing the resist upper layer film using a developer after pattern exposure;
(III-6) transferring the pattern to the organic thin film and the inorganic hard mask middle layer film by dry etching while using the resist upper layer film having the formed pattern as a mask;
(III-7) transferring the pattern to the resist underlayer film by dry etching while using the inorganic hard mask middle layer film having the formed pattern as a mask; and
(III-8) processing the substrate to be processed while using the resist underlayer film having the formed pattern as a mask to form the pattern in the substrate to be processed.
In this manner, a semiconductor device circuit pattern can be formed on a substrate.

As described above, in a case of forming the inorganic hard mask middle layer film on the resist underlayer film, a silicon oxide film, a silicon nitride film, and a silicon oxynitride film (SiON film) can be formed by a CVD method, an ALD method, or the like. For example, a method of forming a silicon nitride film is described in JP 2002-334869 A and WO 2004/066377 A1. Film thickness of the inorganic hard mask middle layer film is preferably 5 to 200 nm and more preferably 10 to 100 nm. Additionally, as the inorganic hard mask middle layer film, a SiON film which is highly effective as the antireflective film is most preferably used. Since a substrate temperature becomes 300 to 500°C during forming the SiON film, the resist underlayer film should withstand the temperature of 300 to 500°C. The composition for forming a resist underlayer film used in the present invention has high heat resistance and can withstand a high temperature of 300°C to 500°C, allowing a combination of the inorganic hard mask middle layer film formed by the CVD method or the ALD method and the resist underlayer film formed by the spin coat method.

As described above, a photoresist film may be formed on the inorganic hard mask middle layer film as the resist upper layer film, or the organic antireflective film (BARC) or the adhesive film may be formed on the inorganic hard mask middle layer film by spin coating and a photoresist film may be formed thereon. Particularly, when a SiON film is used as the inorganic hard mask middle layer film, the reflection can be suppressed by the two antireflective films, i.e. the SiON film and the BARC, even in high-NA immersion lithography exceeding 1.0. Another merit of forming the BARC is an effect of reducing footing in a photoresist pattern immediately above the SiON film.

In the above patterning process, the resist upper layer film may be either a positive or negative type, and the same one as a typically used photoresist composition can be used therefor. Additionally, the photoresist composition may contain metal atoms such as Sn, In, Ga, Ge, Al, Ce, La, Cs, Zr, Hf, Ti, Bi, Sb, and Zn. The spin coat method or deposition processing by the CVD method or the ALD method may be employed to form the resist upper layer film with the above photoresist composition.

When the photoresist composition is formed by the spin coat method, prebaking is performed after resist application, preferably at 60 to 180°C for 10 to 300 seconds. Thereafter, exposure is performed according to a usual manner, followed by post-exposure bake (PEB) and development, thereby obtaining a resist pattern. Note that thickness of the resist upper layer film is preferably 10 to 500 nm and particularly preferably 20 to 400 nm, but not particularly limited thereto.

When the photoresist composition is formed by deposition processing by the CVD method or the ALD method, the resist composition is preferably an EUV photosensitive metal oxide film, where the metal is selected from Sn, Zr, Hf, Ti, Bi, Sb, and the like. Among them, Sn with excellent EUV photosensitivity is preferable. The metal oxide-containing film may be a photosensitive organic metal oxide film such as an organotin oxide (for example, haloalkyl Sn, alkoxyalkyl Sn, or amidoalkyl Sn). Some specific examples of an appropriate precursor include trimethyltin chloride, dimethyltin dichloride, methyltin trichloride, tris(dimethylamino)methyltin(IV), and (dimethylamino)trimethyltin(IV).

The metal oxide film may be deposited by PECVD or PEALD using, for example, a Lam Vector (trademark) tool, and in an example using ALD, a Sn oxide precursor can be separated from an O precursor/plasma. A Deposition temperature is preferably in a range of 50°C to 600°C. A deposition pressure is preferably in a range of 100 to 6,000 mTorr. A flow rate of a precursor liquid of the metal oxide-containing film (for example, organotin oxide precursor) may be 0.01 to 10 cmm, and a gas flow rate (CO₂, CO, Ar, N₂) may be 100 to 10,000 sccm. Plasma power may be 200 to 1,000 W per 300 mm wafer station using RF plasma (for example, frequency at 13.56 MHz, 27.1 MHz or higher). Deposition thickness is preferably 100 to 2,000 Å.

Examples of exposure light include high-energy ray having a wavelength of 300 nm or less, specifically excimer laser with 248 nm, 193 nm, or 157 nm, soft X-ray with 3 to 20 nm, electron beam, X-ray, and the like.

The patterning process for the resist upper layer film is preferably a patterning process using photolithography with a wavelength of 5 nm or more and 300 nm or less, direct drawing using an electron beam, nanoimprinting, or a combination thereof.

Additionally, a development method in the patterning process is preferably alkaline development or development using an organic solvent.

Next, etching is performed using the resist pattern thus obtained as a mask. Etching of the silicon-containing resist middle layer film or the inorganic hard mask middle layer film in the three-layer resist process is performed using a fluorocarbon-based gas while using the upper layer resist pattern as the mask. In this manner, a silicon-containing resist middle layer film pattern or an inorganic hard mask middle layer film pattern are formed.

Next, etching processing is performed on the resist underlayer film while using the silicon-containing resist middle layer film pattern or the inorganic hard mask middle layer film pattern thus obtained as a mask. The etching processing of the resist underlayer film is preferably performed by using an etching gas mainly composed of an oxygen-based gas.

Subsequent etching of a workpiece can also be performed according to a usual manner, and when the workpiece is SiO₂, SiN, or a silica-based low dielectric constant insulating film, for example, etching can be performed with mainly a fluorocarbon-based gas. When the substrate is processed by etching with the fluorocarbon-based gas, the silicon-containing resist middle layer film pattern is stripped simultaneously with the substrate processing in the three-layer resist process.

The resist underlayer film obtained with the composition for forming a resist underlayer film according to the present invention is characterized by the excellent etching resistance during etching of these workpieces.

Note that the workpiece (substrate to be processed) is not particularly limited, and a substrate made of Si, α-Si, p-Si, SiO₂, SiN, SiON, W, TiN, Al, or the like, a substrate on which a layer to be processed is formed, etc. can be used. As the layer to be processed, various Low-k films such as those made of Si, SiO₂, SiON, SiN, p-Si, α-Si, W, W-Si, Al, Cu, Al-Si, or the like, and a stopper film thereof are used, which can generally be formed to have thickness of 50 to 10,000 nm and particularly thickness of 100 to 5,000 nm. Note that when depositing the layer to be processed, the substrate and the layer to be processed are made of different materials.

### Method of Forming Resist Underlayer Film

The present invention can provide a method of forming a resist underlayer film which serves as an organic film for filling used in a manufacturing process of a semiconductor device, the method including: spin coating the composition for forming a resist underlayer film as described above on a substrate to be processed; and performing heat treatment on the substrate to be processed, on which the composition for forming a resist underlayer film is applied, at a temperature of 100°C or higher and 600°C or lower for 10 to 600 seconds, thereby forming a cured film.

The present invention can also provide a method of forming a resist underlayer film which serves as an organic film for filling used in a manufacturing process of a semiconductor device, the method including: spin coating the composition for forming a resist underlayer film as described above on a substrate to be processed; and performing heat treatment on the substrate to be processed, on which the composition for forming a resist underlayer film is applied, under an atmosphere with an oxygen concentration of 1% or greater and 21% or less, thereby forming a cured film.

Alternatively, the present invention can provide a method of forming a resist underlayer film which serves as an organic film for filling used in a manufacturing process of a semiconductor device, the method including: spin coating the composition for forming a resist underlayer film as described above on a substrate to be processed; and performing heat treatment on the substrate to be processed, on which the composition for forming a resist underlayer film is applied, under an atmosphere with an oxygen concentration of less than 1%, thereby forming a cured film.

In the method of forming the resist underlayer film according to the present invention, the composition for forming a resist underlayer film is coated on the substrate to be processed using the spin coat method or the like. Using the spin coat method or the like can provide the favorable filling property. After the spin coating, baking is performed for evaporating the solvent and promoting a crosslinking reaction to prevent mixing with the resist upper layer film or the silicon-containing resist middle layer film. The baking is performed within a temperature range of preferably 100°C or higher and 600°C or lower, more preferably 100°C or higher and 400°C or lower, and further preferably 150°C or higher and 350°C or lower, for preferably 10 to 600 seconds and more preferably 10 to 300 seconds. By adjusting the baking temperature and time within the above ranges as appropriate, the planarization/filling properties and the curing property suitable for the purpose can be obtained. The baking temperature of 100°C or higher is preferable because it allows the curing to proceed sufficiently and causes no mixing with the resist upper layer film or the silicon-containing resist middle layer film. The baking temperature of 600°C or higher is preferable because it can inhibit pyrolysis of the base resin and achieve a uniform film surface without decreasing the film thickness.

The resist underlayer film has thickness of preferably at least 2 pm, more preferably at least 3 pm, and further preferably at least 5 µm.

Such resist underlayer film is preferable because it can further enhance the filling property so as to be advantageous to filling a high aspect pattern, and demonstrate excellent transfer performance when transferring a pattern to the substrate to be processed.

Furthermore, in the patterning process according to the present invention, the resist underlayer film is preferably formed by the spin coat method, and the resist underlayer film is coated to have thickness of preferably at least 2 µm, more preferably at least 3 µm, and further preferably at least 5 um by applying, one time, the composition for forming a resist underlayer film according to the present invention.

Such patterning process is preferable from the viewpoint of productivity of a device because it can form the thick resist underlayer film by applying the composition once.

The atmosphere during the baking can be selected from any of an oxygen-containing atmosphere (oxygen concentration of 1% to 210) such as being in the air, and a non-oxygen atmosphere such as being in nitrogen, as necessary. For example, when the substrate to be processed is easily oxidized with air, substrate damage can be reduced by performing heat treatment under an atmosphere with an oxygen concentration of 1% or less to form a cured film.

Furthermore, the patterning process according to the present invention preferably uses a substrate including a structure with an aspect ratio of 5 or higher or having steps as the substrate to be processed. The patterning process according to the present invention is especially useful in forming a resist underlayer film with no voids on a substrate including a structure with an aspect ratio of 5 or higher, particularly an aspect ratio of 10 or higher, or having steps.

### EXAMPLE

Hereinafter, the present invention will be specifically described with reference to Examples and Comparative Examples. However, the present invention is not limited thereto. Incidentally, a molecular weight and dispersity were measured by the following method. The weight average molecular weight (Mw) in terms of polystyrene and the dispersity (Mw/Mn) were determined by gel permeation chromatography (GPC) using tetrahydrofuran as an eluent.

Resins (X-1) to (X-12) for the composition for forming a resist underlayer film and resins (R-2), (R-3), (R-5), and (R-7) for Comparative Examples were synthesized by using resin raw materials (b-1) to (b-9) below to synthesize resins (A-1) to (A-8) as an intermediate, and using modifiers (c-1) to (c-3) to control a reaction rate. Note that the resin (A-1) was used for the resin (R-1) for Comparative Example, the resin (A-3) was used for the resin (R-4) for Comparative Example, and the resin (A-4) was used for the resin (R-6) for Comparative Example. Note that a 37% aqueous solution as a raw material was used as the resin raw material (b-8).

### Resin Raw Materials:

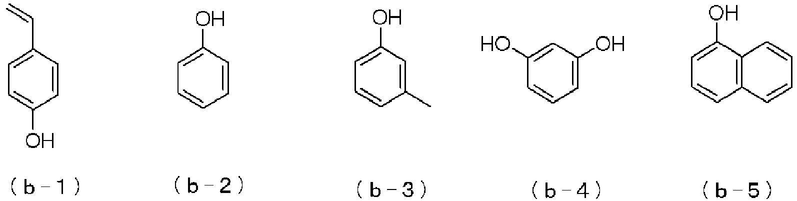

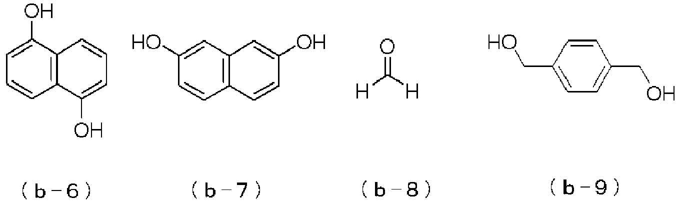

### Resins Used as Intermediate:

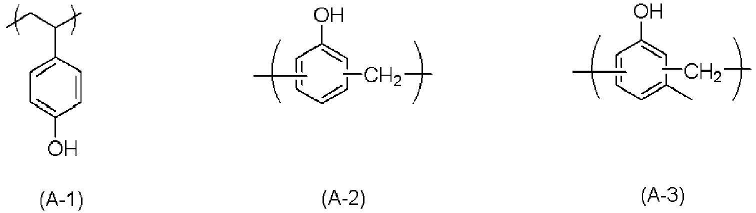

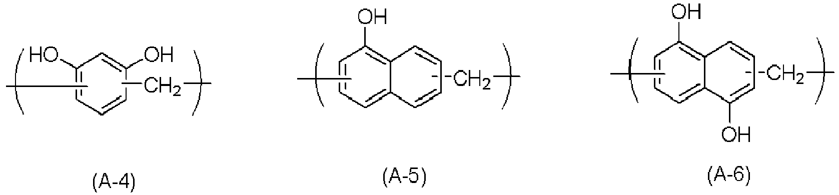

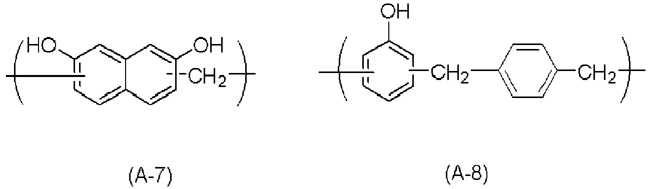

### Modifiers:

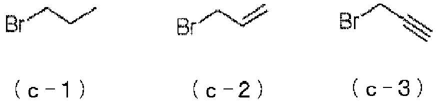

The above resins (A-1) to (A-8) were synthesized as follows.

### Synthesis of Resin (A-1)

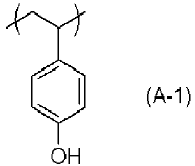

Under a nitrogen atmosphere, 100.0 g of the resin raw material (b-1), 3.85 g of V-601 (2,2'-azobis(isobutyrate)dimethyl, manufactured by Wako Pure Chemical Corporation), and 340 g of PGMEA (propylene glycol monomethyl ether acetate) were measured and introduced into a 1L graduated cylinder, followed by degasification while stirring to prepare a monomer-polymerization initiator solution. 60 g of PGMEA was measured and introduced into another 1L flask under a nitrogen atmosphere, followed by degasification while stirring, and then heated till an internal temperature reached 80°C. After the monomer-polymerization initiator solution was added dropwise over 4 hours, stirring was continued for 16 hours while maintaining the temperature of the polymerization solution at 80°C, and then cooled to a room temperature. The polymerization solution thus obtained was added dropwise to 5,000 g of vigorously stirred hexane, and precipitated polymers were separated by filtration. Further, the polymers thus obtained were washed twice with 600 g of hexane, and then dried under vacuum at 50°C for 20 hours to obtain the white powdered resin (A-1) .

The weight average molecular weight (Mw) and the dispersity (Mw/Mn) determined by GPC showed the below results.
(A-1): Mw=8,500, Mw/Mn=2.50

### Synthesis of Resin (A-2)

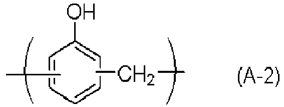

Under a nitrogen atmosphere, 188.2 g of the resin raw material (b-2), 81.3 g of the resin raw material (b-8), 9.0 g of oxalic acid, and 100 g of dioxane were added, and a reaction was carried out at an internal temperature of 100°C for 24 hours. After the reaction was completed, the resultant was cooled to a room temperature, 2,000 ml of MIBK was added thereto, and the resultant was washed 6 times with 500 ml of pure water. The organic layer was collected and at an internal temperature of 150°C, pressure was reduced to 2 mmHg to remove moisture, the solvent, and residual monomers under reduced pressure, thereby obtaining the resin (A-2) .

The weight average molecular weight (Mw) and the dispersity (Mw/Mn) determined by GPC showed the below results.
(A-2): Mw=2,500, Mw/Mn=2.87

### Synthesis of Resin (A-3)

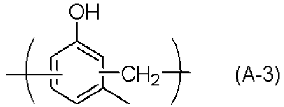

Under a nitrogen atmosphere, 216.3 g of the resin raw material (b-3), 81.3 g of the resin raw material (b-8), 10.8 g of oxalic acid, and 200 g of dioxane were added, and a reaction was carried out at an internal temperature of 100°C for 24 hours. After the reaction was completed, the resultant was cooled to a room temperature, 2,000 ml of MIBK was added thereto, and the resultant was washed 6 times with 500 ml of pure water. The organic layer was collected and at an internal temperature of 150°C, pressure was reduced to 2 mmHg to remove moisture, the solvent, and residual monomers under reduced pressure, thereby obtaining the resin (A-3) .

The weight average molecular weight (Mw) and the dispersity (Mw/Mn) determined by GPC showed the below results.
(A-3): Mw=3,300, Mw/Mn=3.50

### Synthesis of Resin (A-4)

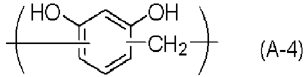

Under a nitrogen atmosphere, 144.2 g of the resin raw material (b-4), 53.2 g of the resin raw material (b-8), and 250 g of PGME (propylene glycol monomethyl ether) were added and homogenized at an internal temperature of 100°C. Thereafter, a previously homogenized mixed liquid of 3.0 g of paratoluenesulfonic acid monohydrate and 7.1 g of PGME was slowly added dropwise, and a reaction was carried out at an internal temperature of 120°C for 8 hours. After the reaction was completed, the resultant was cooled to a room temperature, 2,000 ml of MIBK was added thereto, and the resultant was washed 6 times with 500 ml of pure water. The organic layer was dried and solidified under reduced pressure to obtain the resin (A-4).

The weight average molecular weight (Mw) and the dispersity (Mw/Mn) determined by GPC showed the below results.
(A-4): Mw=2,900, Mw/Mn=2.26

### Synthesis of Resin (A-4')

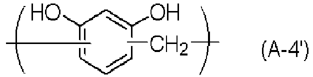

Under a nitrogen atmosphere, 144.2 g of the resin raw material (b-4), 95.8 g of the resin raw material (b-8), and 250 g of PGME (propylene glycol monomethyl ether) were added and homogenized at an internal temperature of 100°C. Thereafter, a previously homogenized mixed liquid of 3.0 g of paratoluenesulfonic acid monohydrate and 7.1 g of PGME was slowly added dropwise, and a reaction was carried out at an internal temperature of 120°C for 8 hours. After the reaction was completed, the resultant was cooled to a room temperature, 2,000 ml of MIBK was added thereto, and the resultant was washed 6 times with 500 ml of pure water. The organic layer was dried under reduced pressure to obtain the resin (A-4').

The weight average molecular weight (Mw) and the dispersity (Mw/Mn) determined by GPC showed the below results.
(A-4'): Mw=8,500, Mw/Mn=2.65

### Synthesis of Resin (A-5)

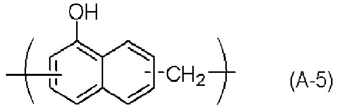

Under a nitrogen atmosphere, 144.2 g of the resin raw material (b-5), 40.6 g of the resin raw material (b-8), and 250 g of PGME (propylene glycol monomethyl ether) were added and homogenized at an internal temperature of 100°C. Thereafter, a previously homogenized mixed liquid of 3.0 g of paratoluenesulfonic acid monohydrate and 7.1 g of PGME was slowly added dropwise, and a reaction was carried out at an internal temperature of 120°C for 8 hours. After the reaction was completed, the resultant was cooled to a room temperature, 2,000 ml of MIBK was added thereto, and the resultant was washed 6 times with 500 ml of pure water. The organic layer was dried and solidified under reduced pressure to obtain the resin (A-5).

The weight average molecular weight (Mw) and the dispersity (Mw/Mn) determined by GPC showed the below results.
(A-5): Mw=3,300, Mw/Mn=2.26

### Synthesis of Resin (A-6)

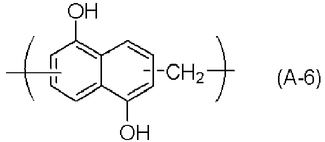

Under a nitrogen atmosphere, 160.2 g of the resin raw material (b-6), 40.6 g of the resin raw material (b-8), and 250 g of PGME (propylene glycol monomethyl ether) were added and homogenized at an internal temperature of 100°C. Thereafter, a previously homogenized mixed liquid of 3.2 g of paratoluenesulfonic acid monohydrate and 8.0 g of PGME was slowly added dropwise, and a reaction was carried out at an internal temperature of 120°C for 8 hours. After the reaction was completed, the resultant was cooled to a room temperature, 2,000 ml of MIBK was added thereto, and the resultant was washed 6 times with 500 ml of pure water. The organic layer was dried and solidified under reduced pressure to obtain the resin (A-6).

The weight average molecular weight (Mw) and the dispersity (Mw/Mn) determined by GPC showed the below results.
(A-6): Mw=3,400, Mw/Mn=2.54

### Synthesis of Resin (A-7)

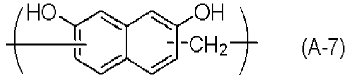

Under a nitrogen atmosphere, 160.2 g of the resin raw material (b-7), 40.6 g of the resin raw material (b-8), and 300 g of PGME (propylene glycol monomethyl ether) were added and homogenized at an internal temperature of 100°C. Thereafter, a previously homogenized mixed liquid of 3.2 g of paratoluenesulfonic acid monohydrate and 8.0 g of PGME was slowly added dropwise, and a reaction was carried out at an internal temperature of 120°C for 8 hours. After the reaction was completed, the resultant was cooled to a room temperature, 2,000 ml of MIBK was added thereto, and the resultant was washed 6 times with 500 ml of pure water. The organic layer was dried under reduced pressure to obtain the resin (A-7).

The weight average molecular weight (Mw) and the dispersity (Mw/Mn) determined by GPC showed the below results.
(A-7): Mw=3,300, Mw/Mn=2.41

### Synthesis of Resin (A-8)

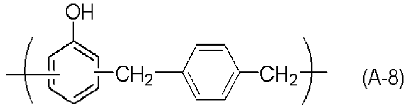

Under a nitrogen atmosphere, 94.1 g of the resin raw material (b-2), 89.8 g of the resin raw material (b-9), and 400 g of dichloromethane were added to prepare a homogeneous dispersion liquid at an internal temperature of 30°C. Thereafter, 211 g of methanesulfonic acid was added over 2 hours, and a reaction was carried out at an internal temperature of 30°C for 24 hours. After the reaction was completed, the resultant was cooled to a room temperature, 2,000 ml of MIBK was added thereto, and the resultant was washed 6 times with 500 ml of pure water. The organic layer was dried and solidified under reduced pressure. 300 g of THF was added to the residues to prepare a homogeneous solution, and then precipitation in 2,000 g of hexane was performed. The precipitated crystal was separated by filtration, washed twice with 500 g of hexane, and collected. The collected crystal was dried under vacuum at 70°C to obtain the resin (A-8).

The weight average molecular weight (Mw) and the dispersity (Mw/Mn) determined by GPC showed the below results.
(A-8): Mw=6,300, Mw/Mn=3.11

### Synthesis of Resins (X-1) to (X-12), and Resins (R-2), (R-3), (R-5), and (R-7) for Comparative Examples

### Synthesis Example 1: Synthesis of Resin (X-1)

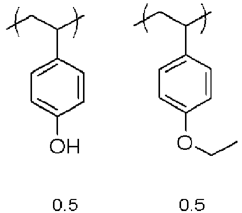

Under a nitrogen atmosphere, 20.0 g of the resin (A-1), 11.5 g of potassium carbonate, and 100 g of DMF were added to prepare a homogeneous dispersion liquid at an internal temperature of 50°C. 10.2 g of the modifier (c-1) was slowly added and a reaction was carried out at an internal temperature of 50°C for 24 hours. 300 ml of methylisobutyl ketone and 300 g of pure water were added to the reaction liquid to dissolve precipitated salts, and then a separated aqueous layer was removed. The organic layer thus obtained was added to 1500 g of hexane, and an upper layer was removed. After dissolving again with 300 ml of methylisobutyl ketone and washing 6 times with 100 g of a 3% nitric acid aqueous solution and 100 g of pure water, the organic layer was dried and solidified under reduced pressure to obtain the resin (X-1).

The weight average molecular weight (Mw) and the dispersity (Mw/Mn) determined by GPC showed the below results.
(X-1): Mw=9,000, Mw/Mn=2.75

### Synthesis Examples 2 to 19: Synthesis of Resins (X-2) to (X-12) and Resins (R-2), (R-3), (R-5), and (R-7) for Comparative Examples

The resins (X-2) to (X-12) and the resins (R-2), (R-3), (R-5), and (R-7) for Comparative Examples shown in Tables 1-3 were obtained as products under the same conditions as those in the Synthesis Example 1, except that the resins (A-1) to (A-8), the modifiers (c-1) to (c-3), and potassium carbonate were used in the preparation amounts shown in Tables 1-3. The weight average molecular weight (Mw) and the dispersity (Mw/Mn) of these resins were determined, which are shown in Table 4 together with those of (R-1), (R-4), and (R-6).

**Table 1**

| Synthesis Example | Resin | | Modifier | | Potassium Carbonate | Compound or Polymer |
|---|---|---|---|---|---|---|
| | | g | | g | g | |
| 1 | A-1 | 20.0 | c-1 | 10.2 | 11.5 | 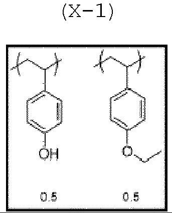 |
| 2 | A-1 | 20.0 | c-2 | 18.1 | 20.7 | 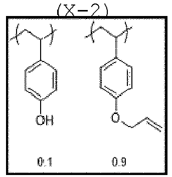 |
| 3 | A-1 | 20.0 | c-3 | 17.3 | 16.1 | 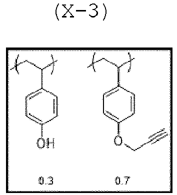 |
| 4 | A-2 | 20.0 | c-1 | 16.2 | 31.3 | 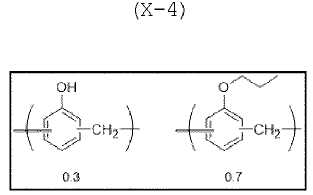 |
| 5 | A-3 | 20.0 | c-2 | 14.1 | 27.6 | 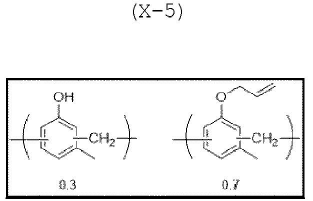 |
| 6 | A-3 | 20.0 | c-3 | 17.5 | 27.6 | 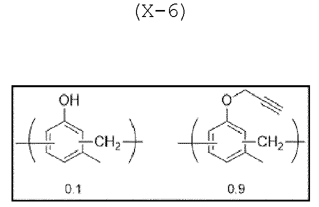 |

**Table 2**

| Synthes is Example | Resin | | Modifier | | Potassium Carbonate | Compound or Polymer |
|---|---|---|---|---|---|---|
| | | g | | g | g | |
| 7 | A-4 | 20.0 | c-1 | 28.2 | 31.7 | 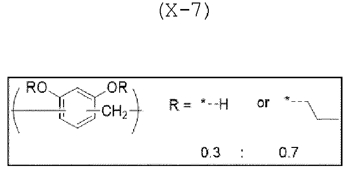 |
| 8 | A-5 | 20.0 | c-3 | 10.7 | 21.2 | 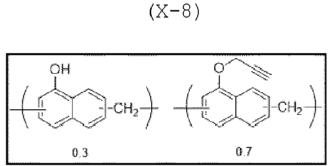 |
| 9 | A-6 | 20.0 | c-3 | 24.2 | 22.5 | 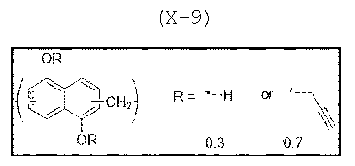 |
| 10 | A-7 | 20.0 | c-3 | 24.2 | 22.5 | 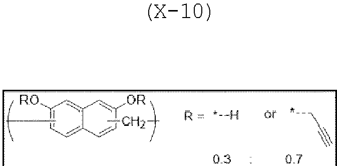 |
| 11 | A-8 | 20.0 | c-2 | 8.6 | 16.9 | 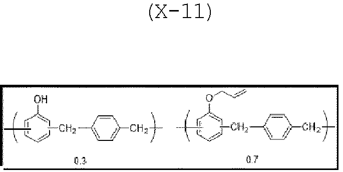 |
| 12 | A-8 | 20.0 | c-3 | 8.5 | 16.9 | 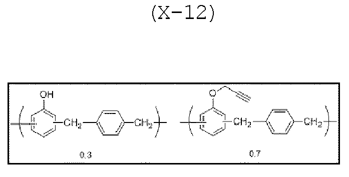 |

**Table 3**

| Synthesis Example | Resin | | Modifier | | Potassium Carbonate | Compound or Polymer |
|---|---|---|---|---|---|---|
| | | g | | g | g | |
| 13 | A-1 | 20.0 | - | - | - | 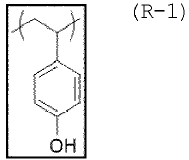 |
| 14 | A-1 | 20.0 | c-2 | 24.2 | 27.6 | 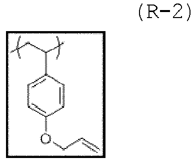 |
| 15 | A-1 | 20.0 | c-3 | 29.8 | 27.6 | 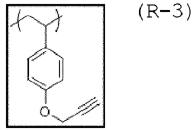 |
| 16 | A-3 | 20.0 | - | - | - | 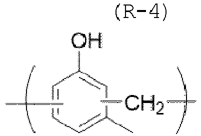 |
| 17 | A-3 | 20.0 | c-3 | 23.8 | 34.5 | 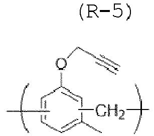 |
| 18 | A-4 | 20.0 | - | - | - | 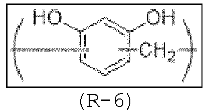 |
| 19 | A-4' | 20.0 | c-1 | 28.2 | 31.7 | 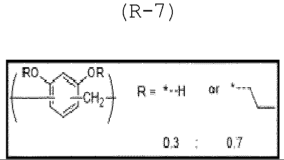 |

### Synthesis Examples 20 to 21: Synthesis of Resins (R-8) and (R-9) for Comparative Examples

The resin raw materials below were used for synthesis of resins (R-8) and (R-9) for Comparative Examples.

### Resin Raw Materials:

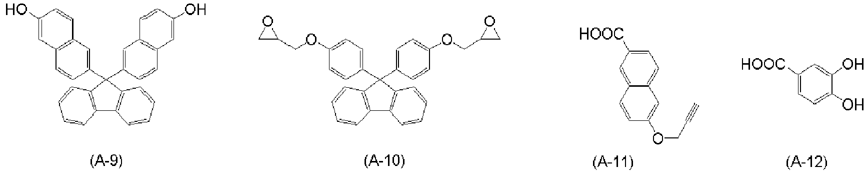

### Synthesis Example 20

### Synthesis of Resin (R-8) for Comparative Example

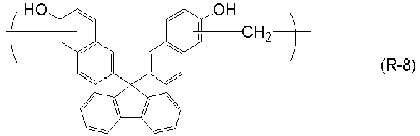

Under a nitrogen atmosphere, 90.1 g of the resin raw material (A-9), 9.7 g of the resin raw material (b-8), and 270 g of 2-methoxy-1-propanol were added to prepare a homogenous solution at a liquid temperature of 80°C. Thereafter, 18 g of a 2-methoxy-1-propanol solution of 20% para-toluenesulfonic acid was slowly added thereto and stirred at the liquid temperature of 110°C for 8 hours. After cooling to a room temperature, 600 g of methylisobutyl ketone was added, and the organic layer was washed 5 times with 200 g of pure water and then dried and solidified under reduced pressure. 320 g of THF was added to the residues, and polymers were precipitated again by 1,350 g of hexane. The precipitated polymers were separated by filtration and dried under reduced pressure, thereby obtaining the resin (R-8) for Comparative Example.

The weight average molecular weight (Mw) and the dispersity (Mw/Mn) determined by GPC showed the below results.
(R-8): Mw=3,460, Mw/Mn=4.60

### Synthesis Example 21

### Synthesis of Resin (R-9) for Comparative Example

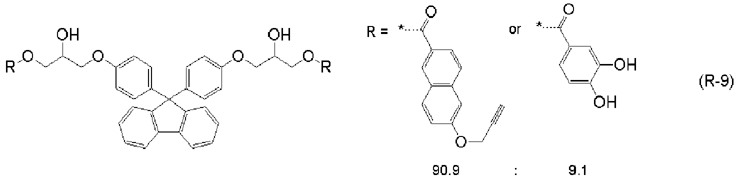

Under a nitrogen atmosphere, 15.4 g of the resin raw material (A-10), 13.6 g of the resin raw material (A-11), 1.0 g of the resin raw material (A-12), and 60 g of 2-methoxy-1-propanol were stirred at an internal temperature of 100°C to prepare a homogenous solution. Thereafter, 1.00 g of benzyltriethylammonium chloride was added to the solution, which was stirred at an internal temperature of 110°C for 12 hours. After cooled to a room temperature, 200 ml of methylisobutyl ketone was added, and the solution was washed twice with 100 g of a 1 wt% ammonia aqueous solution, twice with 100 g of a 3% nitric acid aqueous solution, and 5 times with 100 g of ultrapure water in this order. The organic layer was dried and solidified under reduced pressure to obtain the resin (R-9) for Comparative Example.

The weight average molecular weight (Mw) and the dispersity (Mw/Mn) determined by GPC showed the below results.
(R-9): Mw=910, Mw/Mn=1.03

**Table 4**

| (A) Resin | Mw | Mw/Mn |
|---|---|---|
| (X-1) | 9000 | 2.75 |
| (X-2) | 9500 | 2.60 |
| (X-3) | 9200 | 2.70 |
| (X-4) | 6000 | 3.61 |
| (X-5) | 7400 | 3.51 |
| (X-6) | 8000 | 3.60 |
| (X-7) | 6500 | 3.10 |
| (X-8) | 5900 | 2.43 |
| (X-9) | 7000 | 2.68 |
| (X-10) | 6600 | 2.83 |
| (X-11) | 7200 | 3.41 |
| (X-12) | 7100 | 3.35 |
| (R-1) | 8500 | 2.50 |
| (R-2) | 10000 | 2.55 |
| (R-3) | 10000 | 2.60 |
| (R-4) | 3300 | 3.50 |
| (R-5) | 9400 | 3.59 |
| (R-6) | 2900 | 2.26 |
| (R-7) | 14500 | 3.10 |
| (R-8) | 3460 | 4.60 |
| (R-9) | 910 | 1.03 |

### Preparation of Composition for Forming Resist Underlayer

### Film (UL-1 to 14, Comparative Examples UL-1 to 11)

The resins (X-1) to (X-12) and (R-1) to (R-9), base generators (B-1) to (B-4), a crosslinking agent (D-1), and a flowability accelerator (E-1) were dissolved in an organic solvent containing 0.1% by mass of FC-4430 (manufactured by 3M Corporation and purified by the applicant of the present invention) in the proportions shown in Tables 6 and 7, and filtered through a 0.1 µm filter made of a fluororesin to prepare the compositions for forming a resist underlayer film (UL-1 to 14,

### Comparative Examples UL-1 to 11).

### (B) Base Generator

The base generators (B-1) to (B-4) used for the composition for forming a resist underlayer film are shown below.

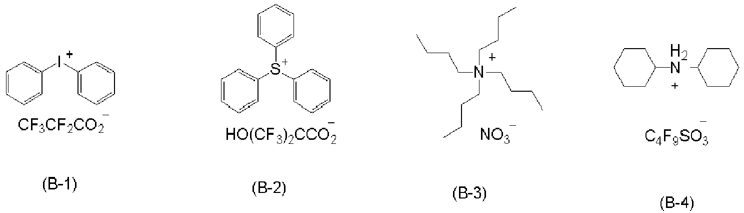

### Crosslinking Agent

The crosslinking agent (D-1) used for the composition for forming a resist underlayer film is shown below.

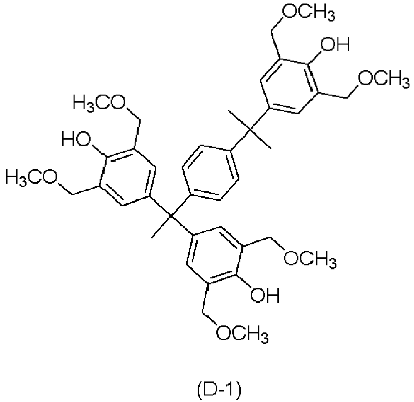

### Flowability Accelerator

The flowability accelerator (E-1) used for the composition for forming a resist underlayer film is shown in Table 5 below.

**Table 5**

| Compound or Polymer | Mw (Calculated Value) | Weight Loss Rate between 30°C to 190°C (%) | Weight Loss Rate between 30°C to 350°C (%) |
|---|---|---|---|
| 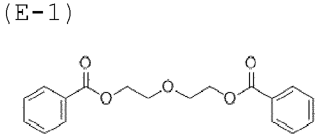 | 314 | 1 | 100 |

**Table 6**

| Composition for Forming | (A) Resin | (B)Base Generator | (D)Crosslinking Agent | (E)Flowability Accelerator | (C) Solvent |
|---|---|---|---|---|---|
| Resist Underlayer Film | (parts by mass) | (parts by mass) | (parts by mass) | (parts by mass) | (parts by mass) |
| UL-1 | (X-1) | (B-1) | - | - | PGMEA(200) |
| | (100) | (0.5) | | | |
| UL-2 | (X-2) | (B-2) | - | - | PGMEA(200) |
| | (100) | (0.5) | | | |
| UL-3 | (X-3) | (B-3) | - | - | PGMEA(200) |
| | (100) | (0.5) | | | |
| UL-4 | (X-4) | (B-4) | - | - | PGMEA(200) |
| | (100) | (0.5) | | | |
| UL-5 | (X-5) | (B-1) | - | - | PGMEA(200) |
| | (100) | (0.5) | | | |
| UL-6 | (X-6) | (B-2) | - | - | PGMEA(200) |
| | (100) | (0.5) | | | |
| UL-7 | (X-7) | (B-3) | - | - | PGMEA(200) |
| | (100) | (0.5) | | | |
| UL-8 | (X-8) | (B-4) | - | - | PGMEA(200) |
| | (100) | (0.5) | | | |
| UL-9 | (X-9) | (B-1) | - | - | PGMEA(200) |
| | (100) | (0.5) | | | |
| UL-10 | (X-10) | (B-2) | - | - | PGMEA(200) |
| | (100) | (0.5) | | | |
| UL-11 | (X-11) | (B-3) | (D-1) | - | PGMEA(200) |
| | (100) | (0.5) | (30) | | |
| UL-12 | (X-12) | (B-4) | - | - | PGMEA(200) |
| | (100) | (0.5) | | | |
| UL-13 | R-1 (30) | (B-1) | - | - | PGMEA(200) |
| | R-2(70) | (0.5) | | | |
| UL-14 | R-4(50) | (B-2) | - | (E-1) | PGMEA(200) |
| | R-5(50) | (0.5) | | (30) | |

**Table 7**

| Composition for Forming | (A) Resin | (B)Base Generator | (D) Crosslinking Agent | (E) Flowability Accelerator | (C) Solvent |
|---|---|---|---|---|---|
| Resist Underlayer Film | (parts by mass) | (parts by mass) | (parts by mass) | (parts by mass) | (parts by mass) |
| Comparative Example UL-1 | (R-1) | - | - | - | PGMEA(200) |
| | (100) | | | | |
| Comparative Example UL-2 | (R-2) | - | - | - | PGMEA(200) |
| | (100) | | | | |
| Comparative Example UL-3 | (R-3) | (B-1) | - | - | PGMEA(200) |
| | (100) | (0.5) | | | |
| Comparative Example UL-4 | (R-4) | (B-2) | (D-1) | - | PGMEA(200) |
| | (100) | (0.5) | (30) | | |
| Comparative Example UL-5 | (R-5) | (B-3) | - | - | PGMEA(200) |
| | (100) | (0.5) | | | |
| Comparative Example UL-6 | (R-1) | (B-4) | - | - | PGMEA(200) |
| | (80) | (0.5) | | | |
| | (R-2) | | | | |
| | (20) | | | | |
| Comparative Example UL-7 | (X-5) | - | - | - | PGMEA(200) |
| | (100) | | | | |
| Comparative Example UL-8 | (R-6) | (B-1) | - | - | PGMEA(200) |
| | (100) | (0.5) | | | |
| Comparative Example UL-9 | (R-7) | (B-2) | - | - | PGMEA(200) |
| | (100) | (0.5) | | | |
| Comparative Example UL-10 | (R-8) | - | - | - | PGMEA(200) |
| | (100) | | | | |
| Comparative Example UL-11 | (R-9) | - | - | - | PGMEA(200) |
| | (100) | | | | |

### Evaluation of Solvent Resistance and Film Thickness Uniformity (Examples 1-1 to 1-14, Comparative Examples 1-1 to 1-11)

The composition for forming a resist underlayer film (UL-1 to 14, Comparative Examples UL-1 to 11) prepared as described above was applied onto a silicon substrate and baked at each baking temperature for 60 seconds, followed by measuring film thickness from the center to the outer periphery of the substrate to calculate average film thickness (a[nm]). Next, a PGMEA solvent was dispensed thereon and left as it was for 30 seconds, followed by spin drying and baking at 100°C for 60 seconds to evaporate PGMEA. Then, the film thickness (b[nm]) was measured. A film thickness difference (percentage of remaining film: (b/a)×100) before and after the PGMEA treatment was obtained.

Moreover, for the films baked under respective conditions, the film thickness from the center to the outer periphery of the substrate was measured. The film thickness uniformity was evaluated as "A" (good) when difference between maximum film thickness and minimum film thickness as measured above was less than 3% of the average film thickness (a), evaluated as "B" (fair) when the difference was 3% or greater and less than 5%, and evaluated as "C" (poor) when the difference was 5% or greater. Further, the film formability of the fabricated resist underlayer film was observed by an optical microscope, and the film formability was evaluated as "good" when there were no defects such as cracks or wrinkles, and evaluated as "poor" when cracks or wrinkles were observed.

The results of Examples 1-1 to 1-14 are shown in Table 8 below, and the results of Comparative Examples 1-1 to 1-11 are shown in Table 9 below.

**Table 8**

| Ex. | Composition for Forming | Baking Temperature | Film Formability | Film Thickness after Deposition: a | Film Thickness Uniformity | Film Thickness after Solvent Treatment:b | b/a x100 |
|---|---|---|---|---|---|---|---|
| | Resist Underlayer Film | | | Å | | Å | % |
| Ex. 1-1 | UL-1 | 250°C | Good | 29400 | A | 29400 | 100% |
| Ex. 1-2 | UL-2 | 250°C | Good | 29500 | A | 29500 | 100% |
| Ex. 1-3 | UL-3 | 250°C | Good | 29400 | A | 29400 | 100% |
| Ex. 1-4 | UL-4 | 250°C | Good | 30500 | A | 30500 | 100% |
| Ex. 1-5 | UL-5 | 250°C | Good | 30200 | A | 30200 | 100% |
| Ex. 1-6 | UL-6 | 250°C | Good | 30300 | A | 30300 | 100% |
| Ex. 1-7 | UL-7 | 250°C | Good | 29900 | A | 29900 | 100% |
| Ex. 1-8 | UL-8 | 250°C | Good | 30000 | A | 30000 | 100% |
| Ex. 1-9 | UL-9 | 250°C | Good | 30100 | A | 30100 | 100% |
| Ex. 1-10 | UL-10 | 250°C | Good | 30200 | A | 30200 | 100% |
| Ex. 1-11 | UL-11 | 250°C | Good | 30400 | A | 30300 | 100% |
| Ex. 1-12 | UL-12 | 250°C | Good | 30400 | A | 30300 | 100% |
| Ex. 1-13 | UL-13 | 250°C | Good | 29300 | A | 29300 | 100% |
| Ex. 1-14 | UL-14 | 250°C | Good | 30500 | A | 30500 | 100% |

**Table 9**

| Ex. | Composition for Forming | Baking Temperature | Film Formability | Film Thickness after Deposition: a | Film Thickness Uniformity | Film Thickness after Solvent Treatment: b | b/a x100 |
|---|---|---|---|---|---|---|---|
| | Resist Underlayer Film | | | Å | | Å | % |
| Comp. Ex. 1-1 | Comp. Ex. UL-1 | 250°C | Good | 29700 | B | 29700 | 100% |
| Comp. Ex. 1-2 | Comp. Ex. UL-2 | 250°C | Good | 29200 | A | 29200 | 100% |
| Comp. Ex. 1-3 | Comp. Ex. UL-3 | 250°C | Good | 29300 | A | 29300 | 100% |
| Comp. Ex. 1-4 | Comp. Ex. UL-4 | 250°C | Good | 30300 | B | 30300 | 100% |
| Comp. Ex. 1-5 | Comp. Ex. UL-5 | 250°C | Good | 30600 | A | 30600 | 100% |
| Comp. Ex. 1-6 | Comp. Ex. UL-6 | 250°C | Good | 29600 | B | 29600 | 100% |
| Comp. Ex. 1-7 | Comp. Ex. UL-7 | 250°C | Good | 30200 | A | 30200 | 100% |
| Comp. Ex. 1-8 | Comp. Ex. UL-8 | 250°C | Good | 29400 | C | 29400 | 100% |
| Comp. Ex. 1-9 | Comp. Ex. UL-9 | 250°C | Good | 30100 | A | 30100 | 100% |
| Comp. Ex. 1-10 | Comp. Ex. UL-10 | 350°C | Crack | 30650 | C | 30650 | 100% |
| Comp. Ex. 1-11 | Comp. Ex. UL-11 | 250°C | Crack | 30300 | C | 30300 | 100% |

As shown in Table 8, Examples 1-1 to 1-14 which used UL-1 to 14 respectively as the composition for forming a resist underlayer film according to the present invention demonstrated good film formability and film thickness uniformity when forming the film. Additionally, the percentage of the remaining film ((b/a)×100) after PGMEA-rinsing treatment was 99% or more, indicating that a crosslinking reaction took place and sufficient solvent resistance was exhibited.

On the other hand, in Comparative Examples 1-1, 1-4, and 1-6 which used Comparative Examples UL-1, UL-4, and UL-6 respectively with a content of a group obtained by modifying a phenolic hydroxyl group outside the range of the present invention, deterioration in the film thickness uniformity was observed probably because of high viscosity of the resin and insufficient flowability during spin coating. It was presumed that in Comparative Example 1-8 which used Comparative Example UL-8 containing the resin (R-6) with the molecular weight of less than 3,000, sublimates increased due to insufficient heat resistance property of a low molecular weight component, resulting in deterioration in the film thickness uniformity.

In Comparative Example 1-10 which used Comparative Example UL-10 containing the resin (R-8) with a rigid cardo structure and Comparative Example 1-11 which used Comparative Example UL-11 containing the resin (R-9), a crack was observed on the surface of the resist underlayer film after the substrate baking. Furthermore, due to the presence of the crack, deterioration in the film thickness uniformity was recognized. It can be said that it is preferable to use a resin containing any of a styrene unit, a novolac-type phenol unit, and a novolac-type naphthol unit when forming a film having thickness of 3 um or more.

### Filling Property (Examples 2-1 to 2-14, Comparative Examples 2-1 to 2-9)

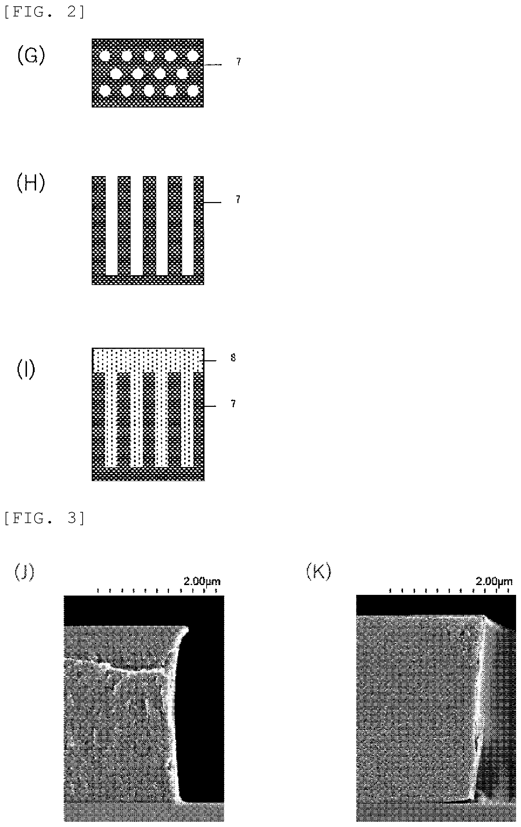

The compositions for forming a resist underlayer film (UL-1 to 14 and Comparative Examples UL-1 to 9) used for the above evaluation of the solvent resistance were each applied onto a SiO₂ wafer substrate 7 having a dense hole pattern (hole diameter: 0.45 um, hole depth: 11.0 um, distance between the centers of two adjacent holes: 1.00 um) as shown in FIGS. 2(G) (plan view) and (H) (sectional view), and baked at the temperature described in Tables 8 and 9 for 60 seconds to form a resist underlayer film 8 as shown in FIG. 2(I). Cross-sectional shapes of each wafer substrate thus obtained was observed using a scanning electron microscope (SEM) to confirm whether or not filling with the resist underlayer film was achieved with no void inside the hole nor peeling at an interface between the pattern sidewall and the resist underlayer film. The results are shown in Table 10. When the composition for forming a resist underlayer film having the poor filling property was used, occurrence of a void inside the hole was confirmed in this evaluation. Additionally, when the composition for forming a resist underlayer film having the poor adhesiveness was used, occurrence of peeling was confirmed at the interface between the pattern sidewall or the substrate and the resist underlayer film in this evaluation. When the composition for forming a resist underlayer film having the good filling property and adhesiveness was used, the resist underlayer film 8 was filled in the hole with no void or peeling as shown in FIG. 2(I) in this evaluation.

**Table 10**

| Example | Composition for Forming | Filling Property | |
|---|---|---|---|
| | Resist Underlayer Film | Occurrence of Void | Peeling from Substrate |
| Example 2-1 | UL-1 | No | No |
| Example 2-2 | UL-2 | No | No |
| Example 2-3 | UL-3 | No | No |
| Example 2-4 | UL-4 | No | No |
| Example 2-5 | UL-5 | No | No |
| Example 2-6 | UL-6 | No | No |
| Example 2-7 | UL-7 | No | No |
| Example 2-8 | UL-8 | No | No |
| Example 2-9 | UL-9 | No | No |
| Example 2-10 | UL-10 | No | No |
| Example 2-11 | UL-11 | No | No |
| Example 2-12 | UL-12 | No | No |
| Example 2-13 | UL-13 | No | No |
| Example 2-14 | UL-14 | No | No |
| Comparative Example 2-1 | Comparative Example UL-1 | Yes | No |
| Comparative Example 2-2 | Comparative Example UL-2 | No | Yes |
| Comparative Example 2-3 | Comparative Example UL-3 | No | Yes |
| Comparative Example 2-4 | Comparative Example UL-4 | Yes | No |
| Comparative Example 2-5 | Comparative Example UL-5 | No | Yes |
| Comparative Example 2-6 | Comparative Example UL-6 | Yes | No |
| Comparative Example 2-7 | Comparative Example UL-7 | No | Yes |
| Comparative Example 2-8 | Comparative Example UL-8 | Yes | No |
| Comparative Example 2-9 | Comparative Example UL-9 | Yes | Yes |

As shown in Table 10, it can be seen that Examples 2-1 to 2-14 which used UL-1 to 14 respectively as the composition for forming a resist underlayer film according to the present invention could fill the hole pattern without voids or peeling and have the excellent filling property and adhesiveness.

On the other hand, it is considered that in Comparative Examples 2-1, 2-4, 2-6, and 2-8 using Comparative Examples UL-1, UL-4, UL-6, and UL-8 respectively, lack of flowability due to the high amount of the hydroxyl group in the resin caused a void because of poor filling.

In Comparative Examples 2-2 and 2-5 using Comparative Examples UL-2 and UL-5 respectively, there was no occurrence of voids but peeling due to the insufficient adhesiveness was observed. This is presumably because of the insufficient amount of the hydroxyl group in the resin.

In Comparative Example 2-7 using Comparative Example UL-7, there was no occurrence of voids but peeling due to the insufficient adhesiveness was observed. This is presumably because the composition did not contain the base generator and thus the adhesiveness was not improved.

In Comparative Example 2-3 using Comparative Example UL-3, it is presumed that although the composition contained the base generator, the amount of the hydroxyl group in the resin was insufficient so that the adhesiveness was not improved.

In Comparative Example 2-9 using Comparative Example UL-9, not only peeling from the substrate but also a void were observed. It is presumed that the occurrence of the void was due to the high molecular weight of the resin and the insufficient thermal flowability. From the viewpoints of the film thickness uniformity and the filling property, it can be said that the molecular weight of the resin needs to be 3,000 to 10,000.

### Patterning Process (Examples 3-1 to 3-12 and 4-1 to 4-12, Comparative Examples 3-1 to 3-7)

Each of the compositions for forming a resist underlayer film (UL-1 to 12 and Comparative Examples UL-1 to 7) was applied onto a silicon wafer substrate having a formed SiO₂ film which was subjected to HMDS treatment (90°C×60 seconds), and baked in the air at 250°C for 60 seconds to form a resist underlayer film having film thickness of 3,000 nm. A silicon atom-containing resist middle layer film material (SOG-1) was applied thereon and baked at 220°C for 60 seconds to form a resist middle layer film having film thickness of 45 nm, onto which a single-layer resist for ArF as a resist upper layer film material was applied and baked at 105°C for 60 seconds to form a photoresist film having film thickness of 100 nm.

The silicon atom-containing resist middle layer film material (SOG-1) was prepared by dissolving a polymer denoted by an ArF silicon-containing middle layer film polymer (SiP1) and a thermal crosslinking catalyst (CAT1) in an organic solvent containing 0.1% by mass of FC-4430 (manufactured by Sumitomo 3M Limited) in the proportions shown in Table 11, and filtering through a filter made of a fluororesin having a pore size of 0.1 µm.

**Table 11**

| | Polymer | Thermal Crosslinking Catalyst | Organic Solvent |
|---|---|---|---|
| | (parts by mass) | (parts by mass) | (parts by mass) |
| SOG-1 | SiP1 (100) | CAT1 (1) | Propylene Glycol Monoethyl Ether (4000) |

The structural formulae of the used silicon-containing middle layer film polymer for ArF (SiP1) and thermal crosslinking catalyst (CAT1) are shown below.

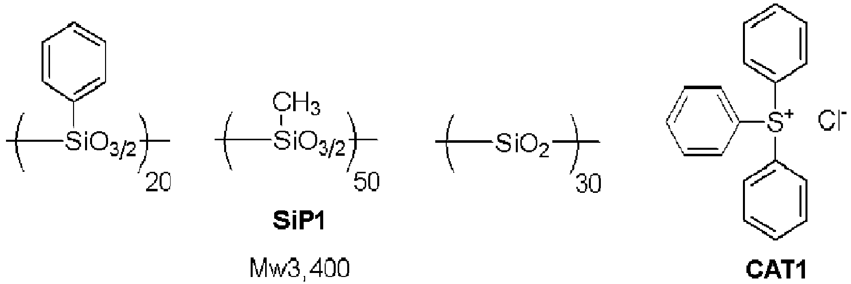

The resist upper layer film material (single-layer resist for ArF) was prepared by dissolving a polymer (RP1), an acid generator (PAG1), and a basic compound (Amine1) in a solvent containing 0.1% by mass of a surfactant FC-4430 (manufactured by Sumitomo 3M Limited) in the proportions shown in Table 12, and filtering through a 0.1 µm filter made of a fluororesin.

**Table 12**

| | Polymer (parts by mass) | Acid Generator (parts by mass) | Basic Compound (parts by mass) | Solvent (parts by mass) |
|---|---|---|---|---|
| Single-Layer Resist for ArF | RP1 (100) | PAG1 (6.6) | Aminel (0.8) | PGMEA (2500) |

The polymer (RP1), the acid generator (PAG1), and the basic compound (Amine1) used for the resist upper layer film material (single-layer resist for ArF) are shown below.

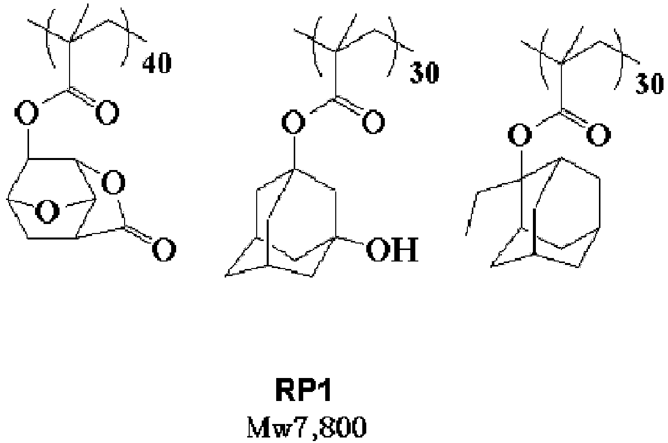

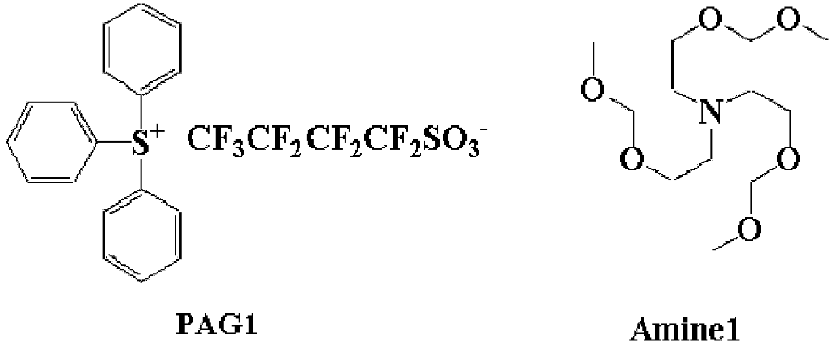

Next, the photoresist film was exposed using an ArF immersion lithography system (manufactured by Nikon Corporation; NSR-S610C, NA0.85, σ0.75, conventional, 6% half-tone phase-shifting mask), baked (PEB) at 100°C for 60 seconds, and developed by a 2.38% by mass tetramethylammonium hydroxide (TMAH) aqueous solution, thereby obtaining a 5 um 1:1 positive line-and-space pattern (resist pattern).

Next, using a Telius etcher manufactured by Tokyo Electron Limited, the resist middle layer film was etched by dry etching while using the resist pattern as a mask to form a resist middle layer film pattern, and the resist underlayer film was etched while using the resist middle layer film pattern thus obtained as a mask to form a resist underlayer film pattern. The etching conditions are as follows.

Conditions for transferring the resist pattern to the resist middle layer film.
Chamber pressure: 80 mT
RF power (upper portion): 500 W
RF power (lower portion): 300 W
CF₄ gas flow rate: 150 sccm
CHF₃ gas flow rate: 50 sccm
Time: 35 sec

Conditions for transferring the resist middle layer film pattern to the resist underlayer film.
Chamber pressure: 80 mT
RF power (upper portion): 500 W
RF power (lower portion): 300 W
CO₂ gas flow rate: 320 sccm
N₂ gas flow rate: 80 sccm
Time: 900 sec

Observation results of the pattern cross section by an electron microscope (S-4700) manufactured by Hitachi Ltd. are shown in Table 13.

**Table 13**

| Example | Composition for Forming | Resist Underlayer Film |
|---|---|---|
| | Resist Underlayer Film | Shape after Etching |
| Example 3-1 | UL-1 | Vertical Shape |
| Example 3-2 | UL-2 | Vertical Shape |
| Example 3-3 | UL-3 | Vertical Shape |
| Example 3-4 | UL-4 | Vertical Shape |
| Example 3-5 | UL-5 | Vertical Shape |
| Example 3-6 | UL-6 | Vertical Shape |
| Example 3-7 | UL-7 | Vertical Shape |
| Example 3-8 | UL-8 | Vertical Shape |
| Example 3-9 | UL-9 | Vertical Shape |
| Example 3-10 | UL-10 | Vertical Shape |
| Example 3-11 | UL-11 | Vertical Shape |
| Example 3-12 | UL-12 | Vertical Shape |
| Comparative Example 3-1 | Comparative Example UL-1 | Vertical Shape |
| Comparative Example 3-2 | Comparative Example UL-2 | Peeled |
| Comparative Example 3-3 | Comparative Example UL-3 | Peeled |
| Comparative Example 3-4 | Comparative Example UL-4 | Vertical Shape |
| Comparative Example 3-5 | Comparative Example UL-5 | Peeled |
| Comparative Example 3-6 | Comparative Example UL-6 | Vertical Shape |
| Comparative Example 3-7 | Comparative Example UL-7 | Peeled |

As shown in Table 13, it was found that in all Examples 3-1 to 3-12 which used UL-1 to 12 respectively as the composition for forming a resist underlayer film according to the present invention, the resist pattern was favorably transferred to the resist underlayer film. Additionally, there were no abnormalities such as peeling confirmed at the interface between the resist underlayer film and the substrate.

On the other hand, in the above evaluation of the filling property, it was confirmed that in Comparative Examples 3-2, 3-3, 3-5, and 3-7 which used Comparative Examples UL-2, UL-3, UL-5, and UL-7 respectively with the insufficient adhesiveness to the substrate confirmed, a void was generated at the interface between the resist underlayer film and the substrate after dry etching processing of the resist underlayer film.

The cross-sectional shapes of Example 3-10 and Comparative Example 3-3 are shown in FIGS. 3(J) and 3(K), respectively.

Next, using the compositions for forming a resist underlayer film (UL-1 to 12) according to the present invention, processing as far as the etching of the resist underlayer film was performed in the same manner as the above evaluation, and further the SiO₂ film was processed while using the resist underlayer film as a mask.

Conditions for transferring the resist underlayer film pattern to the SiO₂ film.
Chamber pressure: 10 mT
RF power (upper portion): 100 W
RF power (lower portion): 800 W
CF₄ gas flow rate: 25 sccm
CHF₃ gas flow rate: 15 sccm
O₂ gas flow rate: 5 sccm
Time: 900 sec

Observation results of the pattern cross section by an electron microscope (S-4700) manufactured by Hitachi Ltd. are shown in Table 14.

**Table 14**

| Example | Composition for Forming | SiO₂ Film |
|---|---|---|
| | Resist Underlayer Film | Shape after Etching |
| Example 4-1 | UL-1 | Vertical Shape |
| Example 4-2 | UL-2 | Vertical Shape |
| Example 4-3 | UL-3 | Vertical Shape |
| Example 4-4 | UL-4 | Vertical Shape |
| Example 4-5 | UL-5 | Vertical Shape |
| Example 4-6 | UL-6 | Vertical Shape |
| Example 4-7 | UL-7 | Vertical Shape |
| Example 4-8 | UL-8 | Vertical Shape |
| Example 4-9 | UL-9 | Vertical Shape |
| Example 4-10 | UL-10 | Vertical Shape |
| Example 4-11 | UL-11 | Vertical Shape |
| Example 4-12 | UL-12 | Vertical Shape |

As shown in Table 14, it was found that in all Examples 4-1 to 4-12 which used UL-1 to 12 respectively as the composition for forming a resist underlayer film according to the present invention, the resist pattern was favorably transferred to the SiO₂ film.

Accordingly, it was demonstrated that the composition for forming a resist underlayer film according to the present invention has both the high filling property and adhesiveness to the substrate so as to be extremely useful as the resist underlayer film material used for the multilayer resist method, and the patterning process according to the present invention using thereof can form a fine pattern with high precision even when a workpiece is a substrate having steps.

The present description includes the following embodiments.
[1]: A composition for forming a resist underlayer film used for a multilayer resist method, comprising (A) a resin, (B) a base generator, and (C) an organic solvent, wherein
   a weight-average molecular weight of (A) the resin is 3,000 to 10,000,
   (A) the resin is (A-1) a resin containing a phenolic hydroxyl group and a group obtained by modifying a phenolic hydroxyl group, or (A-2) a mixture of a resin containing a phenolic hydroxyl group and a resin containing a group obtained by modifying a phenolic hydroxyl group, and
   (A) the resin satisfies relations of a+b=1, 0.1≤a≤0.5, and 0.5≤b≤0.9, wherein "a" is a proportion of a phenolic hydroxyl group and "b" is a proportion of a group obtained by modifying a phenolic hydroxyl group contained in (A) the resin.
[2]: The composition for forming a resist underlayer film of the above [1], wherein (A) the resin contains any of a styrene unit, a novolac-type phenol unit, and a novolac-type naphthol unit.
[3]: The composition for forming a resist underlayer film of the above [1] or [2], wherein (A) the resin is a resin having a constitutional unit represented by the following general formula (1-1) or (1-2), 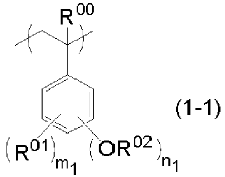 in the general formula (1-1), R⁰⁰ represents a hydrogen atom or a methyl group; R⁰¹ represents a saturated or unsaturated monovalent organic group having 1 to 30 carbon atoms; R⁰² represents a hydrogen atom, or a saturated or unsaturated optionally substituted monovalent organic group having 1 to 30 carbon atoms, satisfying relations of a'+b'=1, 0.1≤a'≤0.5, and 0.5≤b'≤0.9, wherein "a'" is a proportion of the hydrogen atom and "b'" is a proportion of the monovalent organic group to a structure constituting the R⁰²; "m₁" represents an integer of 0 to 4; "n₁" represents an integer of 1 to 5; and m₁+n₁ represents an integer of 1 or greater and 5 or smaller; 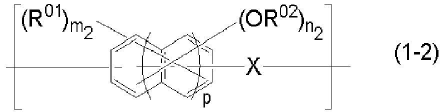 in the general formula (1-2), R⁰¹ represents a saturated or unsaturated monovalent organic group having 1 to 30 carbon atoms; R⁰² represents a hydrogen atom or a saturated or unsaturated optionally substituted monovalent organic group having 1 to 30 carbon atoms, satisfying relations of a'+b'=1, 0.1≤a'≤0.5, and 0.5≤b'≤0.9, wherein "a'" is a proportion of the hydrogen atom and "b'" is a proportion of the monovalent organic group to a structure constituting the R⁰²; X represents a divalent organic group having 1 to 30 carbon atoms; "p" represents 0 or 1, and when "p" is 0, "m₂" represents an integer of 0 to 3, "n₂" represents an integer of 1 to 4, and m₂+n₂ represents an integer of 1 or greater and 4 or smaller, whereas when "p" is 1, "m₂" represents an integer of 0 to 5, "n₂" represents an integer of 1 to 6, and m₂+n₂ represents an integer of 1 or greater and 6 or smaller.
[4]: The composition for forming a resist underlayer film of the above [3], wherein in the general formulae (1-1) and (1-2), the R⁰² is any of a hydrogen atom, an alkyl group having 1 to 10 carbon atoms, and a structure represented by the following general formulae (8), 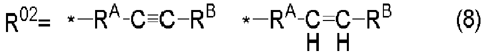 wherein * represents a bonding position to an oxygen atom; R^{A} represents an optionally substituted divalent organic group having 1 to 10 carbon atoms; and R^{B} represents a hydrogen atom or an optionally substituted monovalent organic group having 1 to 10 carbon atoms.
[5]: The composition for forming a resist underlayer film of the above [3] or [4], wherein in the general formula (1-2), "p" is 0.
[6]: The composition for forming a resist underlayer film of any one of the above [3] to [5], wherein in the general formula (1-1), "n₁" is 1.
[7]: The composition for forming a resist underlayer film of any one of the above [3] to [6], wherein in the general formula (1-2), "n₂" is 1.
[8]: The composition for forming a resist underlayer film of any one of the above [1] to [7], wherein the "a" and the "b" satisfy relations of a+b=1, 0.15≤a≤0.4, and 0.6≤b≤0.85.
[9]: The composition for forming a resist underlayer film of any one of the above [1] to [8], wherein (B) the base generator is a compound which exhibits basicity due to pyrolysis.
[10]: The composition for forming a resist underlayer film of any one of the above [1] to [9], wherein (B) the base generator is represented by any of the following general formulae (2), (3), and (4), 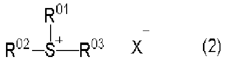 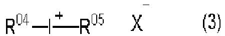 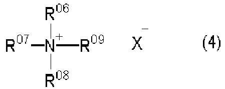 wherein each of R⁰¹ to R⁰³ independently represents a linear, branched, or cyclic alkyl group or alkenyl group having 1 to 10 carbon atoms, or an aralkyl group having 7 to 18 carbon atoms, which is optionally substituted with or separated by a heteroatom, or represents an aryl group having 6 to 18 carbon atoms, which is optionally substituted with or separated by a heteroatom; additionally, any two of R⁰¹, R⁰², and R⁰³ optionally bond together to form a ring with a sulfur atom in the formula; X- represents an organic or inorganic anion as a counterion, but X⁻ does not contain OH⁻; each of R⁰⁴ and R⁰⁵ independently represents an aryl group having 6 to 20 carbon atoms, which is optionally substituted with or separated by a heteroatom, wherein part or all of hydrogen atoms thereof are optionally substituted with a linear, branched, or cyclic alkyl group or alkoxy group having 1 to 10 carbon atoms; additionally, R⁰⁴ and R⁰⁵ optionally bond together to form a ring with an iodine atom in the formula; each of R⁰⁶, R⁰⁷, R⁰⁸, and R⁰⁹ independently represents a hydrogen atom, a linear, branched, or cyclic alkyl group or alkenyl group having 1 to 20 carbon atoms, or an aralkyl group having 7 to 18 carbon atoms, which is optionally substituted with or separated by a heteroatom, or represents an aryl group having 6 to 18 carbon atoms, which is optionally substituted with or separated by a heteroatom; and any two or more of R⁰⁶, R⁰⁷, R⁰⁸, and R⁰⁹ optionally bond together to form a ring with a nitrogen atom in the formula.
[11]: The composition for forming a resist underlayer film of the above [10], wherein X⁻ in the general formulae (2), (3), and (4) is a structure represented by any of the following general formulae (5), (6), and (7), or any of anions selected from a group consisting of a chloride ion, a bromide ion, an iodide ion, a fluoride ion, a cyanide ion, a nitrate ion, and a nitrite ion,

   R¹⁰-COO⁻ (5)

   R¹¹-SO₃⁻ (6)

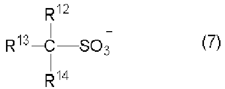

   wherein R¹⁰ represents a linear, branched, or cyclic alkyl group or alkenyl group having 1 to 20 carbon atoms, an aralkyl group having 7 to 20 carbon atoms, or an aryl group having 6 to 20 carbon atoms, and optionally containing an ether group, an ester group, and a carbonyl group, wherein one or more hydrogen atoms of these groups are optionally substituted with a halogen atom, a hydroxyl group, a carboxyl group, an amino group, or a cyano group; R¹¹ represents an aryl group having 6 to 20 carbon atoms, wherein one or more hydrogen atoms of the aryl group are optionally substituted with a halogen atom, a hydroxyl group, a carboxyl group, an amino group, or a cyano group; each of R¹², R¹³, and R¹⁴ independently represents a hydrogen atom, a halogen atom other than a fluorine atom, a linear, branched, or cyclic alkyl group or alkenyl group having 1 to 20 carbon atoms, an aralkyl group having 7 to 20 carbon atoms, or an aryl group having 6 to 20 carbon atoms, and optionally containing an ether group, an ester group, and a carbonyl group, wherein one or more hydrogen atoms of these groups are optionally substituted with a halogen atom, a hydroxyl group, a carboxyl group, an amino group, or a cyano group, and two or more of R¹², R¹³, and R¹⁴ optionally bond together to form a ring.
[12]: The composition for forming a resist underlayer film of any one of the above [1] to [11], wherein (A) the resin satisfies 2.00≤Mw/Mn≤5.00, where Mw is a weight-average molecular weight and Mn is a number-average molecular weight measured by gel permeation chromatography in terms of polystyrene.
[13]: The composition for forming a resist underlayer film of any one of the above [1] to [12], wherein a content of (A) the resin in the composition for forming a resist underlayer film is 20% by mass or greater.
[14]: The composition for forming a resist underlayer film of any one of the above [1] to [13], comprising (D) a crosslinking agent.
[15]: The composition for forming a resist underlayer film of any one of the above [1] to [14], comprising (E) a flowability accelerator, wherein a weight loss rate between 30°C to 190°C is less than 30% and the weight loss rate between 30°C to 350°C is 98% or greater.
[16]: The composition for forming a resist underlayer film of the above [15], wherein (E) the flowability accelerator contains one or more compounds selected from the following general formulae (i) to (iii), 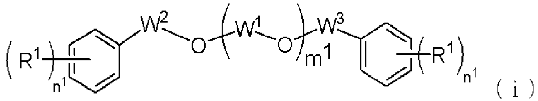
   wherein each R¹ independently represents a hydrogen atom, a hydroxyl group, or an optionally substituted organic group having 1 to 10 carbon atoms; W¹ represents a phenylene group or a divalent group represented by the following general formula (i-1); W² and W³ represent a single bond or a divalent group represented by any of the following general formulae (i-2); "m¹" represents an integer of 1 to 10; and "n¹" represents an integer of 0 to 5; 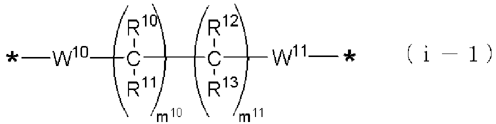
   wherein * represents a bonding position; R¹⁰, R¹¹, R¹², and R¹³ represent a hydrogen atom, a hydroxyl group, or an organic group having 1 to 10 carbon atoms; each of W¹⁰ and W¹¹ independently represents a single bond or a carbonyl group; and "m¹⁰" and "m¹¹" represent an integer of 0 to 10 satisfying a relation of m¹⁰+m¹¹≥1; 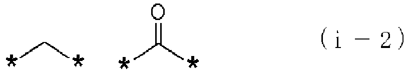
   wherein * represents a bonding position; 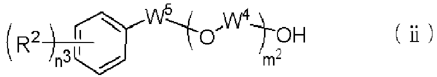
   wherein each R² independently represents a hydrogen atom or an optionally substituted organic group having 1 to 10 carbon atoms; W⁴ represents a divalent group represented by the following general formula (ii-1); W⁵ represents a single bond or a divalent group represented by any of the following general formulae (ii-2); "m₂" represents an integer of 2 to 10; and "n³" represents an integer of 0 to 5; 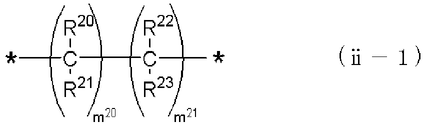
   wherein * represents a boning position; R²⁰, R²¹, R²², and R²³ represent a hydrogen atom, a hydroxyl group, or an organic group having 1 to 10 carbon atoms; and "m²⁰" and "m²¹" represent an integer of 0 to 10 satisfying a relation of m²⁰+m²¹≥1; 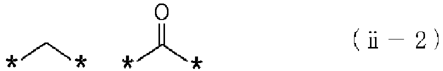
   wherein * represents a bonding position; 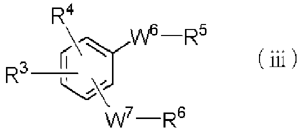
   wherein R³ and R⁴ represent a hydrogen atom, a hydroxyl group, or an optionally substituted organic group having 1 to 10 carbon atoms, and optionally bond together to form a cyclic structure; R⁵ and R⁶ represent an organic group having 1 to 10 carbon atoms, wherein R⁵ represents a group containing either an aromatic ring or a divalent group represented by the following general formula (iii-1); and W⁶ and W⁷ represent a single bond or a divalent group represented by any of the following general formulae (iii-2), wherein at least one of W⁶ and W⁷ represents the divalent group represented by (iii-2); 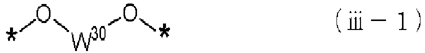
   wherein * represents a bonding position; and W³⁰ represents an organic group having 1 to 4 carbon atoms; 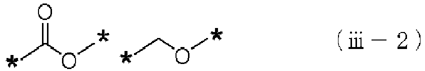
   wherein * represents a bonding position.
[17]: The composition for forming a resist underlayer film of any one of the above [1] to [16], further comprising one or more of (F) a surfactant and (G) a plasticizer.
[18]: A patterning process for forming a pattern in a substrate to be processed, comprising the steps of:
   (I-1) applying a composition for forming a resist underlayer film of any one of the above [1] to [17] on a substrate to be processed and thereafter performing heat treatment to form a resist underlayer film;
   (I-2) forming a resist upper layer film on the resist underlayer film using a photoresist material;
   (I-3) forming a pattern in the resist upper layer film by developing the resist upper layer film using a developer after pattern exposure;
   (I-4) transferring the pattern to the resist underlayer film by dry etching while using the resist upper layer film having the formed pattern as a mask; and
   (I-5) processing the substrate to be processed while using the resist underlayer film having the formed pattern as a mask to form the pattern in the substrate to be processed.
[19]: A patterning process for forming a pattern in a substrate to be processed, comprising the steps of:
   (II-1) applying a composition for forming a resist underlayer film of any one of the above [1] to [17] on a substrate to be processed and thereafter performing heat treatment to form a resist underlayer film;
   (II-2) forming a resist middle layer film on the resist underlayer film;
   (II-3) forming a resist upper layer film on the resist middle layer film using a photoresist material;
   (II-4) forming a pattern in the resist upper layer film by developing the resist upper layer film using a developer after pattern exposure;
   (II-5) transferring the pattern to the resist middle layer film by dry etching while using the resist upper layer film having the formed pattern as a mask;
   (II-6) transferring the pattern to the resist underlayer film by dry etching while using the resist middle layer film having the formed pattern as a mask; and
   (II-7) processing the substrate to be processed while using the resist underlayer film having the formed pattern as a mask to form the pattern in the substrate to be processed.
[20]: A patterning process for forming a pattern in a substrate to be processed, comprising the steps of:
   (III-1) applying a composition for forming a resist underlayer film of any one of the above [1] to [17] on a substrate to be processed and thereafter performing heat treatment to form a resist underlayer film;
   (III-2) forming an inorganic hard mask middle layer film selected from a group consisting of a silicon oxide film, a silicon nitride film, and a silicon oxynitride film on the resist underlayer film;
   (III-3) forming an organic thin film on the inorganic hard mask middle layer film;
   (III-4) forming a resist upper layer film on the organic thin film using a photoresist material;
   (III-5) forming a pattern in the resist upper layer film by developing the resist upper layer film using a developer after pattern exposure;
   (III-6) transferring the pattern to the organic thin film and the inorganic hard mask middle layer film by dry etching while using the resist upper layer film having the formed pattern as a mask;
   (III-7) transferring the pattern to the resist underlayer film by dry etching while using the inorganic hard mask middle layer film having the formed pattern as a mask; and
   (III-8) processing the substrate to be processed while using the resist underlayer film having the formed pattern as a mask to form the pattern in the substrate to be processed.
[21]: The patterning process of any one of the above [18] to [20], wherein the resist underlayer film has thickness of at least 2µm.
[22]: The patterning process of any one of the above [18] to [21], wherein the resist underlayer film is coated to have thickness of at least 2 um by applying, one time, the composition for forming a resist underlayer film of any one of the above [1] to [17].

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

The present invention also refers to the following numbered embodiments, wherein the term "claim" means "embodiment":
1. A composition for forming a resist underlayer film used for a multilayer resist method, comprising (A) a resin, (B) a base generator, and (C) an organic solvent, wherein
   a weight-average molecular weight of (A) the resin is 3,000 to 10,000,
   (A) the resin is (A-1) a resin containing a phenolic hydroxyl group and a group obtained by modifying a phenolic hydroxyl group, or (A-2) a mixture of a resin containing a phenolic hydroxyl group and a resin containing a group obtained by modifying a phenolic hydroxyl group, and
   (A) the resin satisfies relations of a+b=1, 0.1≤a≤0.5, and 0.5≤b≤0.9, wherein "a" is a proportion of a phenolic hydroxyl group and "b" is a proportion of a group obtained by modifying a phenolic hydroxyl group contained in (A) the resin.
2. The composition for forming a resist underlayer film according to claim 1, wherein (A) the resin contains any of a styrene unit, a novolac-type phenol unit, and a novolac-type naphthol unit.
3. The composition for forming a resist underlayer film according to claim 1 or 2, wherein (A) the resin is a resin having a constitutional unit represented by the following general formula (1-1) or (1-2), 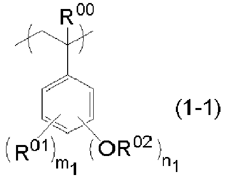 in the general formula (1-1), R⁰⁰ represents a hydrogen atom or a methyl group; R⁰¹ represents a saturated or unsaturated monovalent organic group having 1 to 30 carbon atoms; R⁰² represents a hydrogen atom, or a saturated or unsaturated optionally substituted monovalent organic group having 1 to 30 carbon atoms, satisfying relations of a'+b'=1, 0.1≤a'≤0.5, and 0.5≤b'≤0.9, wherein "a'" is a proportion of the hydrogen atom and "b'" is a proportion of the monovalent organic group to a structure constituting the R⁰²; "m₁" represents an integer of 0 to 4; "n₁" represents an integer of 1 to 5; and m₁+n₁ represents an integer of 1 or greater and 5 or smaller; 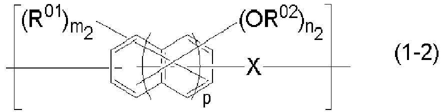 in the general formula (1-2), R⁰¹ represents a saturated or unsaturated monovalent organic group having 1 to 30 carbon atoms; R⁰² represents a hydrogen atom or a saturated or unsaturated optionally substituted monovalent organic group having 1 to 30 carbon atoms, satisfying relations of a'+b'=1, 0.1≤a'≤0.5, and 0.5≤b'≤0.9, wherein "a'" is a proportion of the hydrogen atom and "b'" is a proportion of the monovalent organic group to a structure constituting the R⁰²; X represents a divalent organic group having 1 to 30 carbon atoms; "p" represents 0 or 1, and when "p" is 0, "m₂" represents an integer of 0 to 3, "n₂" represents an integer of 1 to 4, and m₂+n₂ represents an integer of 1 or greater and 4 or smaller, whereas when "p" is 1, "m₂" represents an integer of 0 to 5, "n₂" represents an integer of 1 to 6, and m₂+n₂ represents an integer of 1 or greater and 6 or smaller.
4. The composition for forming a resist underlayer film according to claim 3, wherein in the general formulae (1-1) and (1-2), the R⁰² is any of a hydrogen atom, an alkyl group having 1 to 10 carbon atoms, and a structure represented by the following general formulae (8), 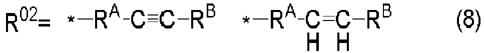 wherein * represents a bonding position to an oxygen atom; R^{A} represents an optionally substituted divalent organic group having 1 to 10 carbon atoms; and R^{B} represents a hydrogen atom or an optionally substituted monovalent organic group having 1 to 10 carbon atoms.
5. The composition for forming a resist underlayer film according to claim 3 or 4, wherein in the general formula (1-2), "p" is 0.
6. The composition for forming a resist underlayer film according to any one of claims 3 to 5, wherein in the general formula (1-1), "n₁" is 1.
7. The composition for forming a resist underlayer film according to any one of claims 3 to 6, wherein in the general formula (1-2), "n₂" is 1.
8. The composition for forming a resist underlayer film according to any one of claims 1 to 7, wherein the "a" and the "b" satisfy relations of a+b=1, 0.15≤a≤0.4, and 0.6≤b≤0.85.
9. The composition for forming a resist underlayer film according to any one of claims 1 to 8, wherein (B) the base generator is a compound which exhibits basicity due to pyrolysis.
10. The composition for forming a resist underlayer film according to any one of claims 1 to 9, wherein (B) the base generator is represented by any of the following general formulae (2), (3), and (4), 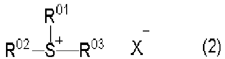 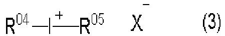 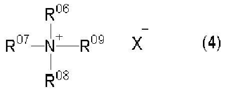 wherein each of R⁰¹ to R⁰³ independently represents a linear, branched, or cyclic alkyl group or alkenyl group having 1 to 10 carbon atoms, or an aralkyl group having 7 to 18 carbon atoms, which is optionally substituted with or separated by a heteroatom, or represents an aryl group having 6 to 18 carbon atoms, which is optionally substituted with or separated by a heteroatom; additionally, any two of R⁰¹, R⁰², and R⁰³ optionally bond together to form a ring with a sulfur atom in the formula; X- represents an organic or inorganic anion as a counterion, but X⁻ does not contain OH⁻; each of R⁰⁴ and R⁰⁵ independently represents an aryl group having 6 to 20 carbon atoms, which is optionally substituted with or separated by a heteroatom, wherein part or all of hydrogen atoms thereof are optionally substituted with a linear, branched, or cyclic alkyl group or alkoxy group having 1 to 10 carbon atoms; additionally, R⁰⁴ and R⁰⁵ optionally bond together to form a ring with an iodine atom in the formula; each of R⁰⁶, R⁰⁷, R⁰⁸, and R⁰⁹ independently represents a hydrogen atom, a linear, branched, or cyclic alkyl group or alkenyl group having 1 to 20 carbon atoms, or an aralkyl group having 7 to 18 carbon atoms, which is optionally substituted with or separated by a heteroatom, or represents an aryl group having 6 to 18 carbon atoms, which is optionally substituted with or separated by a heteroatom; and any two or more of R⁰⁶, R⁰⁷, R⁰⁸, and R⁰⁹ optionally bond together to form a ring with a nitrogen atom in the formula.
11. The composition for forming a resist underlayer film according to claim 10, wherein X⁻ in the general formulae (2), (3), and (4) is a structure represented by any of the following general formulae (5), (6), and (7), or any of anions selected from a group consisting of a chloride ion, a bromide ion, an iodide ion, a fluoride ion, a cyanide ion, a nitrate ion, and a nitrite ion,

   R¹⁰-COO⁻ (5)

   R¹¹-SO₃⁻ (6)

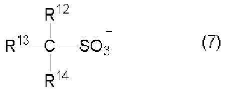

   wherein R¹⁰ represents a linear, branched, or cyclic alkyl group or alkenyl group having 1 to 20 carbon atoms, an aralkyl group having 7 to 20 carbon atoms, or an aryl group having 6 to 20 carbon atoms, and optionally containing an ether group, an ester group, and a carbonyl group, wherein one or more hydrogen atoms of these groups are optionally substituted with a halogen atom, a hydroxyl group, a carboxyl group, an amino group, or a cyano group; R¹¹ represents an aryl group having 6 to 20 carbon atoms, wherein one or more hydrogen atoms of the aryl group are optionally substituted with a halogen atom, a hydroxyl group, a carboxyl group, an amino group, or a cyano group; each of R¹², R¹³, and R¹⁴ independently represents a hydrogen atom, a halogen atom other than a fluorine atom, a linear, branched, or cyclic alkyl group or alkenyl group having 1 to 20 carbon atoms, an aralkyl group having 7 to 20 carbon atoms, or an aryl group having 6 to 20 carbon atoms, and optionally containing an ether group, an ester group, and a carbonyl group, wherein one or more hydrogen atoms of these groups are optionally substituted with a halogen atom, a hydroxyl group, a carboxyl group, an amino group, or a cyano group, and two or more of R¹², R¹³, and R¹⁴ optionally bond together to form a ring.
12. The composition for forming a resist underlayer film according to any one of claims 1 to 11, wherein (A) the resin satisfies 2.00≤Mw/Mn≤5.00, where Mw is a weight-average molecular weight and Mn is a number-average molecular weight measured by gel permeation chromatography in terms of polystyrene.
13. The composition for forming a resist underlayer film according to any one of claims 1 to 12, wherein a content of (A) the resin in the composition for forming a resist underlayer film is 20% by mass or greater.
14. The composition for forming a resist underlayer film according to any one of claims 1 to 13, comprising (D) a crosslinking agent.
15. The composition for forming a resist underlayer film according to any one of claims 1 to 14, comprising (E) a flowability accelerator, wherein a weight loss rate between 30°C to 190°C is less than 30% and the weight loss rate between 30°C to 350°C is 98% or greater.
16. The composition for forming a resist underlayer film according to claim 15, wherein (E) the flowability accelerator contains one or more compounds selected from the following general formulae (i) to (iii), 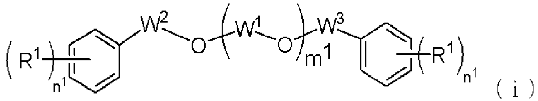
   wherein each R¹ independently represents a hydrogen atom, a hydroxyl group, or an optionally substituted organic group having 1 to 10 carbon atoms; W¹ represents a phenylene group or a divalent group represented by the following general formula (i-1); W² and W³ represent a single bond or a divalent group represented by any of the following general formulae (i-2); "m¹" represents an integer of 1 to 10; and "n¹" represents an integer of 0 to 5; 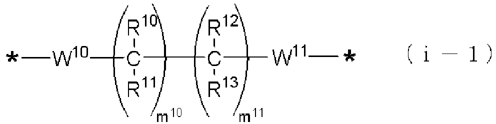
   wherein * represents a bonding position; R¹⁰, R¹¹, R¹², and R¹³ represent a hydrogen atom, a hydroxyl group, or an organic group having 1 to 10 carbon atoms; each of W¹⁰ and W¹¹ independently represents a single bond or a carbonyl group; and "m¹⁰" and "m¹¹" represent an integer of 0 to 10 satisfying a relation of m¹⁰+m¹¹≥1; 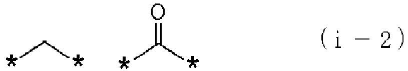
   wherein * represents a bonding position; 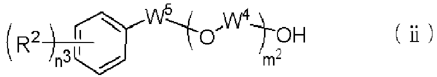
   wherein each R² independently represents a hydrogen atom or an optionally substituted organic group having 1 to 10 carbon atoms; W⁴ represents a divalent group represented by the following general formula (ii-1); W⁵ represents a single bond or a divalent group represented by any of the following general formulae (ii-2); "m₂" represents an integer of 2 to 10; and "n³" represents an integer of 0 to 5; 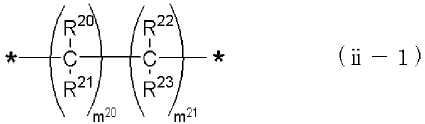
   wherein * represents a boning position; R²⁰, R²¹, R²², and R²³ represent a hydrogen atom, a hydroxyl group, or an organic group having 1 to 10 carbon atoms; and "m²⁰" and "m²¹" represent an integer of 0 to 10 satisfying a relation of m²⁰+m²¹≥1; 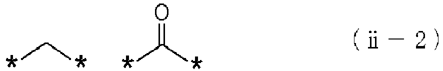
   wherein * represents a bonding position; 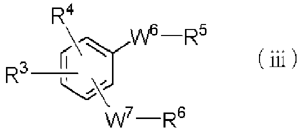
   wherein R³ and R⁴ represent a hydrogen atom, a hydroxyl group, or an optionally substituted organic group having 1 to 10 carbon atoms, and optionally bond together to form a cyclic structure; R⁵ and R⁶ represent an organic group having 1 to 10 carbon atoms, wherein R⁵ represents a group containing either an aromatic ring or a divalent group represented by the following general formula (iii-1); and W⁶ and W⁷ represent a single bond or a divalent group represented by any of the following general formulae (iii-2), wherein at least one of W⁶ and W⁷ represents the divalent group represented by (iii-2); 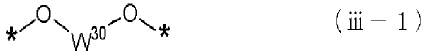
   wherein * represents a bonding position; and W³⁰ represents an organic group having 1 to 4 carbon atoms; 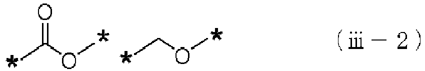
   wherein * represents a bonding position.
17. The composition for forming a resist underlayer film according to any one of claims 1 to 16, further comprising one or more of (F) a surfactant and (G) a plasticizer.
18. A patterning process for forming a pattern in a substrate to be processed, comprising the steps of:
   (I-1) applying a composition for forming a resist underlayer film according to any one of claims 1 to 17 on a substrate to be processed and thereafter performing heat treatment to form a resist underlayer film;
   (I-2) forming a resist upper layer film on the resist underlayer film using a photoresist material;
   (I-3) forming a pattern in the resist upper layer film by developing the resist upper layer film using a developer after pattern exposure;
   (I-4) transferring the pattern to the resist underlayer film by dry etching while using the resist upper layer film having the formed pattern as a mask; and
   (I-5) processing the substrate to be processed while using the resist underlayer film having the formed pattern as a mask to form the pattern in the substrate to be processed.
19. A patterning process for forming a pattern in a substrate to be processed, comprising the steps of:
   (II-1) applying a composition for forming a resist underlayer film according to any one of claims 1 to 17 on a substrate to be processed and thereafter performing heat treatment to form a resist underlayer film;
   (II-2) forming a resist middle layer film on the resist underlayer film;
   (II-3) forming a resist upper layer film on the resist middle layer film using a photoresist material;
   (II-4) forming a pattern in the resist upper layer film by developing the resist upper layer film using a developer after pattern exposure;
   (II-5) transferring the pattern to the resist middle layer film by dry etching while using the resist upper layer film having the formed pattern as a mask;
   (II-6) transferring the pattern to the resist underlayer film by dry etching while using the resist middle layer film having the formed pattern as a mask; and
   (II-7) processing the substrate to be processed while using the resist underlayer film having the formed pattern as a mask to form the pattern in the substrate to be processed.
20. A patterning process for forming a pattern in a substrate to be processed, comprising the steps of:
   (III-1) applying a composition for forming a resist underlayer film according to any one of claims 1 to 17 on a substrate to be processed and thereafter performing heat treatment to form a resist underlayer film;
   (III-2) forming an inorganic hard mask middle layer film selected from a group consisting of a silicon oxide film, a silicon nitride film, and a silicon oxynitride film on the resist underlayer film;
   (III-3) forming an organic thin film on the inorganic hard mask middle layer film;
   (III-4) forming a resist upper layer film on the organic thin film using a photoresist material;
   (III-5) forming a pattern in the resist upper layer film by developing the resist upper layer film using a developer after pattern exposure;
   (III-6) transferring the pattern to the organic thin film and the inorganic hard mask middle layer film by dry etching while using the resist upper layer film having the formed pattern as a mask;
   (III-7) transferring the pattern to the resist underlayer film by dry etching while using the inorganic hard mask middle layer film having the formed pattern as a mask; and
   (III-8) processing the substrate to be processed while using the resist underlayer film having the formed pattern as a mask to form the pattern in the substrate to be processed.
21. The patterning process according to any one of claims 18 to 20, wherein the resist underlayer film has thickness of at least 2µm.
22. The patterning process according to any one of claims 18 to 21, wherein the resist underlayer film is coated to have thickness of at least 2 um by applying, one time, the composition for forming a resist underlayer film according to any one of claims 1 to 17.

## Claims

1. A composition for forming a resist underlayer film used for a multilayer resist method, comprising (A) a resin, (B) a base generator, and (C) an organic solvent, wherein
a weight-average molecular weight of (A) the resin is 3,000 to 10,000,
(A) the resin is (A-1) a resin containing a phenolic hydroxyl group and a group obtained by modifying a phenolic hydroxyl group, or (A-2) a mixture of a resin containing a phenolic hydroxyl group and a resin containing a group obtained by modifying a phenolic hydroxyl group, and
(A) the resin satisfies relations of a+b=1, 0.1≤a≤0.5, and 0.5≤b≤0.9, wherein "a" is a proportion of a phenolic hydroxyl group and "b" is a proportion of a group obtained by modifying a phenolic hydroxyl group contained in (A) the resin.

2. The composition for forming a resist underlayer film according to claim 1, wherein (A) the resin contains any of a styrene unit, a novolac-type phenol unit, and a novolac-type naphthol unit.

3. The composition for forming a resist underlayer film according to claim 1 or 2, wherein (A) the resin is a resin having a constitutional unit represented by the following general formula (1-1) or (1-2), 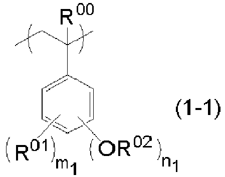
in the general formula (1-1), R⁰⁰ represents a hydrogen atom or a methyl group; R⁰¹ represents a saturated or unsaturated monovalent organic group having 1 to 30 carbon atoms; R⁰² represents a hydrogen atom, or a saturated or unsaturated optionally substituted monovalent organic group having 1 to 30 carbon atoms, satisfying relations of a'+b'=1, 0.1≤a'≤0.5, and 0.5≤b'≤0.9, wherein "a'" is a proportion of the hydrogen atom and "b'" is a proportion of the monovalent organic group to a structure constituting the R⁰²; "m₁" represents an integer of 0 to 4; "n₁" represents an integer of 1 to 5; and m₁+n₁ represents an integer of 1 or greater and 5 or smaller; 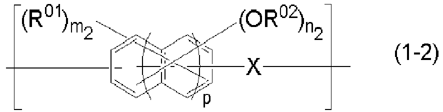
in the general formula (1-2), R⁰¹ represents a saturated or unsaturated monovalent organic group having 1 to 30 carbon atoms; R⁰² represents a hydrogen atom or a saturated or unsaturated optionally substituted monovalent organic group having 1 to 30 carbon atoms, satisfying relations of a'+b'=1, 0.1≤a'≤0.5, and 0.5≤b'≤0.9, wherein "a'" is a proportion of the hydrogen atom and "b'" is a proportion of the monovalent organic group to a structure constituting the R⁰²; X represents a divalent organic group having 1 to 30 carbon atoms; "p" represents 0 or 1, and when "p" is 0, "m₂" represents an integer of 0 to 3, "n₂" represents an integer of 1 to 4, and m₂+n₂ represents an integer of 1 or greater and 4 or smaller, whereas when "p" is 1, "m₂" represents an integer of 0 to 5, "n₂" represents an integer of 1 to 6, and m₂+n₂ represents an integer of 1 or greater and 6 or smaller;
preferably wherein in the general formulae (1-1) and (1-2), the R⁰² is any of a hydrogen atom, an alkyl group having 1 to 10 carbon atoms, and a structure represented by the following general formulae (8), 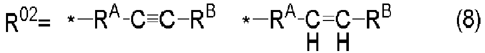
wherein * represents a bonding position to an oxygen atom; R^{A} represents an optionally substituted divalent organic group having 1 to 10 carbon atoms; and R^{B} represents a hydrogen atom or an optionally substituted monovalent organic group having 1 to 10 carbon atoms.

4. The composition for forming a resist underlayer film according to claim 3, wherein in the general formula (1-2), "p" is 0.

5. The composition for forming a resist underlayer film according to claim 3 or 4, wherein in the general formula (1-1), "n₁" is 1.

6. The composition for forming a resist underlayer film according to any one of claims 3 to 5, wherein in the general formula (1-2), "n₂" is 1.

7. The composition for forming a resist underlayer film according to any one of claims 1 to 6, wherein the "a" and the "b" satisfy relations of a+b=1, 0.15≤a≤0.4, and 0.6≤b≤0.85.

8. The composition for forming a resist underlayer film according to any one of claims 1 to 7, wherein (B) the base generator is a compound which exhibits basicity due to pyrolysis.

9. The composition for forming a resist underlayer film according to any one of claims 1 to 8, wherein (B) the base generator is represented by any of the following general formulae (2), (3), and (4), 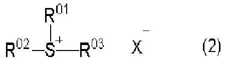 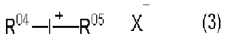 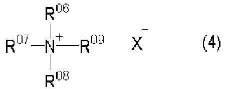 wherein each of R⁰¹ to R⁰³ independently represents a linear, branched, or cyclic alkyl group or alkenyl group having 1 to 10 carbon atoms, or an aralkyl group having 7 to 18 carbon atoms, which is optionally substituted with or separated by a heteroatom, or represents an aryl group having 6 to 18 carbon atoms, which is optionally substituted with or separated by a heteroatom; additionally, any two of R⁰¹, R⁰², and R⁰³ optionally bond together to form a ring with a sulfur atom in the formula; X⁻ represents an organic or inorganic anion as a counterion, but X⁻ does not contain OH-; each of R⁰⁴ and R⁰⁵ independently represents an aryl group having 6 to 20 carbon atoms, which is optionally substituted with or separated by a heteroatom, wherein part or all of hydrogen atoms thereof are optionally substituted with a linear, branched, or cyclic alkyl group or alkoxy group having 1 to 10 carbon atoms; additionally, R⁰⁴ and R⁰⁵ optionally bond together to form a ring with an iodine atom in the formula; each of R⁰⁶, R⁰⁷, R^{0B}, and R⁰⁹ independently represents a hydrogen atom, a linear, branched, or cyclic alkyl group or alkenyl group having 1 to 20 carbon atoms, or an aralkyl group having 7 to 18 carbon atoms, which is optionally substituted with or separated by a heteroatom, or represents an aryl group having 6 to 18 carbon atoms, which is optionally substituted with or separated by a heteroatom; and any two or more of R⁰⁶, R⁰⁷, R⁰⁸, and R⁰⁹ optionally bond together to form a ring with a nitrogen atom in the formula;
preferably wherein X⁻ in the general formulae (2), (3), and (4) is a structure represented by any of the following general formulae (5), (6), and (7), or any of anions selected from a group consisting of a chloride ion, a bromide ion, an iodide ion, a fluoride ion, a cyanide ion, a nitrate ion, and a nitrite ion,
R¹⁰-COO⁻ (5)
R¹¹-SO₃⁻ (6) 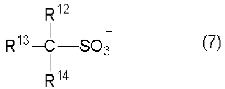
wherein R¹⁰ represents a linear, branched, or cyclic alkyl group or alkenyl group having 1 to 20 carbon atoms, an aralkyl group having 7 to 20 carbon atoms, or an aryl group having 6 to 20 carbon atoms, and optionally containing an ether group, an ester group, and a carbonyl group, wherein one or more hydrogen atoms of these groups are optionally substituted with a halogen atom, a hydroxyl group, a carboxyl group, an amino group, or a cyano group; R¹¹ represents an aryl group having 6 to 20 carbon atoms, wherein one or more hydrogen atoms of the aryl group are optionally substituted with a halogen atom, a hydroxyl group, a carboxyl group, an amino group, or a cyano group; each of R¹², R¹³, and R¹⁴ independently represents a hydrogen atom, a halogen atom other than a fluorine atom, a linear, branched, or cyclic alkyl group or alkenyl group having 1 to 20 carbon atoms, an aralkyl group having 7 to 20 carbon atoms, or an aryl group having 6 to 20 carbon atoms, and optionally containing an ether group, an ester group, and a carbonyl group, wherein one or more hydrogen atoms of these groups are optionally substituted with a halogen atom, a hydroxyl group, a carboxyl group, an amino group, or a cyano group, and two or more of R¹², R¹³, and R¹⁴ optionally bond together to form a ring.

10. The composition for forming a resist underlayer film according to any one of claims 1 to 9,
a)
wherein (A) the resin satisfies 2.00≤Mw/Mn≤5.00, where Mw is a weight-average molecular weight and Mn is a number-average molecular weight measured by gel permeation chromatography in terms of polystyrene; and/or
b)
wherein a content of (A) the resin in the composition for forming a resist underlayer film is 20% by mass or greater;
and/or
c)
comprising (D) a crosslinking agent.

11. The composition for forming a resist underlayer film according to any one of claims 1 to 10, comprising (E) a flowability accelerator, wherein a weight loss rate between 30°C to 190°C is less than 30% and the weight loss rate between 30°C to 350°C is 98% or greater;
preferably wherein (E) the flowability accelerator contains one or more compounds selected from the following general formulae (i) to (iii), 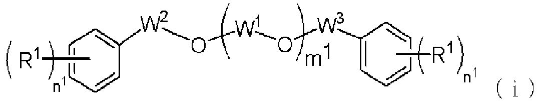
wherein each R¹ independently represents a hydrogen atom, a hydroxyl group, or an optionally substituted organic group having 1 to 10 carbon atoms; W¹ represents a phenylene group or a divalent group represented by the following general formula (i-1); W² and W³ represent a single bond or a divalent group represented by any of the following general formulae (i-2); *"*m¹*"* represents an integer of 1 to 10; and *"*n¹*"* represents an integer of 0 to 5; 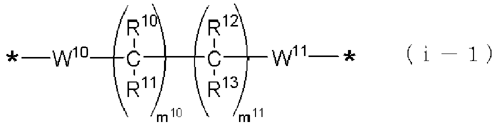
wherein * represents a bonding position; R¹⁰, R¹¹, R¹², and R¹³ represent a hydrogen atom, a hydroxyl group, or an organic group having 1 to 10 carbon atoms; each of W¹⁰ and W¹¹ independently represents a single bond or a carbonyl group; and *"*m¹⁰*"* and *"*m¹¹*"* represent an integer of 0 to 10 satisfying a relation of m¹⁰+m¹¹≥1; 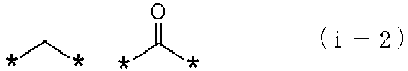
wherein * represents a bonding position; 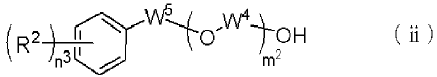
wherein each R² independently represents a hydrogen atom or an optionally substituted organic group having 1 to 10 carbon atoms; W⁴ represents a divalent group represented by the following general formula (ii-1); W⁵ represents a single bond or a divalent group represented by any of the following general formulae (ii-2); *"*m²*"* represents an integer of 2 to 10; and *"*n³*"* represents an integer of 0 to 5; 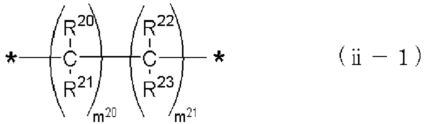
wherein * represents a boning position; R²⁰, R²¹, R²², and R²³ represent a hydrogen atom, a hydroxyl group, or an organic group having 1 to 10 carbon atoms; and *"*m²⁰*"* and *"*m²¹*"* represent an integer of 0 to 10 satisfying a relation of m²⁰+m²¹≥1; 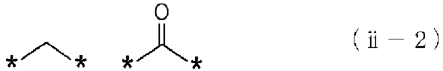
wherein * represents a bonding position; 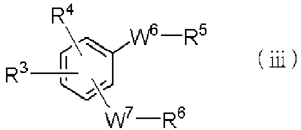
wherein R³ and R⁴ represent a hydrogen atom, a hydroxyl group, or an optionally substituted organic group having 1 to 10 carbon atoms, and optionally bond together to form a cyclic structure; R⁵ and R⁶ represent an organic group having 1 to 10 carbon atoms, wherein R⁵ represents a group containing either an aromatic ring or a divalent group represented by the following general formula (iii-1); and W⁶ and W⁷ represent a single bond or a divalent group represented by any of the following general formulae (iii-2), wherein at least one of W⁶ and W⁷ represents the divalent group represented by (iii-2); 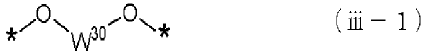
wherein * represents a bonding position; and W³⁰ represents an organic group having 1 to 4 carbon atoms; 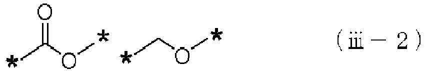
wherein * represents a bonding position.

12. The composition for forming a resist underlayer film according to any one of claims 1 to 11, further comprising one or more of (F) a surfactant and (G) a plasticizer.

13. A patterning process for forming a pattern in a substrate to be processed, comprising the steps of:
A)
(I-1) applying a composition for forming a resist underlayer film according to any one of claims 1 to 12 on a substrate to be processed and thereafter performing heat treatment to form a resist underlayer film;
(I-2) forming a resist upper layer film on the resist underlayer film using a photoresist material;
(I-3) forming a pattern in the resist upper layer film by developing the resist upper layer film using a developer after pattern exposure;
(I-4) transferring the pattern to the resist underlayer film by dry etching while using the resist upper layer film having the formed pattern as a mask; and
(I-5) processing the substrate to be processed while using the resist underlayer film having the formed pattern as a mask to form the pattern in the substrate to be processed;
or
B)
(II-1) applying a composition for forming a resist underlayer film according to any one of claims 1 to 12 on a substrate to be processed and thereafter performing heat treatment to form a resist underlayer film;
(II-2) forming a resist middle layer film on the resist underlayer film;
(II-3) forming a resist upper layer film on the resist middle layer film using a photoresist material;
(II-4) forming a pattern in the resist upper layer film by developing the resist upper layer film using a developer after pattern exposure;
(II-5) transferring the pattern to the resist middle layer film by dry etching while using the resist upper layer film having the formed pattern as a mask;
(II-6) transferring the pattern to the resist underlayer film by dry etching while using the resist middle layer film having the formed pattern as a mask; and
(II-7) processing the substrate to be processed while using the resist underlayer film having the formed pattern as a mask to form the pattern in the substrate to be processed;
or
C)
(III-1) applying a composition for forming a resist underlayer film according to any one of claims 1 to 12 on a substrate to be processed and thereafter performing heat treatment to form a resist underlayer film;
(III-2) forming an inorganic hard mask middle layer film selected from a group consisting of a silicon oxide film, a silicon nitride film, and a silicon oxynitride film on the resist underlayer film;
(III-3) forming an organic thin film on the inorganic hard mask middle layer film;
(III-4) forming a resist upper layer film on the organic thin film using a photoresist material;
(III-5) forming a pattern in the resist upper layer film by developing the resist upper layer film using a developer after pattern exposure;
(III-6) transferring the pattern to the organic thin film and the inorganic hard mask middle layer film by dry etching while using the resist upper layer film having the formed pattern as a mask;
(III-7) transferring the pattern to the resist underlayer film by dry etching while using the inorganic hard mask middle layer film having the formed pattern as a mask; and
(III-8) processing the substrate to be processed while using the resist underlayer film having the formed pattern as a mask to form the pattern in the substrate to be processed.

14. The patterning process according to claim 13, wherein the resist underlayer film has thickness of at least 2 µm.

15. The patterning process according to claim 13 or 14, wherein the resist underlayer film is coated to have thickness of at least 2 µm by applying, one time, the composition for forming a resist underlayer film according to any one of claims 1 to 12.
